# EUROPEAN PATENT APPLICATION

(11) **EP 4 481 531 A1**
(43) Date of publication of application: **25.12.2024**
(21) Application number: 24725392.5
(22) Date of filing: 09.05.2024
(51) Int. Cl.: G06F 1/00

(54) **FOLDABLE ELECTRONIC DEVICE COMPRISING NFC ANTENNA**

(30) Priority: 09.05.2023 KR 20230060071; 25.08.2023 KR 20230112235; 03.05.2024 KR 20240059366
(71) Applicant: Samsung Electronics Co., Ltd., Suwon-si, Gyeonggi-do 16677 (KR)
(72) Inventor: YUN, Himchan, Suwon-si, Gyeonggi-do 16677 (KR); KIM, Seunghwan, Suwon-si, Gyeonggi-do 16677 (KR); LEE, Hyungjoo, Suwon-si, Gyeonggi-do 16677 (KR); LEE, Heejun, Suwon-si, Gyeonggi-do 16677 (KR); CHUN, Jaebong, Suwon-si, Gyeonggi-do 16677 (KR); CHOI, Donguk, Suwon-si, Gyeonggi-do 16677 (KR); CHOI, Sanghoon, Suwon-si, Gyeonggi-do 16677 (KR); HWANG, Soonho, Suwon-si, Gyeonggi-do 16677 (KR)
(74) Representative: Gulde & Partner
(86) International application number: PCT/KR2024/006256
(87) International publication number: WO 2024/232684

(57) **Abstract**

According to an exemplary embodiment of the disclosure, provided is a foldable electronic device. The foldable electronic device includes a foldable housing including a first housing, a second housing, and a hinge portion interconnecting the first housing and the second housing, a first metal included in a first side that provides at least a portion of a side surface of the first housing, a second metal included in a second side that provides at least a portion of a side surface of the second housing, wherein the first metal and the second metal are aligned with and overlap each other in a folded state of the foldable electronic device, a first ground area located in the first housing and physically spaced apart from the first metal, a second ground area located in the second housing and physically spaced apart from the second metal, a wireless communication circuit accommodated in the first housing, a first electrical path electrically interconnecting the first metal and the wireless communication circuit, a second electrical path electrically interconnecting the second metal and the wireless communication circuit and disposed across the hinge portion, a third electrical path electrically interconnecting the first metal and the first ground area, a fourth electrical path electrically interconnecting the second metal and the second ground area, and a fifth electrical path electrically interconnecting the first ground area and the second ground area and disposed across the hinge portion.

## Description

### [Technical Field]

The disclosure relates to a foldable electronic device including a near field communication (NFC) antenna.

### [Background Art]

Electronic devices may not only make payments through NFC antennas, but may also be combined with various applications to provide users with a variety of experiences.

The above information may be provided as a related art for the purpose of aiding understanding of the disclosure. No claim or determination is made as to whether any of the foregoing may be applied as a prior art related to the disclosure.

### [Disclosure of Invention]

### [Technical Problem]

An NFC antenna may be located, for example, corresponding to the center of the rear surface of the electronic device. When a user wants to use a payment service, the user may experience in the inconvenience of having to pay while taking his or her hands off from the electronic device or having to use the electronic device while holding the edges of the electronic device at the time of making a payment. In the case of a foldable electronic device, it may be difficult to make a payment smoothly due to the location of the NFC antenna as well as the folding characteristic of the foldable electronic device itself.

Embodiments of the disclosure provide a foldable electronic device including an NFC antenna to improve usability. Various embodiments of the disclosure are provided to solve or at least alleviate the above-mentioned problems.

The technical problems to be addressed by the disclosure are not limited to those described above, and other technical problems, which are not described above, will be understood by a person ordinarily skilled in the related art, to which this disclosure belongs.

### [Solution to Problem]

The present invention is defined by the appended set of claims. Further disclosure lying outside the scope of the claims is introduced for illustrative and comparative purpose.

According to an exemplary embodiment of the disclosure, a foldable electronic device is provided. The foldable electronic device includes a foldable housing, a first metal, a second metal, a first ground area, a second ground area, a wireless communication circuit, a first electrical path, a second electrical path, a third electrical path, a fourth electrical path, and a fifth electrical path. The foldable housing includes a first housing, a second housing, and a hinge portion interconnecting the first housing and the second housing. The first metal is included in a first side that provides at least a portion of the side surface of the first housing. The second metal is included in a second side that provides at least a portion of the side surface of the second housing. When the foldable electronic device is in the folded state, the first metal and the second metal are aligned with and overlap each other. The first ground area is located in the first housing. The first ground area is physically spaced apart from the first metal. The second ground area is located in the second housing. The second ground area is physically spaced apart from the second metal. The wireless communication circuit is accommodated in the first housing. The first electrical path electrically interconnects the first metal and the wireless communication circuit. The second electrical path electrically interconnects the second metal and the wireless communication circuit. The second electrical path is disposed across the hinge portion. The third electrical path electrically interconnects the first metal and the first ground area. The fourth electrical path electrically interconnects the second metal and the second ground area. The fifth electrical path electrically interconnects the first ground area and the second ground area. The fifth electrical path is disposed across the hinge portion.

According to an exemplary embodiment of the disclosure, a foldable electronic device is provided. The foldable electronic device includes a foldable housing, a first metal, a second metal, a first ground area, a second ground area, a first non-ground area, a second non-ground area, a wireless communication circuit, a first electrical path, a second electrical path, a third electrical path, a fourth electrical path, and a fifth electrical path. The foldable housing includes a first housing, a second housing, and a hinge portion interconnecting the first housing and the second housing. The first metal is included in a first side that provides at least a portion of the side surface of the first housing. The second metal is included in a second side that provides at least a portion of the side surface of the second housing. When the foldable electronic device is in the folded state, the first metal and the second metal are aligned with and overlap each other. The first ground area is located in the first housing. The first ground area is physically spaced apart from the first metal. The second ground area is located in the second housing. The first non-ground area is located between the first metal and the first ground area. The second non-ground area is located between the second metal and the second ground area. When the foldable electronic device in the folded state, the first non-ground area and the second non-ground overlap each other. The second ground area is physically spaced apart from the second metal. The wireless communication circuit may be accommodated in the first housing and is configured to process an NFC signal. The first electrical path electrically interconnects the first metal and the wireless communication circuit. The second electrical path electrically interconnects the second metal and the wireless communication circuit. The second electrical path is disposed across the hinge portion. The third electrical path electrically interconnects the first metal and the first ground area. The fourth electrical path electrically interconnects the second metal and the second ground area. The fifth electrical path electrically interconnects the first ground area and the second ground area. The fifth electrical path is disposed across the hinge portion. The wireless communication circuit is configured to provide a positive voltage (i.e. +voltage) through the first electrical path and a negative voltage (i.e. -voltage) through the second electrical path.

According to an exemplary embodiment of the disclosure, a foldable electronic device is provided. The foldable electronic device includes a first metal, a second metal, a hinge portion, and a wireless communication circuit. The first metal is included in a first side surface member of a first housing. The second metal is included in a second side surface member of a second housing. The hinge portion rotatably interconnects the first housing and the second housing. The wireless communication circuit is configured to transmit and/or receive a signal in the NFC band via the first metal and the second metal. When the foldable electronic device is in a folded state, the first metal and the second metal are aligned with each other. When the foldable electronic device is in the folded state, at the time of feeding from the wireless communication circuit, the direction in which the current flows on the first metal and the direction in which the current flows on the second metal are the same.

### [Advantageous Effects of Invention]

A foldable electronic device including an NFC antenna according to exemplary embodiments of the disclosure secures and/or expands a magnetic field distribution in the NFC band by reducing the limitation of the grip position of a user's hand, thereby improving usability for an NFC service and/or improve user experience.

In addition, effects that may be obtained or predicted by various embodiments of the disclosure will be directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 is a block diagram of an electronic device according to an embodiment of the disclosure in a network environment.
FIG. 2 is a view illustrating appearances of the foldable electronic device according to an embodiment of the disclosure in an unfolded state.
FIG. 3 is a view illustrating appearances of the foldable electronic device according to an embodiment of the disclosure in a folded state.
FIG. 4 is a cross-sectional view of the foldable electronic device according to an embodiment of the disclosure taken along line D-D' in FIG. 2.
FIG. 5 is a view illustrating a foldable electronic device according to an embodiment of the disclosure in an unfolded state.
FIG. 6 is a view illustrating a foldable electronic device according to an embodiment of the disclosure in an unfolded state.
FIG. 7 is a circuit diagram of a first exemplary antenna structure included in a foldable electronic device according to an embodiment of the disclosure.
FIG. 8 is a diagram illustrating a current distribution when a foldable electronic device is in the folded state.
FIG. 9 is a view illustrating a foldable electronic device according to an embodiment of the disclosure in the unfolded state.
FIG. 10 is a view illustrating a foldable electronic device according to an embodiment of the disclosure in the unfolded state.
FIG. 11 is a view illustrating a foldable electronic device according to an embodiment of the disclosure in the unfolded state.
FIG. 12 is a view illustrating a foldable electronic device according to an embodiment of the disclosure in the unfolded state.
FIG. 13 is a view illustrating a foldable electronic device according to an embodiment of the disclosure in the unfolded state.
FIG. 14 is a view illustrating a heat map illustrating a magnetic field distribution at the time of feeding when a foldable electronic device according to an embodiment of the disclosure is in the folded state of, a heat map illustrating a magnetic field distribution at the time of feeding when a foldable electronic device of a first comparative example is in the folded state, and a heat map illustrating a magnetic field distribution at the time of feeding when a foldable electronic device of a second comparative example is in the folded state.
FIG. 15 is a circuit diagram of an antenna structure included in a foldable electronic device according to an embodiment of the disclosure.
FIG. 16 is a view illustrating heat maps illustrating a magnetic field distribution at the time of feeding when a foldable electronic device according to an embodiment of the disclosure is in the folded state, heat maps illustrating a magnetic field distribution at the time of feeding when a foldable electronic device of a third comparative example is in the folded state, and heat maps illustrating a magnetic field distribution at the time of feeding when a foldable electronic device of a fourth comparative example is in the folded state.
FIG. 17 is a circuit diagram of an antenna structure according to an embodiment of the disclosure and a circuit diagram of an antenna structure of the third comparative example.
FIG. 18 is a view illustrating a foldable electronic device according to an embodiment of the disclosure in the unfolded state.
FIG. 19 is a view illustrating a foldable electronic device according to an embodiment of the disclosure in the unfolded state.
FIG. 20 is a view illustrating a foldable electronic device according to an embodiment of the disclosure in the unfolded state.
FIG. 21 is a view illustrating a foldable electronic device according to an embodiment of the disclosure in the unfolded state.
FIG. 22 is a view illustrating a foldable electronic device according to an embodiment of the disclosure in the unfolded state.
FIG. 23 is a view illustrating a foldable electronic device according to an embodiment of the disclosure in the unfolded state.
FIG. 24 is a view illustrates a heat map showing a magnetic field distribution at the time of feeding when the foldable electronic device of FIG. 23 according to an embodiment of the disclosure is in the folded state, and heat maps showing magnetic field distributions at the time of feeding when foldable electronic devices of the comparative examples are in the folded states.
FIG. 25 is a view illustrating a flexible printed circuit board according to various embodiments of the disclosure.
FIG. 26 is a view illustrating a foldable electronic device according to an embodiment of the disclosure in the unfolded state.
FIG. 27 is a view illustrating a foldable electronic device according to an embodiment of the disclosure in the unfolded state.
FIG. 28 is a view illustrating a foldable electronic device according to an embodiment of the disclosure in the unfolded state.
FIG. 29 is a view illustrating a foldable electronic device according to an embodiment of the disclosure in the unfolded state.
FIG. 30 is a view illustrating a foldable electronic device according to an embodiment of the disclosure in the unfolded state.
FIG. 31 is a view illustrating a foldable electronic device according to an embodiment of the disclosure in the unfolded state.
FIG. 32 is a view illustrating a multi-foldable electronic device according to an embodiment of the disclosure in the unfolded state.
FIG. 33 is a perspective view of a multi-foldable electronic device according to an embodiment of the disclosure in the folded state.
FIG. 34 is a view illustrating a multi-foldable electronic device according to an embodiment of the disclosure in the unfolded state.
FIG. 35 is a view illustrating a multi-foldable electronic device according to an embodiment of the disclosure in the unfolded state.
FIG. 36 is a view illustrating a multi-foldable electronic device according to an embodiment of the disclosure in the unfolded state.
FIG. 37 is a view illustrating a multi-foldable electronic device according to an embodiment of the disclosure in the unfolded state.
FIG. 38 is a view illustrating a multi-foldable electronic device according to an embodiment of the disclosure in the unfolded state.
FIG. 39 is a view illustrating a multi-foldable electronic device according to an embodiment of the disclosure in the unfolded state.
FIG. 40 is a view illustrating a multi-foldable electronic device according to an embodiment of the disclosure in the unfolded state.
FIG. 41 is a view illustrating a multi-foldable electronic device according to an embodiment of the disclosure in the unfolded state.
FIG. 42 is a perspective view of a multi-foldable electronic device according to an embodiment of the disclosure in the folded state.
FIG. 43 is a view illustrating a multi-foldable electronic device according to an embodiment of the disclosure in the unfolded state.
FIG. 44 is a view illustrating a multi-foldable electronic device according to an embodiment of the disclosure in the unfolded state.
FIG. 45 is a view illustrating a multi-foldable electronic device according to an embodiment of the disclosure in the unfolded state.
FIG. 46 is a view illustrating a multi-foldable electronic device according to an embodiment of the disclosure in the unfolded state.
FIG. 47 is a view illustrating a multi-foldable electronic device according to an embodiment of the disclosure in the unfolded state.
FIG. 48 is a view illustrating a multi-foldable electronic device according to an embodiment of the disclosure in the unfolded state.
FIG. 49 is a view illustrating a multi-foldable electronic device according to an embodiment of the disclosure in the unfolded state.

### [Mode for the Invention]

Hereinafter, various example embodiments of the disclosure disclosed herein will be described in greater detail with reference to the accompanying drawings.

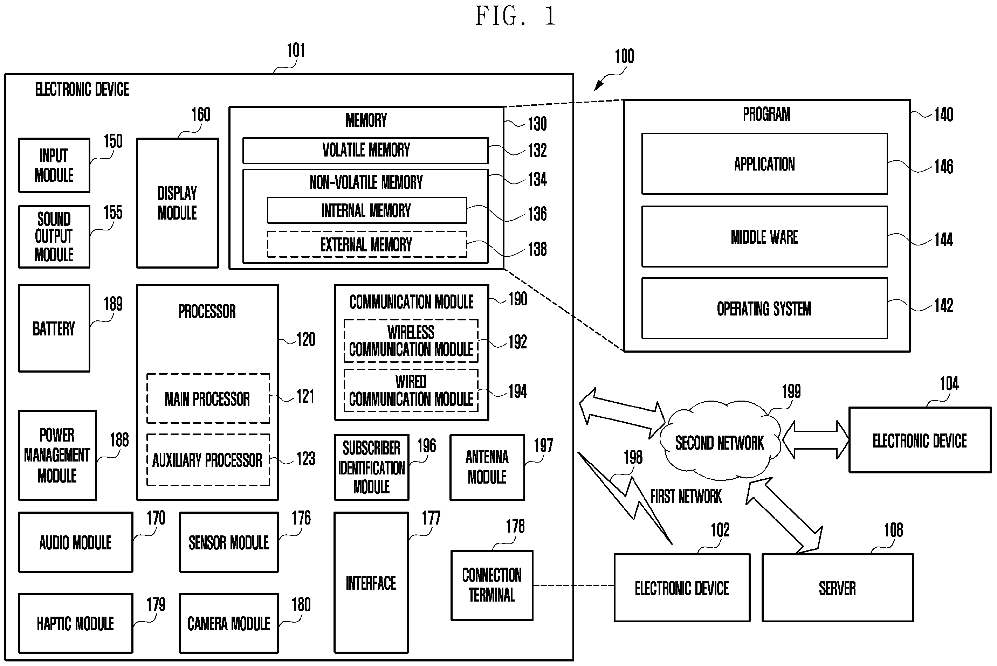

FIG. 1 is a block diagram of an electronic device 101 in a network environment 100 according to an embodiment of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In various embodiments of the disclosure, at least one (e.g., the connection terminal 178) of the components may be omitted from the electronic device 101, or one or more other components may be added in the electronic device 101. In various embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5th generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4th generation (4G) network, and next-generation communication technology, e.g., new radio (NR) access technology. The NR access technology may support highspeed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORETM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

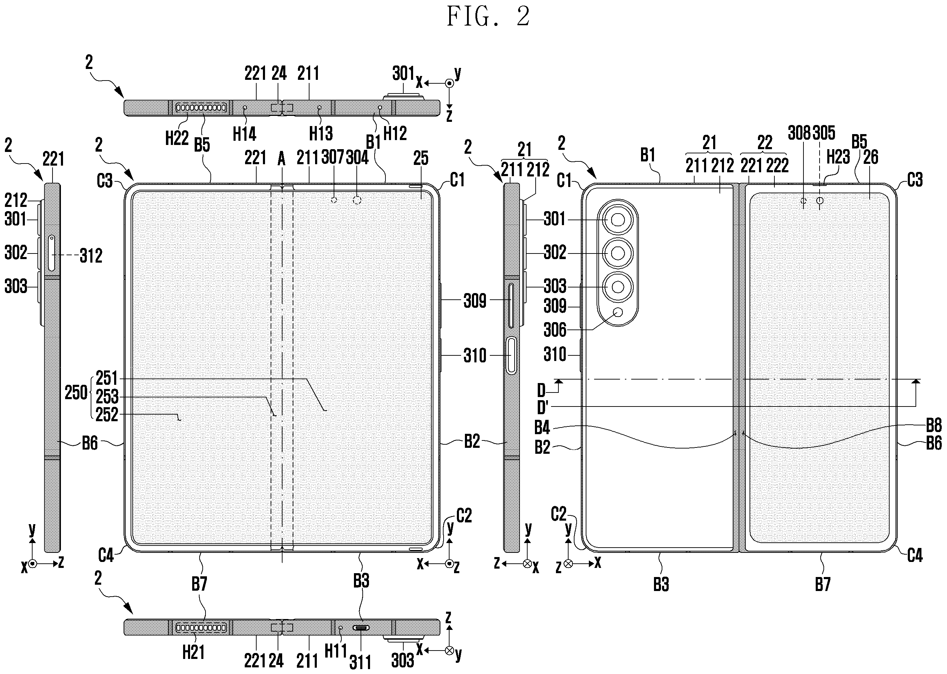

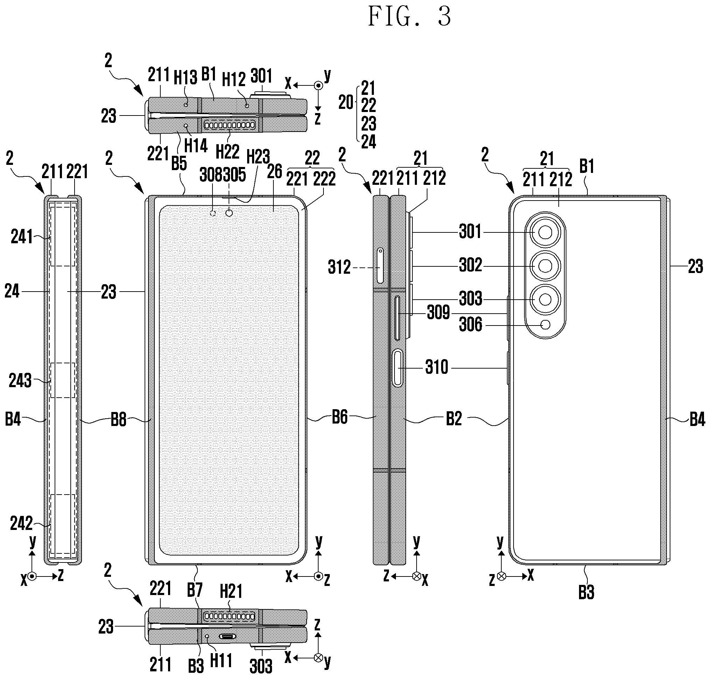

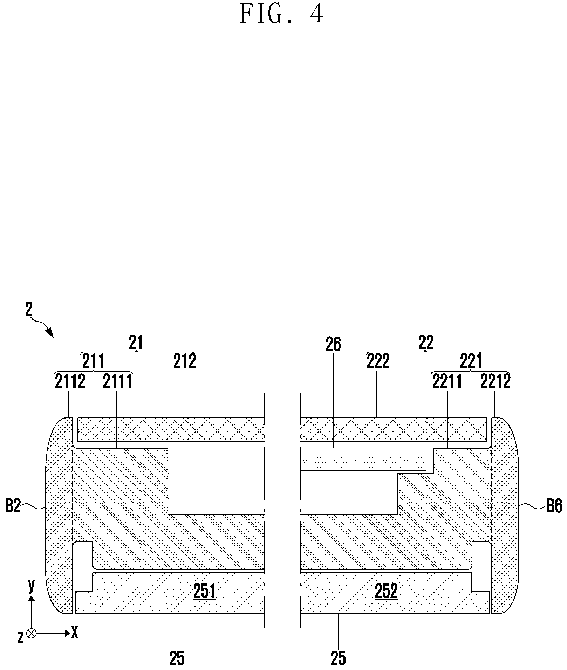

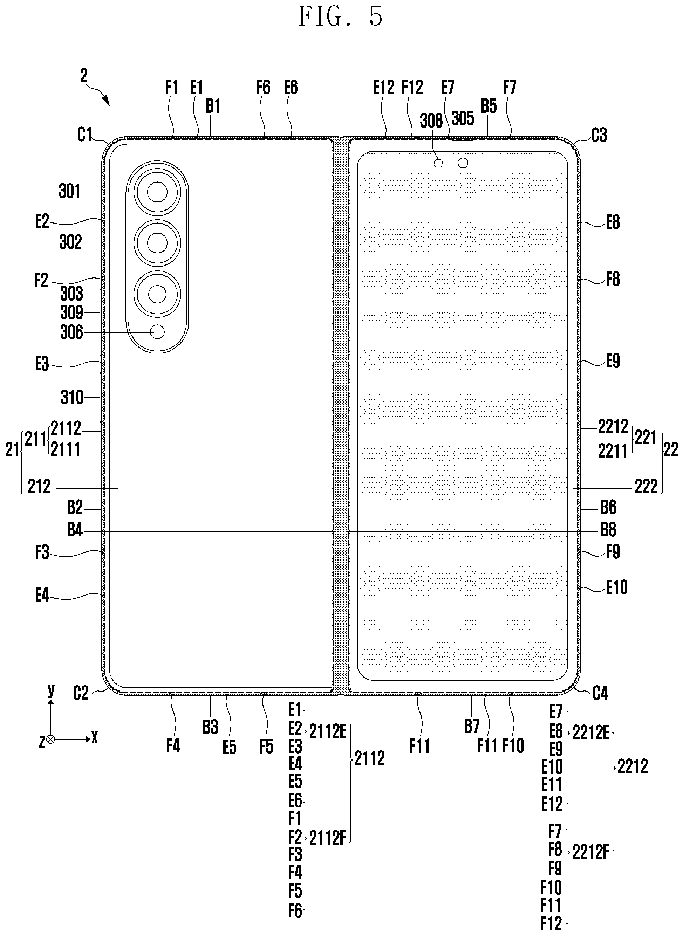

FIG. 2 is a diagram illustrating appearances of the foldable electronic device 2 in an unfolded state (or a flat state) according to an embodiment of the disclosure. FIG. 3 is a view illustrating appearances of the foldable electronic device 2 according to an embodiment of the disclosure in a folded state (or a folding state). FIG. 4 is a cross-sectional view of the foldable electronic device 2 according to an embodiment of the disclosure taken along line D-D' in FIG. 2. FIG. 5 is a view illustrating the foldable electronic device 2 according to an embodiment of the disclosure in an unfolded state.

Referring to FIGS. 2, 3, 4, and 5, the foldable electronic device 2 may include a foldable housing 20, a first display module (e.g., a flexible display module or a foldable display module) 25, a second display module 26, a first camera module 301, a second camera module 302, a third camera module 303, a fourth camera module 304, a fifth camera module 305, a light-emitting module 306, a sensor module 307, a first audio input module (not separately illustrated), a second audio input module (not separately illustrated), a third audio input module (not separately illustrated), a fourth audio input module (not separately illustrated), a first audio output module (not separately illustrated), a second audio output module (not separately illustrated), a third audio output module (not separately illustrated), a key input module, a first connection terminal 311, and/or a second connection terminal 312.

According to an embodiment, the foldable housing 20 may include a first housing (or, a first housing portion or a first housing structure) 21, a second housing (or, a second housing portion or a second housing structure) 22, a hinge housing 23, and/or a hinge portion 24. The first housing 21 and the second housing 22 may be connected through the hinge portion 24 and may be mutually rotatable with respect to the hinge portion 24. The hinge portion 24 may include one or more hinge modules (or hinge assemblies) (e.g., the first hinge module 241, the second hinge module 242, and/or the third hinge module 243 in FIG. 3).

According to an embodiment, the first display module 25 may include a display area 250. The display area 250 may include a first display area 251, a second display area 252, and a third display area 253 interconnecting the first display area 251 and the second display area 252 (or between the first display area 251 and the second display area 252). A first screen area (or a first active area) capable of displaying an image may be provided through the first display area 251. A second screen area (or a second active area) capable of displaying an image may be provided through the second display area 252. A third screen area (or a third active area) capable of displaying an image may be provided through the third display area 253.

According to an embodiment, the first display area 251 may be located corresponding to the first housing 21. The second display area 252 may be located corresponding to the second housing 22, The third display area 253 may be located corresponding to the hinge portion 24. The first display area 251 may be disposed in the first housing 21, and the shape of the first display area 251 may be maintained by being support by the first housing 21. The second display area 252 may be disposed in the second housing 22, and the shape of the first display area 252 may be maintained by being support by the second housing 22. The first display area 251 and the second display area 252 may be provided, for example, to be substantially flat. The unfolded state of the foldable electronic device 2 may be the state in which the third display area 253 is arranged to be substantially flat. When the foldable electronic device 2 is in the unfolded state, the first display area 251 and the second display area 252 may form an angle of about 180 degrees therebetween, and the display area 250 may be provided (or arranged) in a substantially flat form. Due to the relative position between the first display area 251 disposed in the first housing 21 and the second display area 252 disposed in the second housing 22 when the foldable electronic device 2 is in the unfolded state, the third display area 253 may be arranged to be flat. When the foldable electronic device 2 is in the unfolded state, the third display area 253 may be pulled from opposite sides by the first display area 251 and the second display area 252, and the pulling force may be provided to reduce damage to the third display area 253 while causing the third display area 253 to be arranged to be flat. In the unfolded state of the foldable device 2, the third display area 253 may be provided with an extended width that may be pulled by the first display area 251 and the second display area 252 and arranged to be flat while reducing stress.

According to an embodiment, in the unfolded state of the foldable electronic device 2, the hinge portion 24 may support the third display area 253 of the first display module 25 to be substantially flat. When an external force (e.g., an external pressure such as a touch input made by using a user's finger or a touch input made by using an electronic pen) is applied to the third display area 253 when the foldable electronic device 2 is in the unfolded state, the hinge portion 24 may contribute to maintaining the third display area 253 to be flat by reducing sagging of the third display area 253. The hinge portion 24 may be configured to reduce the effect of an external impact on the third display area 253 when the external impact is applied due to a reason such as a drop when the foldable electronic device 2 is in the unfolded state. For example, the hinge portion 24 may support the third display area 253 such that, when the foldable electronic device 2 is in the unfolded state, the third display area 253 can be arranged to be flat without sagging or with reduced sagging, thereby reducing a crease phenomenon.

According to an embodiment, the display area 250 of the first display module 25 may substantially provide the "front surface" in the exterior of the foldable electronic device 2. The front surface of the foldable electronic device 2 may include a first front surface area provided by the first display area 251, a second front surface area provided by the second display area 252, and a third surface area provided by the third display area 253. The illustrated coordinate axes are indicated based on the first housing 21, and the +z-axis direction may be defined or interpreted as a direction where the substantially flat first front surface area is oriented. When the foldable electronic device 2 is in the unfolded state, the front surface of the foldable electronic device 2 may be provided to be substantially flat.

According to an embodiment, the foldable electronic device 2 may be implemented in an infolding type in which the display area 250 of the first display module 25 (or the front surface of the foldable electronic device 2 where the display area 250 is visually visible) can be folded inward. FIG. 3 illustrates the fully folded state of the foldable electronic device 2 in which the first housing 21 and the second housing 22 are arranged such that the first and second housings cannot be folded any further. When the foldable electronic device 2 is in the fully folded state, the first display area 251 and the second display area 252 (or the first front surface area and the second front surface area) may face each other. When the foldable electronic device 2 is in the fully folded state, the third display area 253 may be arranged in a bent shape. When the foldable electronic device 2 is in the fully folded state, the angle between the first housing 21 and the second housing 22 (or, the angle between the first display area 251 and the second display area 252 or the angle between the first front surface area and the second front surface area) may range from about 0 degrees to about 10 degrees, and the display area 250 may be substantially invisible. Although not separately illustrated, the intermediate state of the foldable electronic device 2 may be a state between the unfolded state and the fully folded state. In the intermediate state in which the angle between the first housing 21 and the second housing 22 is equal to or greater than a certain angle, a use environment in which a user does not have substantial difficulty in using the display area 250 may be provided. Hereinafter, the "folded state of the foldable electronic device 2" described in the disclosure may refer to the fully folded state in contrast to the intermediate state which is the less folded state.

According to an embodiment, when the foldable electronic device 2 is viewed in the unfolded state, the display area 250 of the first display module 25 may be provided in a symmetrical shape with respect to the center line A of the foldable electronic device 2. The center line A of the foldable electronic device 2 may correspond to the center of the width of the third display area 253 extending from a first boundary between the first display area 251 and the third display area 253 to a second boundary between the second display area 251 and the third display area 253 when the foldable electronic device 2 is viewed in the unfolded state. The illustrated +x coordinate axis may be substantially perpendicular to the center line A, and the illustrated +y coordinate axis may be substantially parallel to the center line A. In the front surface of the foldable electronic device 2 provided by the first display area 251, the first front surface area provided by the first display area 251 may be substantially parallel to the x-y plane.

According to an embodiment, the third display area 253 arranged in a bent shape when of the foldable electronic device 2 is in the folded state may be provided in a substantially symmetrical shape with reference to the center line A of the foldable electronic device 2.

According to an embodiment, when the foldable electronic device 2 is viewed in the unfolded state, the display area 250 of the first display module 25 may have a substantially rectangular shape.

According to an embodiment, the first housing 21 may include a first frame (or, a first frame structure or a first framework) 211, and a first cover 212 disposed on (or coupled) to the first frame 211. The combination of the first frame 211 and the first cover 212 may provide a "first rear surface area" and a "first side surface area" in the exterior of the foldable electronic device 2. The first frame 211 may provide at least a portion of the first side surface area of the foldable electronic device 2. The first cover 212 may provide at least a portion of the first rear surface area of the foldable electronic device 2. The first rear surface area may be oriented in a direction opposite to the first front surface area of the foldable electronic device 2 provided by the first display area 251 of the first display module 25.

According to an embodiment, the first frame 211 may include a first side (or, a first side surface portion, a first side surface member, a first side surface structure, or a first side surface bezel structure) 2112. The first side 2112 may surround at least a portion of the space between the first display area 251 and the first cover 212, and may provide at least a portion of the first side surface area in the exterior of the foldable electronic device 2.

According to an embodiment, the first frame 211 may include a first support (or a first support plate) 2111 extending from or connected to the first side 2112. The first support 2111 is a structural element located inside the foldable electronic device 2 to correspond to the first housing 21 and may be referred to as various other terms, such as a "first bracket", a "first supporter", a "first support member", or a "first support structure".

According to an embodiment, the first frame 211 may be provided as an integrated or single structure (e.g., a single continuous structure or complete structure) including the first support 2111 and the first side 2112.

According to an embodiment, the first support 2111 may be at least partially located between the first display area 251 and the first cover 212. The first display area 251 may be disposed on the first support 2111, and the first support 2111 may support the first display area 251.

According to an embodiment, various electrical components (not separately illustrated), such as a printed circuit board or a battery, may be at least partially disposed on the first support 2111 of the first frame 211 between the first frame 211 and the first cover 212.

According to an embodiment, the second housing 22 may include a second frame (or, a second frame structure or a second framework) 221, and/or a second cover 222 disposed on the second frame 221. The combination of the second frame 221 and the second cover 222 may provide a "second rear surface area" and a "second side surface area" in the exterior of the foldable electronic device 2. The second frame 221 may provide at least a portion of the second side surface area of the foldable electronic device 2. The second cover 222 may provide at least a portion of the second rear surface area of the foldable electronic device 2. The second rear surface area may be oriented in a direction opposite to the second front surface area of the foldable electronic device 2 provided by the second display area 252.

According to an embodiment, the second frame 221 may include a second side (or, a second side surface portion, a second side surface member, a second side surface structure, or a second side surface bezel structure) 2212. The second side 2212 may surround at least a portion of the space between the second display area 252 and the second cover 222, and may provide at least a portion of the second side surface area in the exterior of the foldable electronic device 2.

According to an embodiment, the second frame 221 may include a second support (or a second support plate) 2211 extending from or connected to the second side 2212. The second support 2211 is a structure element located inside the foldable electronic device 2 to correspond to the second housing 22 and may be referred to as various other terms, such as a "second bracket", a "second supporter", a "second support member", or a "second support structure".

According to an embodiment, the second frame 221 may be provided as an integrated or single structure (e.g., a single continuous structure or complete structure) including the second support 2211 and the second side 2212.

According to an embodiment, the second support 2211 may be at least partially located between the second display area 252 and the second cover 222. The second display area 252 may be disposed on the second support 2211, and the second support 2211 may support the second display area 252.

According to an embodiment, various electrical components (not separately illustrated), such as a printed circuit board or a battery, may be at least partially disposed on the second support 2211 of the second frame 221 between the second frame 221 and the second cover 222.

According to an embodiment, the first side 2112 of the first frame 211 may include a first edge B1, a second edge B2, a third edge B3, and/or a fourth edge B4. The first edge B1 may extend in a direction perpendicular to the center line A of the foldable electronic device 2. The third edge B3 may be spaced apart from the first edge B1 in the direction of the center line A of the foldable electronic device 2, and may be substantially parallel to the first edge B1. The second edge B2 may interconnect one end of the first edge B1 and one end of the third edge B3. The fourth edge B4 may interconnect the other end of the edge B1 and the other end of the third edge B3. The second edge B2 and the fourth edge B4 may be substantially parallel to each other. The fourth edge B4 may be located closer to the center line A of the foldable electronic device 2 than the second edge B2.

According to an embodiment, a first corner C1 where the first edge B1 and the second edge B2 are connected, and/or a second corner C2 where the second edge B2 and the third edge B3 are connected may be provided (or formed) in a smoothly curved shape.

According to an embodiment, when viewed from above the first cover 212, the first edge B1, the second edge B2, the third edge B3, and the fourth edge B4 may surround the first cover 112.

According to an embodiment, the second side 2212 of the second frame 221 may include a fifth edge B5, a sixth edge B6, a seventh edge B7, and/or an eighth edge B8. The fifth edge B5 may extend in a direction perpendicular to the center line A of the foldable electronic device 2. The seventh edge B7 may be spaced apart from the fifth edge B5 in the direction of the center line A of the foldable electronic device 2, and may be substantially parallel to the fifth edge B5. The sixth edge B6 may interconnect one end of the fifth edge B5 and one end of the seventh edge B7. The eighth edge B8 may interconnect the other end of the fifth edge B5 and the other end of the seventh edge B7. The sixth edge B6 and the eighth edge B8 may be substantially parallel to each other. The eighth edge B8 may be located closer to the center line A of the foldable electronic device 6 than the sixth edge B6.

According to an embodiment, a third corner C3 where the fifth edge B5 and the sixth edge B6 are connected, and/or a fourth corner C4 where the sixth edge B6 and the seventh edge B7 are connected may be provided (or formed) in a smoothly curved shape.

According to an embodiment, when viewed from above the second cover 222, the fifth edge B5, the sixth edge B6, the seventh edge B7, and the eighth edge B8 may surround the second cover 222.

According to an embodiment, in the folded state of the foldable electronic device 2, the first side 2112 of the first frame 211 and the second side 2212 of the second frame 221 may be aligned with and overlap each other. In the folded state of the foldable electronic device 2, the first edge B1 and the fifth edge B5 may be aligned with and overlap each other. When the foldable electronic device 2 is in the folded state, the second edge B2 and the sixth edge B6 may be aligned with and overlap each other. When the foldable electronic device 2 is in the folded state, the third edge B3 and the seventh edge B7 may be aligned with and overlap each other.

According to an embodiment, the fourth edge B4 and the eighth edge B8 may be located on opposite sides of the third display area 253. When viewed from above the front surface of the foldable electronic device 2 in the unfolded state, the fourth edge B4 and the eighth edge B8 may be invisible. For example, referring to the foldable electronic device 2 in the unfolded state, the surface area provided by the third display area 253, which is arranged to be substantially flat in the exterior of the foldable electronic device 2, may be oriented in the +z-axis direction, and the surface area provided by the fourth edge B4 and the eighth edge B8 in the exterior of the foldable electronic device 2 may be oriented in the -z-axis direction on the opposite side of the surface area provided by the third display area 253.

According to an embodiment, a hinge housing (or a hinge cover) 23 may include one or more hinge modules (e.g., a first hinge module 241, a second hinge module 242, and a third hinge module 243). The one or more hinge modules may interconnect the first support 2111 of the first frame 211 and the second support 2211 of the second frame 221.

According to an embodiment, when the foldable electronic device 2 switches from the unfolded state to the folded state, a gap between the first frame 211 and the second frame 221 may open on the opposite side of the third display area 253 due to a change in the relative position between the first frame 211 and the second frame 221 connected to each other via the hinge portion 24 and a change in the state of the hinge portion 24 coupled with the hinge housing 23. The hinge housing 23 may be exposed to the outside through the open gap. In the folded state of the foldable electronic device 2, the hinge housing 23 may be exposed to the outside through an open gap between the fourth edge B4 and the eighth edge B8. The hinge housing 23 may be exposed to a greater extent in the folded state of the foldable electronic device 2 than in the intermediate state of the foldable electronic device 2. In the folded state of the foldable electronic device 2, the hinge housing 23 may be a portion of the exterior that covers the interior of the foldable electronic device 2. When the foldable electronic device 2 is in the folded state, the side surface of the foldable electronic device 2 may include a first side surface area provided by the first side 2112 of the first frame 211, a second side surface area provided by the second side 2212 of the second frame 221, and a third side surface area provided by the hinge housing 23.

According to an embodiment, when the foldable electronic device 2 switches from the folded state to the unfolded state, the gap between the first frame 211 and the second frame 221 may be closed on the opposite side of the third display area 253 due to a change in the relative position between the first frame 211 and the second frame 221 connected to each other via the hinge portion 24 and a change in the state of the hinge portion 24 coupled with the hinge housing 23. The hinge housing 23 may not be exposed to the outside. When the foldable electronic device 2 is in the unfolded state, the gap between the fourth edge B4 and the eighth edge B8 may be closed, and the hinge housing 23 may not be exposed to the outside.

According to an embodiment, the first edge B1, the second edge B2, and the third edge B3 may be one side bezel (or screen bezel) surrounding one side area of the first display module 25 with respect to the center line A of the foldable electronic device 2. The fifth edge B5, the sixth edge B6, and the seventh edge B7 may be the other side bezel (or screen bezel) surrounding the other side area of the first display module 25 with respect to the center line A of the foldable electronic device 2.

According to an embodiment, the first frame 211 and/or the second frame 221 may be provided as a combination of a conductor (or a metal body) (not separately illustrated) including one or more conductive portions and a non-conductor (or a non-metal body) (not separately illustrated) including one or more non-conductive portions.

According to an embodiment, the first side 2112 of the first frame 211 may include a first side metal (or, a first side metal structure, a first side conductor, a first side conductive structure, a first outer metal structure, a first outer conductor, a first outer conductive structure, a first side surface metal, a first side surface metal structure, a first side surface conductor, or a first side surface conductive structure) 2112E (see FIG. 5), and a first side non-metal (or, a first side non-metal structure, a first side non-conductor, a first side non-conducting structure, a first outer non-metal structure, a first outer non-conductor, a first outer non-conductive structure, a first side surface non-metal, a first side surface non-metal structure, a first side surface non-conductor, or a first side surface non-conductive structure) 2112F (see FIG. 5).

According to an embodiment, the first side metal 2112E of the first side 2112 (see FIG. 5) may include a plurality of metals (or, outer metals, outer conductive portions, or side surface conductive portions) E1, E2, E3, E4, E5, and E6. The plurality of metals E1, E2, E3, E4, E5, and E6 of the first side metal 2112E may include, for example, a first metal E1, a second metal E2, a third metal E3, a fourth metal E4, a fifth metal E5, and/or a sixth metal E6.

According to an embodiment, the first metal E1 may be located between the second metal E2 and the sixth metal E6. The first metal E1 may extend from one end adjacent to the second metal E2 to the other end adjacent to the sixth metal E6. The first metal E1 may provide (or form) a portion of the first edge B1.

According to an embodiment, the first metal E2 may be located between the second metal E1 and the third metal E3. The second metal E2 may extend from one end adj acent to the first metal E1 to the other end adj acent to the third metal E3. The second metal E2 may provide (or form) a first corner C1, a portion of the first edge B1 extending from the first corner C1, and a portion of the second edge B2 extending from the first corner C1.

According to an embodiment, the third metal E3 may be located between the second metal E2 and the fourth metal E4. The third metal E3 may extend from one end adjacent to the second metal E2 to the other end adjacent to the fourth metal E4. The third metal E3 may provide (or form) a portion of the second edge B2.

According to an embodiment, the fourth metal E4 may be located between the third metal E3 and the fifth metal E5. The fourth metal E4 may extend from one end adjacent to the second metal E3 to the other end adjacent to the fifth metal E5. The fourth metal E4 may provide (or form) a second corner C2, a portion of the second edge B2 extending from the first corner C2, and a portion of the third edge B3 extending from the second corner C2.

According to an embodiment, the fifth metal E5 may be located between the fourth metal E4 and the sixth metal E6. The fifth metal E5 may extend from one end adjacent to the fourth metal E4 to the other end adjacent to the sixth metal E6. The fifth metal E5 may provide (or form) a portion of the third edge B3.

According to an embodiment, the sixth metal E6 may be located between the fifth metal E5 and the sixth metal E1. The sixth metal E6 may extend from one end adjacent to the fifth metal E5 to the other end adjacent to the first metal E1. The sixth metal E6 may provide (or form) a fourth edge B4, a portion of the first edge B1 extending from one end of the fourth corner B4, and a portion of the third edge B3 extending from the other end of the fourth corner B4.

According to an embodiment, the first side non-metal 2112F of the first side 2112 (see FIG. 5) may include a plurality of non-metals (or, outer non-metals, outer non-conductive portions, or side surface non-conductive portions) F1, F2, F3, F4, F5, and F6. The plurality of non-metals F1, F2, F3, F4, F5, and F6 of the first side non-metal 2112F may include, for example, a first non-metal F1, a second non-metal F2, a third non-metal F3, a fourth non-metal F4, a fifth non-metal F5, and/or a sixth non-metal F6.

According to an embodiment, the first non-metal F1 (e.g., a first insulating portion) may be disposed in a first split portion (e.g., a first gap) between the first metal E1 and the second metal E2. The first metal E1 and the second metal E2 may be physically separated from each other with the first non-metal F1 interposed therebetween. The first non-metal F1 may provide (or form) a portion of the first edge B 1.

According to an embodiment, the second non-metal F2 (e.g., a second insulating portion) may be disposed in a second split portion (e.g., a second gap) between the second metal E2 and the third metal E3. The second metal E2 and the third metal E3 may be physically separated from each other with the second non-metal F2 interposed therebetween. The second non-metal F2 may provide (or form) a portion of the second edge B2.

According to an embodiment, the third non-metal F3 (e.g., a third insulating portion) may be disposed in a third split portion (e.g., a third gap) between the third metal E3 and the fourth metal E4. The third metal E3 and the fourth metal E4 may be physically separated from each other with the third non-metal F3 interposed therebetween. The third non-metal F3 may provide (or form) a portion of the second edge B2.

According to an embodiment, the fourth non-metal F4 (e.g., a fourth insulating portion) may be disposed in a fourth split portion (e.g., a fourth gap) between the fourth metal E4 and the fifth metal E5. The fourth metal E4 and the fifth metal E5 may be physically separated from each other with the fourth non-metal F4 interposed therebetween. The fourth non-metal F4 may provide (or form) a portion of the third edge B3.

According to an embodiment, the fifth non-metal F5 (e.g., a fifth insulating portion) may be disposed in a fifth split portion (e.g., a fifth gap) between the fifth metal E5 and the sixth metal E6. The fifth metal E5 and the sixth metal E6 may be physically separated from each other with the fifth non-metal F5 interposed therebetween. The fifth non-metal F5 may provide (or form) a portion of the third edge B3.

According to an embodiment, the sixth non-metal F6 (e.g., a sixth insulating portion) may be disposed in a sixth split portion (e.g., a sixth gap) between the sixth metal E6 and the first metal E1. The sixth metal E6 and the first metal E1 may be physically separated from each other with the sixth non-metal F6 interposed therebetween. The sixth non-metal F6 may provide (or form) a portion of the first edge B 1.

According to various embodiments, although not separately illustrated, the number, locations, and/or shapes of metals and/or non-metals included in the first side 2112 are not limited to the illustrated examples and may vary.

According to an embodiment, the first support 2111 of the first frame 211 may be provided (or formed) by a combination of a first inner metal (not separately illustrated) and a first inner non-metal (not separately illustrated). The first inner metal may include a combination of one or more conductive portions. The first inner non-metal may include a combination of one or more non-conductive portions. Some surface areas of first support 2111 may include a conductive surface area provided by the first inner metal, and other partial surface areas of the first support 2111 may include a non-conductive surface provided by the first inner non-metal.

According to an embodiment, the first inner metal (not separately illustrated) of the first support 2111 may be connected to the first side metal 2112E of the first side 2112. For example, the first metal material included in the first inner metal of the first support 2111 may be the same as or different from the second metal material included in the first side metal 2112E.

According to an embodiment, an integrated or single metal (or metal structure) (e.g., a single continuous structure or complete structure) including a first inner metal (not separately illustrated) of the first support 2111 and a first side metal 2112E of the first side 2112 may be provided (or formed).

According to an embodiment, the first inner non-metal (not separately illustrated) of the first support 2111 may be connected to the first side non-metal 2112F of the first side 2112. For example, the first non-metal material included in the first inner non-metal may be the same as or different from the second non-metal material included in the first side non-metal F.

According to an embodiment, an integrated or single non-metal (or non-metal structure) (e.g., a single continuous structure or complete structure) including a first inner non-metal (not separately illustrated) of the first support 2111 and a first side non-metal 2112F of the first side 2112 may be provided (or formed).

According to an embodiment, the second side 2212 of the second frame 221 may include a second side metal 2212E including a plurality of metals E7, E8, E9, E10, E11, and E12, and a second side non-metal 2212F including a plurality of non-metals F7, F8, F9, F10, F11, and F12. The plurality of metals E7, E8, E9, E10, E11, and E12 of the second side metal 2212E may include, for example, a seventh metal E7, an eighth metal E8, a ninth metal E9, a tenth metal E10, an eleventh metal E11, and/or a twelfth metal E12. The plurality of non-metals F7, F8, F9, F10, F11, and F12 of the second side metal 2212F may include, for example, a seventh non-metal F7, an eighth non-metal F8, a ninth non-metal F9, a tenth non-metal F10, an eleventh non-metal F 11, and/or a twelfth non-metal F12.

According to an embodiment, when the foldable electronic device 2 is in the folded state, the first side metal 2112E included in the first side 2112 of the first frame 211 and the second side metal 2212E included in the second side 2212 of the second frame 221 may be aligned with and overlap each other. For example, when the foldable electronic device 2 is in the folded state, the plurality of metals E1, E2, E3, E4, E5, and E6 included in the first side 2112 and the plurality of metals E7, E8, E9, E10, E11, and E12 included in the second side 2212 may be respectively and correspondingly aligned with and overlap each other.

According to an embodiment, when the foldable electronic device 2 is in the folded state, the first side non-metal 2112F included in the first side 2112 of the first frame 211 and the second side non-metal 2212F included in the second side 2212 of the second frame 221 may be aligned with and overlap each other. For example, when the foldable electronic device 2 is in the folded state, the plurality of non-metals F1, F2, F3, F4, F5, and F6 included in the first side 2112 and the plurality of non-metals F7, F8, F9, F10, F11, and F12 included in the second side 2212 may be respectively and correspondingly aligned with and overlap each other.

According to an embodiment, the second support 2211 of the second frame 221 may be implemented to be at least partially the same as or similar to the first support 2111 of the first frame 211. The second support 2211 may be provided (or formed) by a combination of a second inner metal (not separately illustrated) and a second inner non-mental (not separately illustrated).

According to an embodiment, the foldable electronic device 2 may include a ground structure (e.g., not separately illustrated). The ground structure may reduce or prevent electromagnetic interference (EMI) to a plurality of electrical elements included in the foldable electronic device 2. The ground structure of the foldable electronic device 2 may reduce or prevent the electromagnetic influence of noise from outside the foldable electronic device 2 on a plurality of electric components included in the foldable electronic device 2. The ground structure of the foldable electronic device 2 may reduce or prevent electromagnetic interference between the electric components included in the foldable electronic device 2. The ground structure of the foldable electronic device 2 may include, for example, a combination of a plurality of conductors electrically and/or physically connected to each other.

According to an embodiment, the ground structure of the foldable electronic device 2 may include a first inner metal (not separately illustrated) of the first support 2111 and a second inner metal (not separately illustrated) of the second support 2211.

According to an embodiment, the ground structure of the foldable electronic device 2 may include at least one ground plane included in at least one printed circuit board (not separately illustrated) disposed on the first support 2111. Through at least one flexible conductor (or, a flexible conductive portion or flexible conductive member) (not separately illustrated) located between a first inner metal (not separately illustrated) of the first support 2111 and at least one printed circuit board (not separately illustrated) disposed on the first support 2111, the first inner metal may be electrically connected to at least one ground plane included in the at least one printed circuit board. The flexible conductor may include, for example, a conductive clip (e.g., a conductive structure including an elastic structure), a pogo-pin, a spring, conductive Poron, conductive sponge, conductive rubber, conductive tape, or a conductive connector.

According to an embodiment, the ground structure of the foldable electronic device 2 may include at least one ground plane included in at least one printed circuit board (not separately illustrated) disposed on the second support 2211. Through at least one flexible conductor located between a second inner metal (not separately illustrated) of the second support 2211 and at least one printed circuit board (not separately illustrated) disposed on the second support 2211, the second inner metal may be electrically connected to at least one ground plane included in the at least one printed circuit board.

According to an embodiment, the ground structure of the foldable electronic device 2 may include at least a portion of the first side metal E of the first side 2112. For example, a portion of the first side metal E may be physically connected to the first inner metal (not separately illustrated) of the first support 2111. For example, through at least one flexible conductor located between the first side metal E and at least one printed circuit board (not separately illustrated) disposed on the first support 2111, a portion of the first side metal E may be electrically connected to at least one ground plane included in the at least one printed circuit board.

According to an embodiment, the ground structure of the foldable electronic device 2 may include at least a portion of the second side metal (not separately illustrated) of the second side 2212. For example, a portion of the second side metal may be physically connected to the second inner metal (not separately illustrated) of the second support 2211. For example, through at least one flexible conductor located between the second side metal and at least one printed circuit board (not separately illustrated) disposed on the second support 2211, a portion of the second side metal may be electrically connected to at least one ground plane included in the at least one printed circuit board.

According to an embodiment, the ground structure of the foldable electronic device 2 may include at least one conductive layer (e.g., a metal sheet for electromagnetic shielding such as a copper sheet) (not separately illustrated) included in the first display module 25. For example, through the first conductive member located between the first display module 25 and the first support 2111, at least one conductive layer included in the first display module 25 may be electrically connected to the first inner metal (not separately illustrated) of the first support 2111. For example, through the second conductive member located between the first display module 25 and the second support 2211, at least one conductive layer included in the first display module 25 may be electrically connected to the second inner metal (not separately illustrated) of the second support 2211. The first conductive member and/or the second conductive member may include a conductive adhesive material (or a conductive bonding material) or a flexible conductor (or, a flexible conductive portion or a flexible conductive member).

According to an embodiment, the ground structure of the foldable electronic device 2 may include at least one conductive layer (e.g., a metal sheet for electromagnetic shielding such as a copper sheet) (not separately illustrated) included in the second display module 26. For example, through the third conductive member located between the second display module 26 and the second support 2211, at least one conductive layer included in the second display module 26 may be electrically connected to the second inner metal (not separately illustrated) of the second support 2211. The third conductive member may include a conductive adhesive material (or a conductive bonding material) or a flexible conductor (or, a flexible conductive portion or a flexible conductive member).

According to various embodiments, the ground structure of the foldable electronic device 2 may further include various other conductors or metal bodies (not separately illustrated).

According to an embodiment, at least one metal included in the first side 2112 and/or at least one metal included in the second side 2212 may be electrically connected to a wireless communication circuit (e.g., the wireless communication module 192 of FIG. 1) included in the foldable electronic device 2 and may operate as an antenna radiator. At least one metal included in the first side 2112 and/or at least one metal included in the second side 2212 may receive a signal (e.g., an electromagnetic signal, a radio signal, an RF signal, or a radiation current) from a wireless communication circuit and may emit electromagnetic waves.

According to an embodiment, the wireless communication circuit (e.g., the wireless communication module 192 in FIG. 1) of the foldable electronic device 2 may be configured to transmit a signal of at least one selected or predetermined frequency band to the outside of the foldable electronic device 2 through at least one metal included in the first side 2111 and/or the at least one metal included in the second side 2112. The wireless communication circuit may be configured to receive a signal of at least one selected or predetermined frequency band from the outside of the foldable electronic device 2 through at least one metal included in the first side 2112 and/or at least one metal included in the second side 2212.

According to an embodiment, the at least one selected or predetermined frequency band in which the wireless communication circuit (e.g., wireless communication module 192 of FIG. 1) of the foldable electronic device 2 processes the transmitted signal and/or the received signal may include at least one of a low band (LB) (about 600 megahertz (MHz) to about 1 gigahertz (GHz)), a middle band (MB) (about 1 GHz to about 2.3 GHz), a high band (HB) (about 2.3 GHz to about 2.7 GHz), or an ultra-high band (UHB) (about 2.7 GHz to about 6 GHz). The selected or predetermined frequency band may include a variety of other frequency bands.

According to an embodiment, when the foldable electronic device 2 is in the folded state, by arranging a plurality of non-metals F1, F2, F3, F4, F5, F6, and F7 included in the first side 2112 and a plurality of non-metals included in the second side 2212 to be respectively and correspondingly aligned with each other, it is possible to reduce the degradation of antenna radiation performance when at least one metal included in the first side 2112 and/or at least one metal included in the second side 2212 is used as an antenna radiator.

According to an embodiment, the foldable electronic device 2 may include a first conductive area (not separately illustrated) and a second conductive area (not separately illustrated). The first conductive area and the second conductive area may be electrically connected to each other, or may be electrically and/or physically connected to each other. According to various embodiments of the disclosure, when the first conductive area is configured to substantially radiate electromagnetic waves, the first conductive area of the combination of the first conductive area and the second conductive area may be defined or interpreted as an antenna radiator, and the second conductive area of the combination of the first conductive area and the second conductive area may be defined or interpreted as a ground structure of the foldable electronic device 2 that is distinct from the antenna radiator. According to various embodiments of the disclosure, when the first conductive area is configured to substantially radiate electromagnetic waves, the combination of the first conductive area and the second conductive area may be defined or interpreted as a ground structure of the foldable electronic device 2, and the first conductive area may be defined or interpreted as an antenna radiator implemented through a portion of the ground structure of the foldable electronic device 2. According to various embodiments of the disclosure, when the first conductive area is configured to substantially radiate electromagnetic waves, the second conductive area may be configured as an antenna ground that electromagnetically affects the first conductive area (e.g., an antenna radiator). The antenna ground may contribute to ensuring antenna radiation performance (or, radio wave transmission/reception performance or communication performance) and/or coverage relative to the antenna radiator. The antenna ground may reduce electromagnetic interference (EMI) or signal loss relative to the antenna radiator.

According to an embodiment, a portion of the ground structure of the foldable electronic device 2 (not separately illustrated) may operate as an antenna radiator. A of the ground structure of the foldable electronic device 2 may be electrically connected to a wireless communication circuit (e.g., the wireless communication module 192 of FIG. 1) of the foldable electronic device 2. A portion of the ground structure of the foldable electronic device 2 may receive (or may be fed with) a signal (e.g., an electromagnetic signal, a radio signal, a RF signal, or a radiation current) from the wireless communication circuit and may be operate as an antenna radiator (or, a radiator, a radiating portion, or a resonator). Various conductive portions (or, conductors, conductive areas, or conductive patterns) configured to radiate electromagnetic waves may be defined or interpreted as excluded from the ground structure of the foldable electronic device 2.

According to an embodiment, a portion of the ground structure (not separately illustrated) of the foldable electronic device 2 may be configured as an antenna ground that has an electromagnetic influence on at least one antenna radiator (not separately illustrated).

According to an embodiment, the second display module 26 may be located between the second cover 222 and the second support 2211 of the second frame 221. The second display module 26 may be disposed on or coupled to the second cover 222 and/or the second support 2211. The display area of the second display module 26 may be visually visible through the second cover 222.

According to an embodiment, the first camera module 301, the second camera module 302, the third camera module 303, the fourth camera module 304, and/or the fifth camera module 305 may include one or more lenses, one or more image sensors, and/or an image signal processor (ISP).

According to an embodiment, the first camera module 301, the second camera module 302, and the third camera module 303 may be accommodated in the first housing 21 to correspond to the first cover 212 (or the first rear surface area of the foldable electronic device 1). For example, the first cover 212 may include a first camera hole (or a first light transmission area) corresponding to the first camera module 301, a second camera hole (or a second light transmission area) corresponding to the second camera module 302, and/or a third camera hole (or a third light transmission area) corresponding to the third camera module 303. The positions or number of camera modules accommodated in the first housing 21 to correspond to the first cover 212 may vary without being limited to the illustrated example.

According to an embodiment, the first camera module 301, the second camera module 302, or the third camera module 303 may include a wide-angle camera module, a telephoto camera module, a color camera module, a monochrome camera, or an IR camera (e.g., a time-of-flight (TOF) camera or a structured light camera module).

According to an embodiment, the first camera module 301, the second camera module 302, and the third camera module 303 may have different properties (e.g., angles of view) or functions.

According to various embodiments, the first camera module 301, the second camera module 302, or the third camera module 303 may provide different angles of view (or lenses with different angles of view). The foldable electronic device 2 may selectively use the angle of view of the first camera module 301, the second camera module 302, or the third camera module 303 based on a user's selection regarding the angle of view.

According to an embodiment, the fourth camera module 304 may be accommodated in the first housing 21 to correspond to the first front surface area of the foldable electronic device 2.

According to an embodiment, the fourth camera module 304 may overlap the first display area 251 of the first display module 25 when viewed from above the first front surface area of the foldable electronic device 2. The fourth camera module 304 may be located on the rear surface of the first display area 351 or below the first display area 351. When viewed from the outside of the foldable electronic device 2, the fourth camera module 304 or the position of the fourth camera module 304 may not be substantially visually distinguished (or exposed). The fourth camera module 304 may include, for example, a hidden behind-display camera (e.g., an under-display camera (UDC)). External light may pass through the first display module 25 and reach the fourth camera module 304.

According to various embodiments, the illustrated embodiment may be modified such that the fourth camera module 304 is accommodated in the second housing 12 to correspond to the second front surface area of the foldable electronic device 2. In various embodiments, an additional camera module (not separately illustrated) may be accommodated in the second housing 22 to correspond to the second front surface area of the foldable electronic device 2.

According to an embodiment, the fifth camera module 305 may be accommodated in the second housing 22 to correspond to the second cover 222 (or the second rear surface area of the foldable electronic device 2).

According to an embodiment, the fifth camera module 305 may be located in alignment with an opening provided in the second display module 26 or may be at least partially inserted into the opening. External light may pass through the second cover 222 and the opening provided in the second display module 26 and reach the fifth camera module 305. The opening of the second display module 26 aligned with or overlapping the fifth camera module 305 may be a through hole. In various embodiments, the opening in the second display module 26 aligned with or overlapping the fifth camera module 305 may be provided as a notch (not separately illustrated).

According to various embodiments, the fifth camera module 305 may overlap the second display area 26 when viewed from above the second rear surface area of the foldable electronic device 2. The fifth camera module 305 may be located on the rear surface of the second display area 26 or below the second display area 26. When viewed from the outside of the foldable electronic device 2, the fifth camera module 305 or the position of the fifth camera module 305 may not be substantially visually distinguished (or exposed). The fifth camera module 305 may include, for example, a hidden behind-display rear camera (e.g., a UDC). External light may pass through the second display module 26 and reach the fifth camera module 305 through the second cover 222.

According to various embodiments, the first camera module 301, the second camera module 302, the third camera module 303, the fourth camera module 304, or the fifth camera module 305 may operate as at least a portion of a sensor module. For example, an IR camera module may operate as at least portion of a sensor module.

According to an embodiment, the light-emitting module 306 may be accommodated in the first housing 21 to correspond to the first cover 212 (or the first rear surface area of the foldable electronic device 2). The first cover 212 may include a flash hole (or a fourth light transmission area) corresponding to the light-emitting module 306. The light-emitting module 306 may include, for example, an LED or a xenon lamp. The light-emitting module 306 may include a light source for the first camera module 301, the second camera module 302, and/or the third camera module 303.

According to various embodiments, the foldable electronic device 2 may further include another light-emitting module (not separately illustrated) accommodated in the foldable housing 20 to correspond to the front surface of the foldable electronic device 2. The light-emitting module may provide, for example, the state information of the foldable electronic device 2 in an optical form. In various embodiments, the light-emitting module may provide a light source that operates in conjunction with the operation of the fourth camera module 304.

According to an embodiment, the sensor module 307 may be accommodated in the foldable housing 20 to correspond to the front of the foldable electronic device 2.

According to an embodiment, the sensor module 307 may include an optical sensor module. The optical sensor module may include, for example, a proximity sensor module or an illuminance sensor module.

According to an embodiment, the sensor module 307 may overlap the first display area 251 of the first display module 25 when viewed from above the first front surface area of the foldable electronic device 2. The sensor module 307 may be located on the rear surface of the first display area 251 or below the first display area 251. When viewed from the outside of the foldable electronic device 2, the sensor module 307 or the position of the sensor module 307 may not be substantially visually distinguished (or exposed). External light may pass through the first display module 25 and reach the sensor module 307.

According to various embodiments, the foldable electronic device 2 may further include various other sensor modules (e.g., a biometric sensor modules) (not separately illustrated).

According to an embodiment, the first audio input module may include a first microphone (or a first mic) (not separately illustrated). The second audio input module may include a second microphone (or a second mic) (not separately illustrated). The third audio input module may include a third microphone (or a third mic) (not separately illustrated). The fourth audio input module may include a fourth microphone (or a fourth mic) (not separately illustrated). The first microphone may be accommodated in the first housing 21 to correspond to the first microphone hole H11 included in the first edge B1 of the first side 2112. The second microphone may be accommodated in the second housing 21 to correspond to the second microphone hole H12 included in the third edge B3 of the first side 2112. The third microphone may be accommodated in the first housing 21 to correspond to the third microphone hole H13 included in the third edge B3 of the first side 2112. The fourth microphone may be accommodated in the second housing 22 to correspond to the fourth microphone hole H14 included in the seventh edge B7 of the second side 2212. The positions or numbers of microphones and microphone holes corresponding to the microphones may vary without being limited to the illustrated example.

According to an embodiment, the first audio output module may include a first speaker (not separately illustrated). The second audio output module may include a second speaker (not separately illustrated). The first speaker or the second speaker may be a speaker for multimedia playback or recording playback. The first speaker may be accommodated in the second housing 22 to correspond to the first speaker hole H21 included in the second side 2212. The second speaker may be accommodated in the second housing 22 to correspond to the second speaker hole H21 provided in the second side 2212. The positions or numbers of speakers for multimedia playback or recording playback and speaker holes corresponding to the speakers may vary without being limited to the illustrated example.

According to an embodiment, the third audio output module may include a third speaker (not separately illustrated). The third speaker may include a call receiver. The third speaker may be accommodated in the first housing 21 to correspond to the third speaker hole H23 provided between the second cover 222 and the seventh edge B7 of the second side 2212. The positions or numbers of communication speakers and speaker holes corresponding to the speakers may vary without being limited to the illustrated example.

According to an embodiment, the key input module may include a first key (or first side key) 309, a second key (or second side key 310), and/or a key signal generator (not separately illustrated). The first key 309 may be located in the first key hole included in the second edge B2 of the first side 2112. The second key 310 may be located in the second key hole included in the second edge B2 of the first side 2112. The key signal generator may be configured to generate a first key signal in response to a press or touch on the first key 309 and a second key signal in response to a press or touch on the second key 310. The positions or number of key input modules may vary without being limited to the illustrated example.

According to an embodiment, the first connection terminal 311 (or, a first connector or a first interface terminal) may be accommodated in the first housing 21 to correspond to a first connection terminal hole (e.g., a first connector hole) included in the first edge B1 of the first side 2112. The foldable electronic device 2 may transmit and/or receive power and/or data to/from an external electronic device electrically connected to the first connection terminal 311. The first connection terminal 311 may include, for example, a USB connector or an HDMI connector. The positions of the first connection terminal 311 and the first connection terminal hole corresponding to the first connection terminal 311 may vary without being limited to the illustrated example.

According to an embodiment, the second connection terminal 312 (or, a second connector or a second interface terminal) may be accommodated in the second housing 22 to correspond to a second connection terminal hole (e.g., a second connector hole) included in the sixth edge B6 of the second side 2112. An external storage medium such as a secure digital memory (SD) card, an SIM card, or a universal SIM (USIM) may be connected to the second connection terminal 312. The positions of the second connection terminal 312 and the second connection terminal hole corresponding to the second connection terminal 312 may vary without being limited to the illustrated example.

The foldable electronic device 2 may further include various components depending on its provided form. Although these components cannot be all listed as their modifications vary depending on the convergence trend of foldable electronic devices 2, components equivalent to the components mentioned above may be further included in the foldable electronic device 2. In various embodiments, specific components may be excluded from the above components or replaced with other components depending on the provided form of the foldable electronic device 2. It is to be understood that the disclosure envisions and includes all of the combinations of the above-mentioned features and/or embodiments. That is, all of the combinations of the above-described features are to be considered as being included in the disclosure as specific examples.

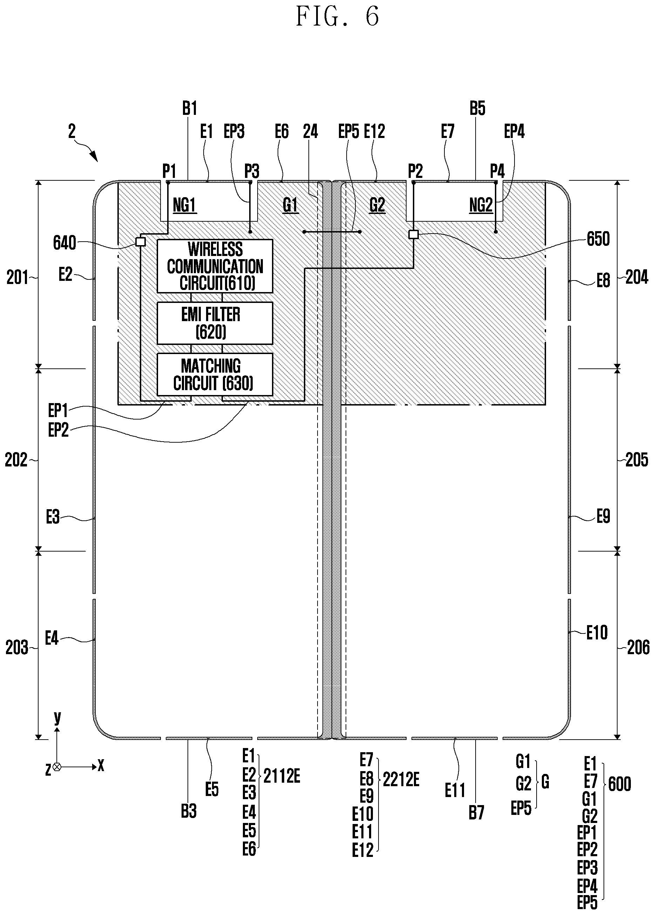

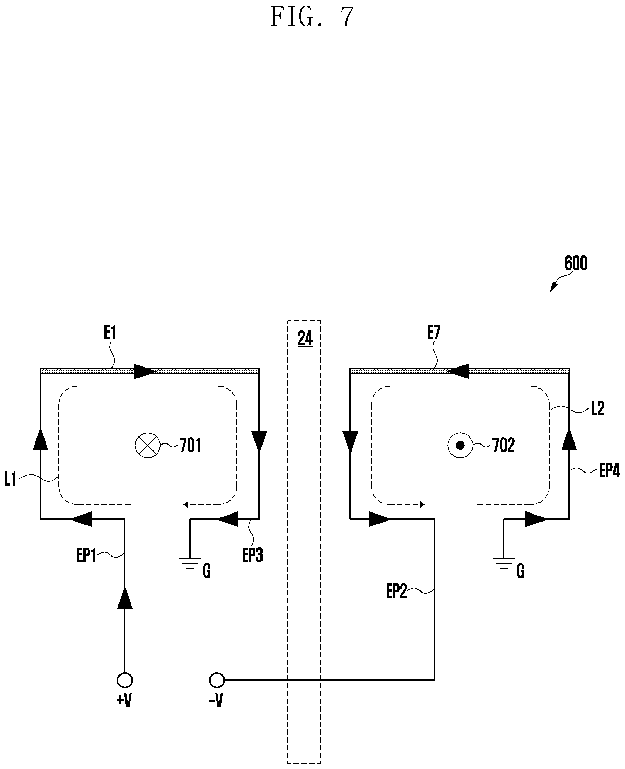

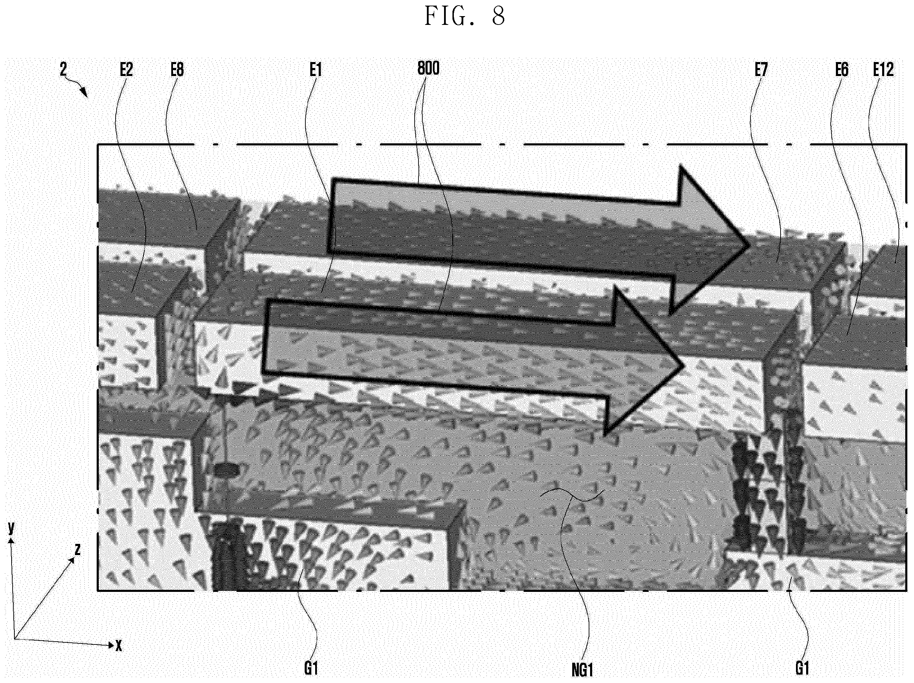

FIG. 6 is a view illustrating the foldable electronic device 2 according to an embodiment of the disclosure in an unfolded state. FIG. 7 is a circuit diagram of a first exemplary antenna structure 600 included in the foldable electronic device 2 according to an embodiment of the disclosure. FIG. 8 is a diagram illustrating a current distribution when the foldable electronic device 2 is in the folded state. It is to be understood that the disclosure conceives and includes all of the combinations of features and/or embodiments disclosed with reference to FIGS. 6, 7, and 8. That is, all of the combinations of features described below with reference to FIGS. 6, 7, and 8 are to be considered as being included in the disclosure as specific examples.

Referring to FIGS. 6, 7, and 8, the foldable electronic device 2 includes a first side metal 2112E, a second side metal 2212E, a first ground area G1, a second ground area G2, , a first electrical path EP1, a second electrical path EP2, a third electrical path EP3, a fourth electrical path EP4, a fifth electrical path EP5, a wireless communication circuit 610. Further, the foldable electronic device 2 may include the a first non-ground area NG1 and a second non-ground area NG2, an EMI filter 620, a matching circuit 630, a first filter 640, and/or a second filter 650. Although not separately illustrated, at least one of the above-mentioned components may be omitted from the foldable electronic device 2, or other components may be added to the foldable electronic device 2.

According to an embodiment, the first side metal 2112E may include a plurality of metals E1, E2, E3, E4, E5, and E6. The second side metal 2212E may include a plurality of metals E7, E8, E9, E10, E11, and E12. For example, when the foldable electronic device 2 is in the folded state (see FIG. 3), the plurality of metals E1, E2, E3, E4, E5, and E6 included in the first side metal 2112E and the plurality of metals E7, E8, E9, E10, E11, and E12 included in the second side metal 2212E may be respectively and correspondingly aligned with and overlap each other.

According to an embodiment, the first ground area G1 may include a portion of the ground structure (not separately illustrated) of the foldable electronic device 2 located corresponding to the first housing 21 (see FIG. 2). The first ground area G1 may include, for example, at least one ground plane included in the at least one printed circuit board (not separately illustrated) disposed on the first support 2111 (see FIG. 4), the first inner metal (not separately illustrated) of the first support 2111 (see FIG. 4), and/or a combination of one or more other conductors (or, conductive areas or conductive structures).

According to an embodiment, when viewed from above the first rear surface area (or the first display area 251 in FIG. 2) of the foldable electronic device 2, the first ground area G1 may overlap the first rear surface area. When viewed from above the first rear surface area of the foldable electronic device 2, the first ground area G1 may be surrounded by the first side metal 2112E.

According to an embodiment, at least one of the plurality of metals E1, E2, E3, E4, E5, and E6 included in the first side metal 2112E may be electrically and/or physically connected to the ground area G1.

According to an embodiment, at least one of the plurality of metals E1, E2, E3, E4, E5, and E6 included in the first side metal 2112E may be electrically and/or physically connected to the first ground area G1.

According to an embodiment, the second ground area G2 may include a portion of the ground structure (not separately illustrated) of the foldable electronic device 2 located corresponding to the second housing 22 (see FIG. 2). The second ground area G2 may include, for example, at least one ground plane included in the at least one printed circuit board (not separately illustrated) disposed on the second support 2211 (see FIG. 4), the second inner metal (not separately illustrated) of the second support 2211 (see FIG. 4), and/or a combination of one or more other conductors (or, conductive areas or conductive structures).

According to an embodiment, when viewed from above the second rear surface area (or the second display area 252 in FIG. 2) of the foldable electronic device 2, the second ground area G2 may overlap the second rear surface area. When viewed from above the second rear surface area of the foldable electronic device 2, the second ground area G2 may be surrounded by the second side metal 2212E.

According to an embodiment, at least one of the plurality of metals E7, E8, E9, E10, E11, and E12 included in the second side metal 2212E may be electrically and/or physically connected to the second ground area G2.

According to an embodiment, at least one of the plurality of metals E7, E8, E9, E10, E11, and E12 included in the second side metal 2212E may be electrically and/or physically connected to the second ground area G2.

According to an embodiment, the foldable electronic device 2 may include one or more first non-ground areas (or non-conductive areas) that are at least partially physically separated between the first ground area G1 and the first side metal 2112E. The illustrated first non-ground area NG1 may be, for example, one of one or more first non-ground areas located in the first housing 21 (see FIG. 2).

According to an embodiment, the one or more first non-ground areas located in the first housing 21 (see FIG. 2) may include one or more first openings formed in the first ground area G1. In various embodiments, the one or more first non-ground areas may include a non-conductive material (not separately illustrated) disposed (e.g., filled) in the one or more first openings. The non-conductive material disposed in the one or more first openings may, for example, be included in the first inner non-metal (not separately illustrated) included in the first support 2111 (see FIG. 4).

According to an embodiment, the first non-ground area NG1 may be located corresponding to the first edge B1. For example, the first metal E1 may be physically separated from the first ground area G1 with the first non-ground area NG1 interposed therebetween. For example, the first non-ground area NG1 may include a first opening in the form of a notch formed in the first ground area G1 to correspond to the first metal E1. The first non-ground area NG1 may include, for example, a non-conductive material disposed in the first opening.

According to an embodiment, the foldable electronic device 2 may include one or more second non-ground areas (or non-conductive areas) that are at least partially physically separated between the second ground area G2 and the second side metal 2212E. The illustrated second non-ground area NG2 may be, for example, one of one or more second non-ground areas located in the second housing 22 (see FIG. 2).

According to an embodiment, the one or more second non-ground areas located in the second housing 22 (see FIG. 2) may include one or more second openings formed in the second ground area G2. In various embodiments, the one or more second non-ground areas may include a non-conductive material (not separately illustrated) disposed (e.g., filled) in the one or more second openings. The non-conductive material disposed in the one or more second openings may, for example, be included in the second inner non-metal (not separately illustrated) included in the second support 2211 (see FIG. 4).

According to an embodiment, the second non-ground area NG2 may be located corresponding to the fifth edge B2. For example, the seventh metal E7 may be physically separated from the second ground area G2 with the second non-ground area NG2 interposed therebetween. For example, the second non-ground area NG2 may include a second opening in the form of a notch formed in the second ground area G2 to correspond to the seventh metal E7. The second non-ground area NG2 may include, for example, a non-conductive material disposed in the second opening.

According to an embodiment, when the foldable electronic device 2 in the folded state (see FIG. 3), the first non-ground area NG1 and the second non-ground area NG2 may overlap each other.

According to an embodiment, the first electrical path EP1 may electrically interconnect the first metal E1 and the wireless communication circuit 610. The first electrical path EP1 may be electrically connected to the first point P1 of the first metal E1. The first electrical path EP1 may include a combination of one or more conductive paths (or, conductors or conductive structures) (not separately illustrated) between the first metal E1 and the wireless communication circuit 610.

According to an embodiment, the first electrical path EP1 may be accommodated in the first housing 21 (see FIG. 2).

According to an embodiment, the wireless communication circuit 610 may be disposed on a first printed circuit board (not separately illustrated) disposed on the first support 2111 (see FIG. 4). The first electrical path EP1 may include, for example, a first conductive line (e.g., a first wire) included in the first printed circuit board, and an electrical connection structure between the first metal E1 and the first printed circuit board. One end of the first conductive line may be electrically connected to the wireless communication circuit 610. The other end of the first conductive line may be electrically connected to the electrical connection structure between the first metal E1 and the first printed circuit board. The electrical connection structure between the first metal E1 and the first printed circuit board may include, for example, a flexible conductor (or, a flexible conductive portion or a flexible conductive member) (not separately illustrated) disposed between the first metal E1 and the first printed circuit board. The flexible conductor may vary and include, for example, a conductive clip (e.g., a conductive structure including an elastic structure), a pogo pin, a spring, conductive Poron, conductive sponge, conductive rubber, conductive tape, or a conductive connector. The first metal E1 may include, for example, a first protrusion (not separately illustrated) that is in physical contact with a flexible conductor disposed on the first printed circuit board. The first protrusion may include a first point P1.

According to an embodiment, the second electrical path EP2 may electrically interconnect the seventh metal E7 and the wireless communication circuit 610. The second electrical path EP2 may be electrically connected to the second point P2 of the seventh metal E7. The second electrical path EP2 may include a combination of one or more conductive paths (or, conductors or conductive structures) (not separately illustrated) between the seventh metal E7 and the wireless communication circuit 610.

According to an embodiment, the second electrical path EP2 may extend from the first housing 21 (see FIG. 2) to the second housing 22 (see FIG. 2). The second electrical path EP2 may be disposed across the hinge portion 24.

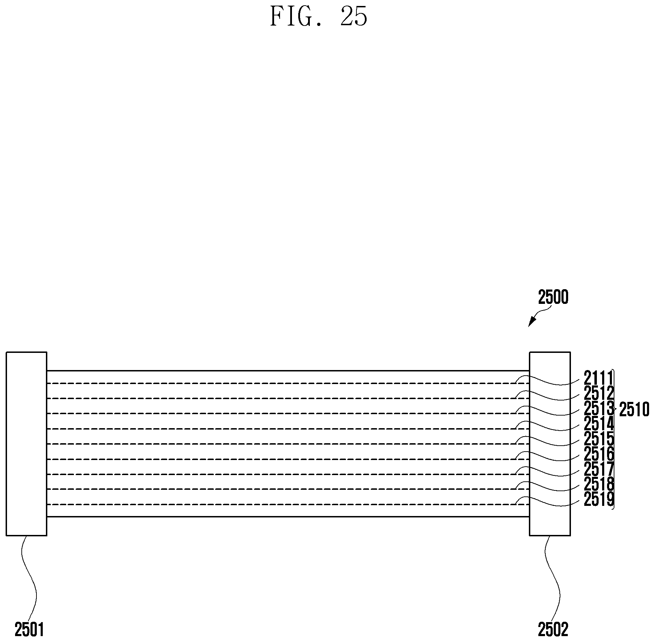

According to an embodiment, the foldable electronic device 2 may include a first printed circuit board (not separately illustrated) disposed on the first support 2111 (see FIG. 4), a second printed circuit board (not separately illustrated) disposed on the second support 2211 (see FIG. 4), and a flexible printed circuit board (e.g., the flexible printed circuit board 2500 in FIG. 25) electrically interconnecting the first printed circuit board and the second printed circuit board. The flexible printed circuit board may extend from the first housing 21 (see FIG. 2) to the second housing 22 (see FIG. 2) across the hinge portion 24. The second electrical path EP2 may include a second conductive line (e.g., a second wire) included in the first printed circuit board on which the wireless communication circuit 610 is disposed, a third conductive line (e.g., a third wire) included in the second printed circuit board, a fourth conductive line (e.g., a fourth wire) included in the flexible printed circuit board, and/or an electrical connection structure between the seventh metal E7 and the second printed circuit board. The second conductive line may be electrically connected to the wireless communication circuit 610. The third conductive line may be electrically connected to the electrical connection structure between the seventh metal E7 and the second printed circuit board. The fourth conductive line may electrically interconnect the second conductive line and the third conductive line. The electrical connection structure between the seventh metal E7 and the second printed circuit board may include, for example, a flexible conductor (or, a flexible conductive portion or a conductive member) disposed between the seventh metal E7 and the second printed circuit board (e.g., a conductive clip, a pogo pin, a spring, conductive Poron, conductive rubber, conductive tape, or a conductive connector) (not separately illustrated). For example, the seventh metal E7 may include a second protrusion (not separately illustrated) that is in physical contact with a flexible conductor disposed on the second printed circuit board. The second protrusion may include a second point P2.

According to an embodiment, the third electrical path EP3 may electrically interconnect the first metal E1 and the first ground area G1. The third electrical path EP3 may be electrically connected to the third point P3 of the first metal E1. The third electrical path EP3 may include a combination of one or more conductive paths (or, conductors or conductive structures) (not separately illustrated) between the first metal E1 and the first ground area G1.

According to an embodiment, the third electrical path EP3 is a flexible conductor (or, a flexible conductive portion or a flexible conductive member) that electrically interconnects the first metal E1 and the first ground area G1 (e.g., a conductive clip, a pogo pin, a spring, conductive Poron, conductive rubber, conductive tape, or a conductive connector) (not separately illustrated). The flexible conductor may be disposed on, for example, a first printed circuit board (not separately illustrated) disposed on the first support 2111 (see FIG. 4) and may be electrically connected to the first ground area G1. For example, the flexible conductor may be disposed on the first support 2111 (see FIG. 4) and may be electrically connected to the first ground area G1. The first metal E1 may include, for example, a third protrusion (not separately illustrated) that is in physical contact with a flexible conductor. The third protrusion may include a third point P3.

According to an embodiment, the fourth electrical path EP4 may electrically interconnect the seventh metal E7 and the second ground area G2. The fourth electrical path EP4 may be electrically connected to the fourth point P4 of the seventh metal E7. The fourth electrical path EP4 may include a combination of one or more conductive paths (or, conductors or conductive structures) (not separately illustrated) between the seventh metal E7 and the second ground area G2.

According to an embodiment, the fourth electrical path EP4 is a flexible conductor (or, a flexible conductive portion or a flexible conductive member) that electrically interconnects the seventh metal E7 and the second ground area G2 (e.g., a conductive clip, a pogo pin, a spring, conductive Poron, conductive rubber, conductive tape, or a conductive connector) (not separately illustrated). The flexible conductor may be disposed on, for example, a second printed circuit board (not separately illustrated) disposed on the second support 2211 (see FIG. 4) and may be electrically connected to the second ground area G2. For example, the flexible conductor may be disposed on the second support 2211 (see FIG. 4) and may be electrically connected to the second ground area G2. The seventh metal E7 may include, for example, a fourth protrusion (not separately illustrated) that is in physical contact with a flexible conductor. The fourth protrusion may include a fourth point P4.

According to an embodiment, the fifth electrical path EP5 may electrically interconnect the first ground area G1 and the second ground area G2. The fifth electrical path EP5 may include a combination of one or more conductive paths (or, conductors or conductive structures) (not separately illustrated) between the first ground area G1 and the second ground area G2.

According to an embodiment, at least a portion of the fifth electrical path EP5 may be included in a flexible printed circuit board (e.g., the flexible printed circuit board 2500 in FIG. 25) disposed across the hinge portion 24.

According to an embodiment, the foldable electronic device 2 may include a flexible printed circuit (e.g., the flexible printed circuit board 2500 of FIG. 25) extending from the first housing 21 (see FIG. 2) to the second housing 22 (see FIG. 2) across the hinge portion 24. The flexible printed circuit board may include, for example, a conductive line included in the second electrical path EP2 and a conductive line included in the fifth electrical path EP5.

According to an embodiment, the fifth electrical path EP5 is connected to at least one hinge module included in the hinge portion 24 (e.g., the first hinge module 241, the second hinge module 242, and /or the third hinge module 243 in FIG. 3). A first inner metal (not separately illustrated) included in the first ground area G1 of the first support 2111 (see FIG. 4) and a second inner metal (not separately illustrated) included in the second ground area G2 of the second support 2211 (see FIG. 4) may be electrically connected to each other through at least one hinge module.

According to an embodiment, the fifth electrical path EP5 may be defined or interpreted as a portion (e.g., a connection body, a connection member, or a connection structure) that electrically connects the first ground area G1 and the second ground area G2 of the ground structure of the foldable electronic device 2.

According to an embodiment, a first exemplary antenna structure 600 included in the foldable electronic device 2 may include a first metal E1, a seventh metal E7, a first ground area G1, a second ground area G2, a first electrical path EP1, a second electrical path EP2, a third electrical path EP3, a fourth electrical path EP4, and/or a fifth electrical path EP5.

According to an embodiment, the wireless communication circuit 610 may provide (or feed) a positive voltage (i.e., +voltage) (V) to the first metal E1 through the first electrical path EP1 and a negative voltage (i.e., -voltage) to the seventh metal E7 through the second electrical path EP2. The case where the wireless communication circuit 610 provides a +voltage to the first metal E1 through the first electrical path EP 1 and provides a -voltage to the second metal E7 through the second electrical path EP2 may be defined or interpreted as "differential feeding". Hereinafter, the case where the wireless communication circuit 610 provides a +voltage will be referred to as "positive (+) feeding", and the case where the wireless communication circuit 610 provides a -voltage will be referred to as "negative (-) feeding".

According to an embodiment, the combination of the first ground area G1, the second ground area G2, and the fifth electrical path EP5 may operate as an antenna ground G as an equal electrical element at the time of positive feeding and negative feeding of the wireless communication circuit 610.

According to an embodiment, at the time of positive feeding to the first electrical path EP1 and negative feeding to the second electrical path EP2, due to the potential difference, a first current flow corresponding to the first metal E1 and a second current flow corresponding to the seventh metal E7 may be provided (or formed). The first current flow may have a first current path (or first loop) L1 (see FIG. 7) in which a current (or radiation current) flows from the first electrical path EP1 to the third electrical path EP3 through the first metal E1. The second current flow may have a second current path (or second loop) L2 (see FIG. 7) in which a current (or radiation current) flows from the fourth electrical path EP4 to the second electrical path EP2 through the seventh metal E7. The first current path L1 and the distribution of current (or radiation current) along the first current path L1 may form an electromagnetic field (or magnetic field distribution) 701. The second current path L2 and the distribution of current along the second current path L2 may form an electromagnetic field (or magnetic field distribution) 702.

According to an embodiment, at the time of positive feeding to the electrical path EP1 and negative feeding to the second electrical path EP2, an electromagnetic field 701 including electromagnetic force passing through the first non-ground area NG1 between the first metal E1 and the second ground area G1, and an electromagnetic field 702 including electromagnetic force passing through a second non-ground area NG2 between the seventh metal E7 and the second ground area G2 may be provided (or formed).

According to an embodiment, the wireless communication circuit 610 may be configured to transmit and/or receive a signal of a frequency band selected or predetermined through an electromagnetic field 701 generated corresponding to the first current path L1 including the first metal E1 and/or an electromagnetic field 702 generated corresponding to the second current path L2 including the seventh metal E7 at the time of positive feeding to the first electrical path EP 1 and negative feeding to the second electrical path EP2.

According to an embodiment, the wireless communication circuit 610 may be configured to transmit and/or receive a signal of about 13.56 MHz for NFC through an electromagnetic field 701 generated corresponding to the first current path L1 including the first metal E1 and/or an electromagnetic field 702 generated corresponding to the second current path L2 including the seventh metal E7.

According to an embodiment, the first rear surface area of the exterior of the foldable electronic device 2 may include a first area (or first upper area) 201 and a second area (or first middle area) 202, and a third area (or first lower area) 203. The second area 202 may be located between the first area 201 and the third area 203. The first area 201 may be located closer to the first edge B 1 than the second area 202. The third area 203 may be located closer to the third edge B3 than the second area 202. The second rear surface area of the exterior of the foldable electronic device 2 may include a fourth area (or second upper area) 204, a fifth area (or second middle area) 205, and a sixth area (or second lower area) 206. The fifth area 205 may extend the fourth area 204 and the sixth area 206. The fourth area 204 may be located closer to the fifth edge B5 than the fifth area 205. The sixth area 206 may be located closer to the seventh edge B7 than the fifth area 205. When the foldable electronic device 2 is in the folded state, the first area 201 and the fourth area 204, the second area 202 and the fifth area 205, and the third area 203 and the six areas 206 may overlap each other. At the time of positive feeding to the first electrical path EP1 and negative feeding to the second electrical path EP2, the electromagnetic field 701 generated corresponding to the first current path L1 including the first metal E1 may be radiated through the first area 201 of the first rear surface area, and the electromagnetic field 702 generated corresponding to the second current path L2 including the seventh metal E7 may be radiated through the fourth area 204 of the second rear surface area. Compared to the second area 202 and the third area 203, the first area 201 may be less likely to be included in a grip position of a user's hand for the foldable electronic device 2 in the unfolded or folded state. By causing the electromagnetic field 701 generated corresponding to the first current path L1 including the first metal E1 to be radiated through the first area 201 of the first rear surface area, it is possible to reduce the limitations of a user's hand grip position for the foldable electronic device 2 in the unfolded or folded state and to reduce the possibility of deterioration of radiation performance due to a user's hand (e.g., dielectric). Compared to the fifth area 205 and the sixth area 206, the fourth area 204 may be less likely to be included in a grip position of a user's hand for the foldable electronic device 2 in the unfolded or folded state. By causing the electromagnetic field 702 generated corresponding to the second current path L2 including the seventh metal E7 to be radiated through the fourth area 204 of the second rear surface area, it is possible to reduce the limitations of a user's hand grip position for the foldable electronic device 2 in the unfolded or folded state and to reduce the possibility of deterioration of radiation performance due to a user's hand (e.g., dielectric).

According to an embodiment, when the foldable electronic device 2 is in the folded state, the first current path (or first loop) L1 including the first metal E1 and the second current path (or second loop) L2 including the seventh metal E7 may provide (or form) a coil (or coil-shaped loop). The first current path L1 may provide (or form) a first turn of the coil. The second current path L2 may provide (or form) a second turn of the coil. At the time of positive feeding to the first electrical path EP1 and negative feeding to the second electrical path EP2, the coil formed by a combination of the first turn of the first current path L1 and the second turn of the second current path L2 when the foldable electronic device 2 is in the folded state may improve radiation performance by generating an electromagnetic field that is a composite of the electromagnetic field 701 generated through the first current path L1 and the electromagnetic field 702 generated through the second current path L2.

According to an embodiment, the third point P3 of the first metal E1 electrically connected to the third electrical path EP3 may be located closer to the hinge portion 24 than the first point P1 of the first metal E1 electrically connected to the first electrical path EP1. The second point P2 of the first metal E7 electrically connected to the second electrical path EP2 may be located closer to the hinge portion 24 than the fourth point P4 of the seventh metal E7 electrically connected to the fourth electrical path EP4. At the time of positive feeding to the first electrical path EP1 and negative feeding to the second electrical path EP2, the current (or radiation current) may flow on the first metal E1 from the first point P1 to the third point P3, and may flow on the seventh metal E7 from the fourth point P4 to the second point P2. When the foldable electronic device 2 is in the folded state, the first metal E1 and the seventh metal E7 may be aligned with and overlap each other. At the time of positive feeding to the first electrical path EP 1 and negative feeding to the second electrical path EP2 when the foldable electronic device 2 is in the folded state, the direction in which the current (or radiation current) flows on the first metal E1 from the first point P1 to the third point P3 and the direction in which the current flows on the seventh metal E7 from the fourth point P4 to the second point P2 may be substantially the same. When the currents are caused to flow in substantially the same direction (see 800 in FIG. 8) on the first metal E1 and the seventh metal E7 which are aligned with and overlap each other when the foldable electronic device 2 is in the folded state, it is possible to improve radiation performance by generating an electromagnetic field with a relatively high intensity of electromagnetic force, compared to the case where the currents are to flow in opposite directions (e.g., reverse directions) on the first metal E1 and the seventh metal E7 which are aligned with and overlap each other when the foldable electronic device 2 is in the folded state.

In the disclosure, when it is described that radiation currents flow in the same direction on two metals aligned with each other (e.g., the first metal E1 and the seventh metal E7 at the time of feeding when the foldable electronic device is in the folded state, it may indicate that the phase of the radiation current (the phase of AC current) flowing on one metal (e.g., the first metal E1) and the phase of the radiation current flowing on the remaining metal (e.g., the seventh metal E7) substantially coincide at a specific point in time, i.e., that radiation currents have waveforms which are in-phase to each other. When it is described that the waveform of the radiation current flowing on one metal (e.g., the first metal E1) and the waveform of the radiation current flowing on the remaining metal (e.g., the seventh metal E7) are in the in-phase, it may mean that the waveforms are perfectly aligned in time, and the wave difference therebetween is 0. When it is described that radiation currents flow in different directions on two metals aligned with each other (e.g., the first metal E1 and the seventh metal E7) at the time of feeding when the foldable electronic device is in the folded state, it may indicate, for example, that the phase of the radiation current (the phase of AC current) flowing on one metal (e.g., the first metal E1) and the phase of the radiation current flowing on the remaining metal (e.g., the seventh metal E7) do not coincide at a specific point in time, i.e., that the radiation currents waveforms which are anti-phase to each other or have a relationship between in-phase and anti-phase relationships.

According to various embodiments, although not separately illustrated, the first electrical path EP1 may be electrically connected to the third point P3, and the third electrical path EP3 may be electrically connected to the first point P1. Although not separately illustrated, the second electrical path EP2 may be electrically connected to the fourth point P4, and the fourth electrical path EP4 may be electrically connected to the second point P2. At the time of positive feeding to the first electrical path EP1 and negative feeding to the second electrical path EP2, the current (or radiation current) may flow on the first metal E1 from the third point P3 to the first point P1, and may flow on the seventh metal E7 from the second point P2 to the fourth point P4. At the time of positive feeding to the first electrical path EP1 and negative feeding to the second electrical path EP2 when the foldable electronic device 2 is in the folded state, the direction in which the current (or radiation current) flows on the first metal E1 from the third point P3 to the first point P1 and the direction in which the current flows on the seventh metal E7 from the second point P2 to the fourth P4 may be substantially the same. When the currents are caused to flow in substantially the same direction on the first metal E1 and the seventh metal E7 when the foldable electronic device 2 is in the folded state, it is possible to improve radiation performance by generating an electromagnetic field with a relatively high intensity of electromagnetic force, compared to the case where the currents are caused to flow in opposite directions (e.g., reverse directions) on the first metal E1 and the seventh metal E7 which are aligned with and overlap each other when the foldable electronic device 2 is in the folded state.

According to various embodiments, the first metal E1 may extend from a first end adjacent to the second metal E2 to a second end adjacent to the sixth metal E6. The first point P1 may be located substantially at the first end of the first metal E1, but without being limited thereto, the first point P 1 may be formed at another position between the first end and the second end of the first metal E1. The third point P3 may be located substantially at the second end of the first metal E1, but without being limited thereto, the third point P3 may be formed at another position between the first end and the second end of the first metal E1.

According to various embodiments, the seventh metal E7 may extend from a third end adjacent to the eighth metal E8 to a fourth end adjacent to the twelfth metal E12. The fourth point P4 may be located substantially at the third end of the seventh metal E7, but without being limited thereto, the fourth point P4 may be formed at another position between the third end and the fourth end of the seventh metal E7. The second point P2 may be located substantially at the fourth end of the seventh metal E7, but without being limited thereto, the second point P2 may be formed at another position between the third end and the fourth end of the seventh metal E7.

According to an embodiment, the EMI filter 620 may be disposed in the first electrical path EP1 and/or the second electrical path EP2 or may be electrically connected to the first electrical path EP1 and/or the second electrical path EP2. The EMI filter 620 may reduce or shield noise affecting a signal (e.g., an NFC signal) in a selected or predetermined frequency band.

According to an embodiment, the matching circuit 630 may be disposed in the first electrical path EP1 and/or the second electrical path EP2 or may be electrically connected to the first electrical path EP1 and/or the second electrical path EP2. The matching circuit 630 may adjust the frequency of the first exemplary antenna structure 600 such that resonance can be generated, for example, in a selected or predetermined frequency band. The matching circuit 630 may move, for example, the resonance frequency of the first exemplary antenna structure 600 to a predetermined frequency, or may move the resonance frequency by a predetermined amount.

According to an embodiment, when the foldable electronic device 2 is in the unfolded state, the matching circuit 630 may adjust the frequency of the first exemplary antenna structure 600 such that the electromagnetic field 701 generated corresponding to the current path L1 including the first metal E1 and the electromagnetic field 702 generated corresponding to the second current path L2 including the seventh metal E7 at the time of positive feeding to the first electrical path EP1 and negative feeding to the second electrical path EP2 can have a resonance frequency of about 13.56 MHz for NFC. For example, when the foldable electronic device 2 is in the folded state, the matching circuit 630 may adjust the frequency of the first exemplary antenna structure 600 such that the electromagnetic field generated from the coil formed by the combination of the first turn of the first current path and the second turn of the second current path at the time of positive feeding to the first electrical path EP1 and negative feeding to the second electrical path EP2 can have a resonance frequency of about 13.56 MHz for NFC.

According to an embodiment, the matching circuit 630 may adjust the inductance of the first exemplary antenna structure 600 to have a predetermined inductance value at the time of positive feeding to the first electrical path EP1 and negative feeding to the second electrical path EP2. For example, when the foldable electronic device 2 is in the unfolded state, the matching circuit 630 may adjust the inductance of the first exemplary antenna structure 600 such that the electromagnetic field 701 generated corresponding to the current path L1 including the first metal E1 and the electromagnetic field 702 generated corresponding to the second current path L2 including the seventh metal E7 at the time of positive feeding to the first electrical path EP1 and negative feeding to the second electrical path EP2 can have an inductance value of about 8 to 10 microhenry for about 13.56 MHz for NFC. For example, when the foldable electronic device 2 is in the folded state, the matching circuit 630 may adjust the inductance of the first exemplary antenna structure 600 such that the electromagnetic field generated from the coil formed by the combination of the first turn of the first current path and the second turn of the second current path at the time of positive feeding to the first electrical path EP1 and negative feeding to the second electrical path EP2 can have a resonance frequency of about 13.56 MHz for NFC.

According to an embodiment, the matching circuit 630 may provide (or form) impedance matching. At the time of positive feeding to the first electrical path EP1 and negative feeding to the second electrical path EP2, the matching circuit 630 may reduce transmission loss through impedance matching.

According to an embodiment, the first filter 640 may be disposed on the first electrical path EP1 or electrically connected to the first electrical path EP1. The wireless communication circuit 610 may be electrically connected to the first metal E1 through, for example, the first filter 640. When the first metal E1 is used as an antenna radiator in a non-NFC band (referred to as a non-NFC frequency band) such as LB, MB, HB, or UHB, the first filter 640 may reduce the influence of the first exemplary structure 600 on the non-NFC band (e.g., electromagnetic interference). For example, when the first metal E1 is used as an antenna radiator in a non-NFC band such as LB, MB, HB, or UHB, the first filter 640 may reduce or prevent the occurrence of resonance in the NFC band (or an NFC frequency band).

According to an embodiment, the first filter 640 may be provided as at least one filter (also referred to as a filter circuit), at least one switch (also referred to as a switch circuit), or a combination thereof.

According to an embodiment, the first filter 640 may include a diplex or a duplexer capable of transmitting each of an NFC band and a non-NFC band separately.

According to an embodiment, the second filter 650 may be disposed on the second electrical path EP2 or electrically connected to the second electrical path EP2. The wireless communication circuit 610 may be electrically connected to the seventh metal E7 through, for example, the second filter 650. When the seventh metal E7 is used as an antenna radiator in a non-NFC band such as LB, MB, HB, or UHB, the second filter 650 may reduce the influence of the first exemplary structure 600 on the non-NFC band (e.g., electromagnetic interference). For example, when the seventh metal E7 is used as an antenna radiator in a non-NFC band such as LB, MB, HB, or UHB, the second filter 650 may reduce or prevent the occurrence of resonance in the NFC band.

According to an embodiment, the second filter 650 may be provided as at least one filter (also referred to as a filter circuit), at least one switch (also referred to as a switch circuit), or a combination thereof.

According to an embodiment, the second filter 650 may include a diplex or a duplexer capable of transmitting each of an NFC band and a non-NFC band separately.

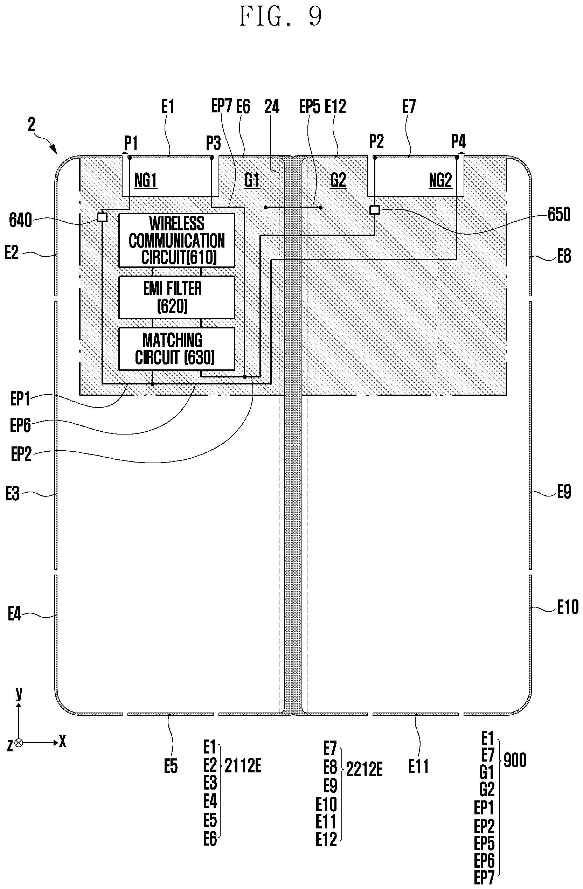

The embodiment of FIG. 6 discloses that the first metal E1 and the seventh metal E7 are connected in series to the wireless communication circuit 610, but the disclosure is not limited thereto. The first metal E1 and the seventh metal E7 may be implemented to be connected in parallel to the wireless communication circuit 610. For example, the case where the first metal E1 and the seventh metal E7 are connected in parallel to the wireless communication circuit 610 will be described with reference to FIG. 9,

FIG. 9 is a view illustrating the foldable electronic device 2 according to an embodiment of the disclosure in the unfolded state. It is to be understood that the disclosure conceives and includes all of the combinations of features and/or embodiments disclosed with reference to FIG. 9. That is, all of the combinations of features described below with reference to FIG. 9 are to be considered as being included in the disclosure as specific examples.

Referring to FIG. 9, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first electrical path EP1, a second electrical path EP2, a fifth electrical path EP5, a sixth electrical path EP6, a seventh electrical path EP7, a wireless communication circuit 610, an EMI filter 620, a matching circuit 630, a first filter 640, and/or a second filter 650. Descriptions of some components of FIG. 9 that are indicated by the same reference numerals as those illustrated in FIG. 6 will be omitted.

According to an embodiment, a second exemplary antenna structure 900 included in the foldable electronic device 2 may include a first metal E1, a seventh metal E7, a first ground area G1, a second ground area G2, a first electrical path EP1, a second electrical path EP2, a fifth electrical path EP5, a sixth electrical path EP6, and/or a seventh electrical path EP7.

According to an embodiment, the sixth electrical path EP6 may electrically interconnect the first electrical path EP1 and the fourth point P4 of the seventh metal E7. The seventh metal E7 may be electrically connected to the first electrical path EP1 through the sixth electrical path EP6. The sixth electrical path EP6 may include a combination of one or more conductive paths (or, conductors or conductive structures) (not separately illustrated) between the first electrical path EP1 and the fourth point P4 of the seventh metal E7.

According to an embodiment, the sixth electrical path EP6 may extend from the first housing 21 (see FIG. 2) to the second housing 22 (see FIG. 2). The six electrical path EP6 may be disposed across the hinge portion 24.

According to an embodiment, the foldable electronic device 2 may include a first printed circuit board (not separately illustrated) disposed on the first support 2111 (see FIG. 4), a second printed circuit board (not separately illustrated) disposed on the second support 2211 (see FIG. 4), and a flexible printed circuit board (e.g., the flexible printed circuit board 2500 in FIG. 25) electrically interconnecting the first printed circuit board and the second printed circuit board. The flexible printed circuit board may be placed across the hinge portion 24. The sixth electrical path EP6 may include a fifth conductive line (e.g., a fifth wire) included in the first printed circuit board on which the wireless communication circuit 610 is disposed, a sixth conductive line included in the second printed circuit board (e.g., a sixth wire), and/or a seventh conductive line (e.g., a seventh wire) included in the flexible printed circuit board. The fifth conductive line may be electrically connected to the first electrical path EP1. The sixth conductive line may be electrically connected to the fourth point P4 of the seventh metal E7. The seventh conductive line may electrically interconnect the fifth conductive line and the sixth conductive line.

According to an embodiment, the seventh electrical path EP7 may electrically interconnect the second electrical path EP2 and the third point P3 of the first metal E1. The first metal E1 may be electrically connected to the second electrical path EP2 through the seventh electrical path EP7. The seventh electrical path EP7 may include a combination of one or more conductive paths (or, conductors or conductive structures) (not separately illustrated) between the second electrical path EP2 and the third point P3 of the first metal E1.

According to an embodiment, the seventh electrical path EP7 may be accommodated in the first housing 21 (see FIG. 2).

According to an embodiment, the seventh electrical path EP7 may include an eighth conductive line (e.g., an eighth conductive line) included in the first printed circuit board (not separately illustrated) disposed on the first support 2111 (see FIG. 4). The first printed circuit board may include a second conductive line (e.g., a second wire) included in the second electrical path EP2. The eighth conductive line may be electrically connected to the second conductive line.

According to an embodiment, the foldable electronic device 2 may include a flexible printed circuit (e.g., the flexible printed circuit board 2500 of FIG. 25) extending from the first housing 21 (see FIG. 2) to the second housing 22 (see FIG. 2) across the hinge portion 24. The flexible printed circuit board may include, for example, a conductive line included in the second electrical path EP2, a conductive line included in the fifth electrical path EP5, and/or a conductive line included in the sixth electrical path EP6. In various embodiments, the sixth electrical path EP6 may be included in a second printed circuit board (not separately illustrated) accommodated in the second housing 22, and may be electrically connected to the flexible printed circuit board.

According to an embodiment, the wireless communication circuit 610 may provide (or feed) a +voltage to the first electrical path EP1 and a -voltage to the second electrical path EP2. The +voltage may be provided to the first point P1 of the first metal E1 through the first electrical path EP1. The +voltage may be provided to the fourth point P4 of the second metal E2 through the sixth electrical path EP6. The - voltage may be provided to the second point P2 of the seventh metal E7 through the second electrical path EP2. The -voltage may be provided to the third point P3 of the first metal E1 through the seventh electrical path EP7.

According to an embodiment, at the time of positive feeding to the first electrical path EP1 and negative feeding to the second electrical path EP2, a first current flow corresponding to the first metal E1 and a second current flow corresponding to the seventh metal E7 may be provided (or formed). The first current flow may have a first current path (or first loop) in which a current (or radiation current) flows from the first electrical path EP1 to the seventh electrical path EP7 through the first metal E1. The second current flow may have a second current path (or second loop) in which a current (or radiation current) flows from the sixth electrical path EP6 to the second electrical path EP2 through the seventh metal E7.

According to an embodiment, the first current path and the distribution of current (or radiation current) along the first current path may form an electromagnetic field including electromagnetic force passing through the first non-ground area NG1 between the first metal E1 and the first ground area G1.

According to an embodiment, the second current path and the distribution of current along the second current path may form an electromagnetic field including electromagnetic force passing through the second non-ground area NG2 between the seventh metal E7 and the second ground area G2.

According to an embodiment, the wireless communication circuit 610 may be configured to transmit and receive a signal of a frequency band selected or predetermined through an electromagnetic field generated corresponding to the first current path including the first metal E1 and/or an electromagnetic field generated corresponding to the second current path including the seventh metal E7 at the time of positive feeding to the first electrical path EP1 and negative feeding to the second electrical path EP2.

According to an embodiment, the wireless communication circuit 610 may be configured to transmit and/or receive a signal of about 13.56 MHz for NFC through an electromagnetic field generated corresponding to the first current path including the first metal E1 and/or an electromagnetic field generated corresponding to the second current path including the seventh metal E7.

According to an embodiment, when the foldable electronic device 2 is in the folded state, the first current path (or first loop) including the first metal E1 and the second current path (or second loop) including the seventh metal E7 may provide (or form) a coil (or coil-shaped loop). The first current path may provide (or form) a first turn of the coil. The second current path may provide (or form) a second turn of the coil. At the time of positive feeding to the first electrical path EP1 and negative feeding to the second electrical path EP2, the coil formed by a combination of the first turn of the first current path and the second turn of the second current path when the foldable electronic device 2 is in the folded state may improve radiation performance by generating an electromagnetic field that is a composite of the electromagnetic field generated through the first current path and the electromagnetic field generated through the second current path.

According to an embodiment, at the time of positive feeding to the first electrical path EP1 and negative feeding to the second electrical path EP2, the current (or radiation current) may flow on the first metal E1 from the first point P1 to the third point P3, and may flow on the seventh metal E7 from the fourth point P4 to the second point P2. When the foldable electronic device 2 is in the folded state, the first metal E1 and the seventh metal E7 may be aligned with and overlap each other. At the time of positive feeding to the first electrical path EP1 and negative feeding to the second electrical path EP2 when the foldable electronic device 2 is in the folded state, the direction in which the current (or radiation current) flows on the first metal E1 from the first point P1 to the third point P3 and the direction in which the current flows on the seventh metal E7 from the fourth point P4 to the second point P2 may be substantially the same. When the currents are caused to flow in substantially the same direction on the first metal E1 and the seventh metal E7 which are aligned with and overlap each other when the foldable electronic device 2 is in the folded state, it is possible to improve radiation performance by generating an electromagnetic field with a relatively high intensity of electromagnetic force, compared to the case where the currents are caused to flow in opposite directions (e.g., reverse directions) on the first metal E1 and the seventh metal E7 which are aligned with and overlap each other when the foldable electronic device 2 is in the folded state.

According to various embodiments, although not separately illustrated, the first electrical path EP1 may be electrically connected to the third point P3, and the seventh electrical path EP7 may be electrically connected to the first point P1. Although not separately illustrated, the second electrical path EP2 may be electrically connected to the fourth point P4, and the sixth electrical path EP6 may be electrically connected to the second point P2. At the time of positive feeding to the first electrical path EP1 and negative feeding to the second electrical path EP2, the current (or radiation current) may flow on the first metal E1 from the third point P3 to the first point P1, and may flow on the seventh metal E7 from the second point P2 to the fourth point P4. At the time of positive feeding to the first electrical path EP1 and negative feeding to the second electrical path EP2 when the foldable electronic device 2 is in the folded state, the direction in which the current (or radiation current) flows on the first metal E1 from the third point P3 to the first point P1 and the direction in which the current flows on the seventh metal E7 from the second point P2 to the fourth P4 may be substantially the same. When the currents are caused to flow in substantially the same direction on the first metal E1 and the seventh metal E7 which are aligned with and overlap each other when the foldable electronic device 2 is in the folded state, it is possible to improve radiation performance by generating an electromagnetic field with a relatively high intensity of electromagnetic force, compared to the case where the currents are caused to flow in opposite directions (e.g., reverse directions) on the first metal E1 and the seventh metal E7 which are aligned with and overlap each other when the foldable electronic device 2 is in the folded state.

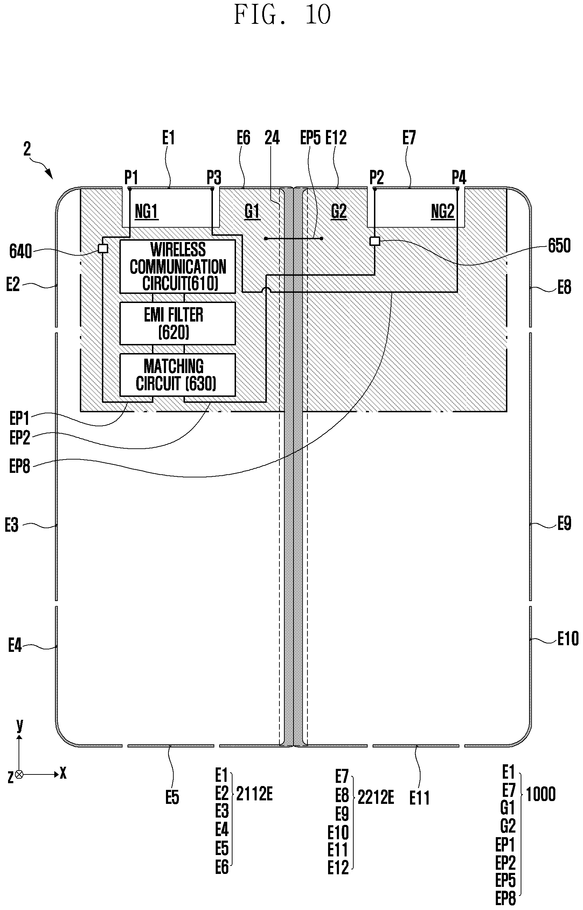

FIG. 10 is a view illustrating the foldable electronic device 2 according to an embodiment of the disclosure in an unfolded state. It is to be understood that the disclosure conceives and includes all of the combinations of features and/or embodiments disclosed with reference to FIG. 10. That is, all of the combinations of features described below with reference to FIG. 10 are to be considered as being included in the disclosure as specific examples.

Referring to FIG. 10, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first electrical path EP1, a second electrical path EP2, a fifth electrical path EP5, an eighth electrical path EP8, a wireless communication circuit 610, an EMI filter 620, a matching circuit 630, a first filter 640, and/or a second filter 650. Descriptions of some components of FIG. 9 that are indicated by the same reference numerals as those illustrated in FIG. 6 will be omitted.

According to an embodiment, a third exemplary antenna structure 1000 included in the foldable electronic device 2 may include a first metal E1, a seventh metal E7, a first ground area G1, a second ground area G2, a first electrical path EP1, a second electrical path EP2, a fifth electrical path EP5, and/or an eighth electrical path EP8.

According to an embodiment, the eighth electrical path EP8 may electrically interconnect the first metal E1 and the seventh metal E7. The third electrical path EP8 may include a combination of one or more conductive paths (or, conductors or conductive structures) (not separately illustrated) between the first metal E1 and the seventh metal E7.

According to an embodiment, the eighth electrical path EP8 may extend from the first housing 21 (see FIG. 2) to the second housing 22 (see FIG. 2). The eighth electrical path EP8 may be disposed across the hinge portion 24.

According to an embodiment, the foldable electronic device 2 may include a first printed circuit board (not separately illustrated) disposed on the first support 2111 (see FIG. 4), a second printed circuit board (not separately illustrated) disposed on the second support 2211 (see FIG. 4), and a flexible printed circuit board (e.g., the flexible printed circuit board 2500 in FIG. 25) electrically interconnecting the first printed circuit board and the second printed circuit board. The flexible printed circuit board may be placed across the hinge portion 24. The eighth electrical path EP8 may include a ninth conductive line (e.g., a ninth wire) included in the first printed circuit board on which the wireless communication circuit 610 is disposed, a tenth conductive line (e.g., a tenth wire) included in the second printed circuit board, an eleventh conductive line (e.g., an eleventh wire) included in the flexible printed circuit board, an electrical connection structure between the first metal E1 and the first printed circuit board, and/or an electrical connection structure between the seventh metal E7 and the second printed circuit board. The ninth conductive line may be electrically connected to the electrical connection structure between the first metal E1 and the first printed circuit board. The tenth conductive line may be electrically connected to the electrical connection structure between the seventh metal E7 and the second printed circuit board. The eleventh conductive line may electrically interconnect the ninth conductive line and the tenth conductive line. The electrical connection structure between the first metal E1 and the first printed circuit board may include, for example, a flexible conductor (or a flexible conductive portion or a conductive member) disposed between the first metal E1 and the first printed circuit board (e.g., a conductive clip, a pogo pin, a spring, conductive Poron, conductive rubber, conductive tape, or a conductive connector) (not separately illustrated). The electrical connection structure between the seventh metal E7 and the second printed circuit board may include, for example, a flexible conductor (or a flexible conductive portion or a conductive member) disposed between the seventh metal E7 and the second printed circuit board (e.g., a conductive clip, a pogo pin, a spring, conductive Poron, conductive rubber, conductive tape, or a conductive connector) (not separately illustrated).

According to an embodiment, one end of the eighth electrical path EP8 may be electrically connected to the third point P3 of the first metal E1, and the other end of the eighth electrical path EP8 may be electrically connected to the fourth point P4 of the seventh metal E7.

According to an embodiment, the foldable electronic device 2 may include a flexible printed circuit (e.g., the flexible printed circuit board 2500 of FIG. 25) extending from the first housing 21 (see FIG. 2) to the second housing 22 (see FIG. 2) across the hinge portion 24. The flexible printed circuit board may include, for example, a conductive line included in the second electrical path EP2, a conductive line included in the fifth electrical path EP5, and/or a conductive line included in the eighth electrical path EP8.

According to an embodiment, the wireless communication circuit 610 may provide (or feed) a +voltage to the first electrical path EP1 and a -voltage to the second electrical path EP2. The +voltage may be provided to the first point P1 of the first metal E1 through the first electrical path EP1. The -voltage may be provided to the second point P2 of the seventh metal E7 through the second electrical path EP2.

According to an embodiment, at the time of positive feeding to the first electrical path EP1 and negative feeding to the second electrical path EP2, a flow current in which current (or radiation current) flows from the first electrical path EP1 to the second electrical path EP2 through the first metal E1, the eighth electrical path EP8, and the seventh metal E7 may be provided (or formed). The current flow may include a first current flow corresponding to the first metal E1 and a second current flow corresponding to the seventh metal E7. The first current flow may have a first current path (or first loop) in which a current (or radiation current) flows from the first electrical path EP1 to the eighth electrical path EP8 through the first metal E1. The second current flow may have a second current path (or second loop) in which a current (or radiation current) flows from the eighth electrical path EP8 to the second electrical path EP2 through the seventh metal E7.

According to an embodiment, the first current path and the distribution of current (or radiation current) along the first current path may form an electromagnetic field including electromagnetic force passing through the first non-ground area NG1 between the first metal E1 and the first ground area G1.

According to an embodiment, the second current path and the distribution of current along the second current path may form an electromagnetic field including electromagnetic force passing through the second non-ground area NG2 between the seventh metal E7 and the second ground area G2.

According to an embodiment, the wireless communication circuit 610 may be configured to transmit and receive a signal of a frequency band selected or predetermined through an electromagnetic field generated corresponding to the first current path including the first metal E1 and/or an electromagnetic field generated corresponding to the second current path including the seventh metal E7 at the time of positive feeding to the first electrical path EP1 and negative feeding to the second electrical path EP2.

According to an embodiment, the wireless communication circuit 610 may be configured to transmit and/or receive a signal of about 13.56 MHz for NFC through an electromagnetic field generated corresponding to the first current path including the first metal E1 and/or an electromagnetic field generated corresponding to the second current path including the seventh metal E7.

According to an embodiment, when the foldable electronic device 2 is in the folded state, the first current path (or first loop) including the first metal E1 and the second current path (or second loop) including the seventh metal E7 may provide (or form) a coil (or coil-shaped loop). The first current path may provide (or form) a first turn of the coil. The second current path may provide (or form) a second turn of the coil. At the time of positive feeding to the first electrical path EP1 and negative feeding to the second electrical path EP2, the coil formed by a combination of the first turn of the first current path and the second turn of the second current path when the foldable electronic device 2 is in the folded state may improve radiation performance by generating an electromagnetic field that is a composite of the electromagnetic field generated through the first current path and the electromagnetic field generated through the second current path.

According to an embodiment, at the time of positive feeding to the first electrical path EP1 and negative feeding to the second electrical path EP2, the current (or radiation current) may flow on the first metal E1 from the first point P1 to the third point P3, and may flow on the seventh metal E7 from the fourth point P4 to the second point P2. When the foldable electronic device 2 is in the folded state, the first metal E1 and the seventh metal E7 may be aligned with and overlap each other. At the time of positive feeding to the first electrical path EP1 and negative feeding to the second electrical path EP2 when the foldable electronic device 2 is in the folded state, the direction in which the current (or radiation current) flows on the first metal E1 from the first point P1 to the third point P3 and the direction in which the current flows on the seventh metal E7 from the fourth point P4 to the second point P2 may be substantially the same. When the currents are caused to flow in the substantially same direction on the first metal E1 and the seventh metal E7 which are aligned with and overlap each other when the foldable electronic device 2 is in the folded state, it is possible to improve radiation performance by generating an electromagnetic field with a relatively high intensity of electromagnetic force, compared to the case where the currents are caused to flow in opposite directions (e.g., reverse directions) on the first metal E1 and the seventh metal E7 which are aligned with and overlap each other when the foldable electronic device 2 is in the folded state.

According to various embodiments, although not separately illustrated, the first electrical path EP1 may be electrically connected to the third point P3, and the eighth electrical path EP8 may be electrically connected to the first point P1. Although not separately illustrated, the second electrical path EP2 may be electrically connected to the fourth point P4, and the eighth electrical path EP8 may be electrically connected to the second point P2. At the time of positive feeding to the first electrical path EP1 and negative feeding to the second electrical path EP2, the current (or radiation current) may flow on the first metal E1 from the third point P3 to the first point P1, and may flow on the seventh metal E7 from the second point P2 to the fourth point P4. At the time of positive feeding to the first electrical path EP1 and negative feeding to the second electrical path EP2 when the foldable electronic device 2 is in the folded state, the direction in which the current (or radiation current) flows on the first metal E1 from the third point P3 to the first point P1 and the direction in which the current flows on the seventh metal E7 from the second point P2 to the fourth P4 may be substantially the same. When the currents are caused to flow in substantially the same direction in the first metal E1 and the seventh metal E7 which are aligned with and overlap each other when the foldable electronic device 2 is in the folded state, it is possible to improve radiation performance by generating an electromagnetic field with a relatively high intensity of electromagnetic force, compared to the case where the currents are caused to flow in opposite directions (e.g., reverse directions) on the first metal E1 and the seventh metal E7 which are aligned with and overlap each other when the foldable electronic device 2 is in the folded state.

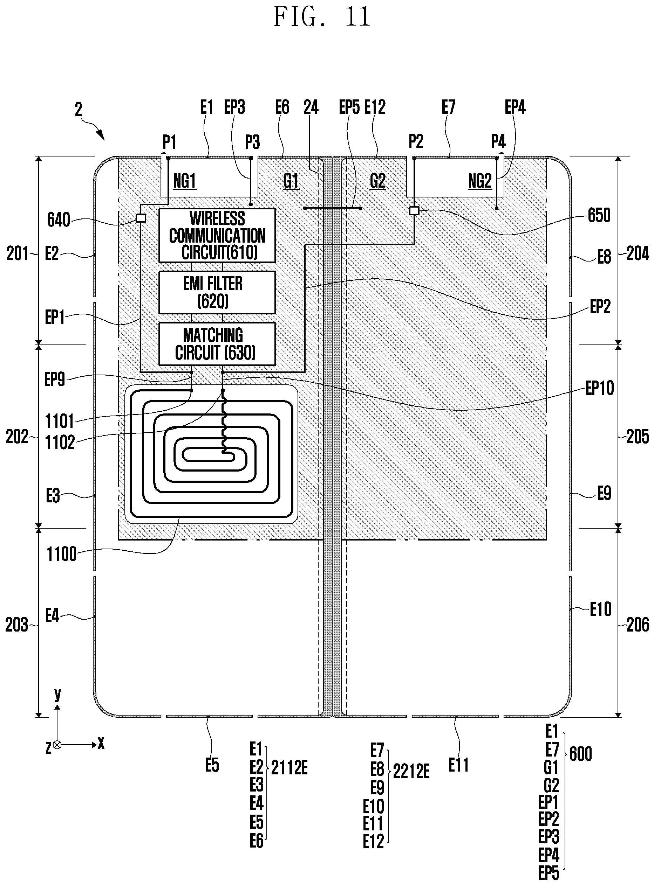

FIG. 11 is a view illustrating the foldable electronic device 2 according to an embodiment of the disclosure in an unfolded state. It is to be understood that the disclosure conceives and includes all of the combinations of features and/or embodiments disclosed with reference to FIG. 11. That is, all of the combinations of features described below with reference to FIG. 11 are to be considered as being included in the disclosure as specific examples.

Referring to FIG. 11, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first non-ground area NG1, a second non-ground area NG2, a first electrical path EP1, a second electrical path EP2, a third electrical path EP3, a fourth electrical path EP4, a fifth electrical path EP5, a wireless communication circuit 610, an EMI filter 620, a matching circuit 630, a first filter 640, a second filter 650, a spiral conductive pattern 1100, a ninth electrical path EP9, and/or a tenth electrical path EP10. The first exemplary antenna structure 600 may include a first metal E1, a seventh metal E7, a first ground area G1, a second ground area G2, a first electrical path EP1, a second electrical path EP2, a third electrical path EP3, a fourth electrical path EP4, and/or a fifth electrical path EP5. The embodiment of FIG. 11 may further include a spiral conductive pattern 1100, a ninth electrical path EP9, and a tenth electrical path EP10, compared to the embodiment of FIG. 6. In FIG. 11, descriptions of some components that have the same reference numerals as those illustrated in FIG. 6 will be omitted.

According to an embodiment, the spiral conductive pattern 1100 may have a loop of a current path extending from a first end 1101 to a second end 1102. For example, the spiral conductive pattern 1100 may include a plane-shaped coil (e.g., a planar coil or a pattern coil) including a plurality of turns.

According to an embodiment, the spiral conductive pattern 1100 may be implemented with a flexible printed circuit board (not separately illustrated).

According to an embodiment, the spiral conductive pattern 1100 may be accommodated in the first housing 21 (see FIG. 2). The spiral conductive pattern 1100 may be accommodated in the first housing 21 (see FIG. 2) to correspond to the first rear surface area of the foldable electronic device 2. The spiral conductive pattern 1100 may be located, for example, between the first cover 212 (see FIG. 2) and the first support 2111 (see FIG. 4).

According to an embodiment, the first end 1101 of the spiral conductive pattern 1100 may be electrically connected to the first electrical path EP1 through the ninth electrical path EP9. The second end 1102 of the spiral conductive pattern 1100 may be electrically connected to the second electrical path EP2 through the tenth electrical path EP10.

According to an embodiment, the foldable electronic device 2 may include a first printed circuit board (not separately illustrated) disposed on the first support 2111 (see FIG. 4). For example, the ninth electrical path EP9 may include a twelfth conductive line included in the first printed circuit board. One end of the twelfth conductive line may be electrically connected to the first end 1101 of the spiral conductive pattern 1100, and the other end of the twelfth conductive line may be electrically connected to the first electrical path EP1. For example, the tenth electrical path EP10 may include a thirteenth conductive line included in the first printed circuit board. One end of the thirteenth conductive line may be electrically connected to the second end 1102 of the spiral conductive pattern 1100, and the other end of the thirteenth conductive line may be electrically connected to the second electrical path EP2.

According to an embodiment, the wireless communication circuit 610 may provide (or feed) a +voltage to the first electrical path EP1 and a -voltage to the second electrical path EP2. The +voltage may be provided to the first point P1 of the first metal E1 through the first electrical path EP1. The +voltage may be provided to the first end 1101 of the spiral conductive pattern 1100 through the ninth electrical path EP9. The -voltage may be provided to the second point P2 of the seventh metal E7 through the second electrical path EP2. The -voltage may be provided to the second end 1102 of the spiral conductive pattern 1100 through the tenth electrical path EP10.

According to an embodiment, at the time of positive feeding to the first electrical path EP1 and negative feeding to the second electrical path EP2, the embodiment of FIG. 11 may further provide an electromagnetic field generated due to a third current path in which current (or radiation current) flows along the spiral conductive pattern 1100 and a distribution of current (or radiation current) along the third current path, compared to the embodiment of FIG. 6. The wireless communication circuit 610 may be configured to transmit and/or receive a signal in a frequency band (e.g., about 13.56 MHz for NFC) selected or predetermined through an electromagnetic field generated through the spiral conductive pattern 1100.

According to an embodiment, the spiral conductive pattern 1100 may overlap the second area 202 of the first rear surface area of the foldable electronic device 2 when viewed from above. At the time of positive feeding to the first electrical path EP1 and negative feeding to the second electrical path EP2, the electromagnetic field generated by the spiral conductive pattern 1100 may be radiated through the second area 202.

According to various embodiments, although not separately illustrated, the spiral conductive pattern 1100 may be accommodated in the first housing 21 (see FIG. 2) to overlap the third area 203 of the first rear surface area of the foldable electronic device 2 when viewed from above the first rear surface area of the foldable electronic device 2. At the time of positive feeding to the first electrical path EP1 and negative feeding to the second electrical path EP2, the electromagnetic field generated by the spiral conductive pattern 1100 may be radiated through the third area 203.

According to various embodiments, although not separately illustrated, the spiral conductive pattern 1100 may be accommodated in the second housing 22 (see FIG. 2) to overlap the fifth area 205 of the second rear surface area of the foldable electronic device 2 when viewed from above the second rear surface area of the foldable electronic device 2. At the time of positive feeding to the first electrical path EP1 and negative feeding to the second electrical path EP2, the electromagnetic field generated by the spiral conductive pattern 1100 may be radiated through the fifth area 205.

According to various embodiments, although not separately illustrated, the spiral conductive pattern 1100 may be accommodated in the second housing 22 (see FIG. 2) to overlap the sixth area 206 of the second rear surface area of the foldable electronic device 2 when viewed from above the second rear surface area of the foldable electronic device 2. At the time of positive feeding to the first electrical path EP1 and negative feeding to the second electrical path EP2, the electromagnetic field generated by the spiral conductive pattern 1100 may be radiated through the sixth area 206.

According to an embodiment, at the time of positive feeding to the first electrical path EP1 and negative feeding to the second electrical path EP2, the electromagnetic field generated corresponding to the first current path L1 (see FIG. 7) including the first metal E1 may be radiated through the first area 201 of the first rear surface area of the foldable electronic device 2, and the electromagnetic field generated corresponding to the second current path L2 (see FIG. 7) including the seventh metal E7 may be radiated through the fourth area 204 of the second rear surface area of the foldable electronic device 2. For example, compared to the second area 202 and the third area 203 of the first rear surface area, the first area 201 of the first rear surface area may be less likely to be included in a grip position of a user's hand for the foldable electronic device 2 in the unfolded or folded state. For example, compared to the second area 205 and the sixth area 206 of the second rear surface area, the fourth area 204 of the second rear surface area may be less likely to be included in a grip position of a user's hand for the foldable electronic device 2 in the unfolded or folded state. Even when the grip position of a user's hand for the foldable electronic device 2 in the unfolded or folded state overlaps the spiral conductive pattern 1100, radiation can be ensured by causing the electromagnetic field generated corresponding to the first current path L1 (see FIG. 7) including the first metal E1 to be radiated through the first area 201 and/or causing the electromagnetic field generated corresponding to the second current path L2 (see FIG. 7) including the seventh metal E7 to be radiated through the fourth area 204.

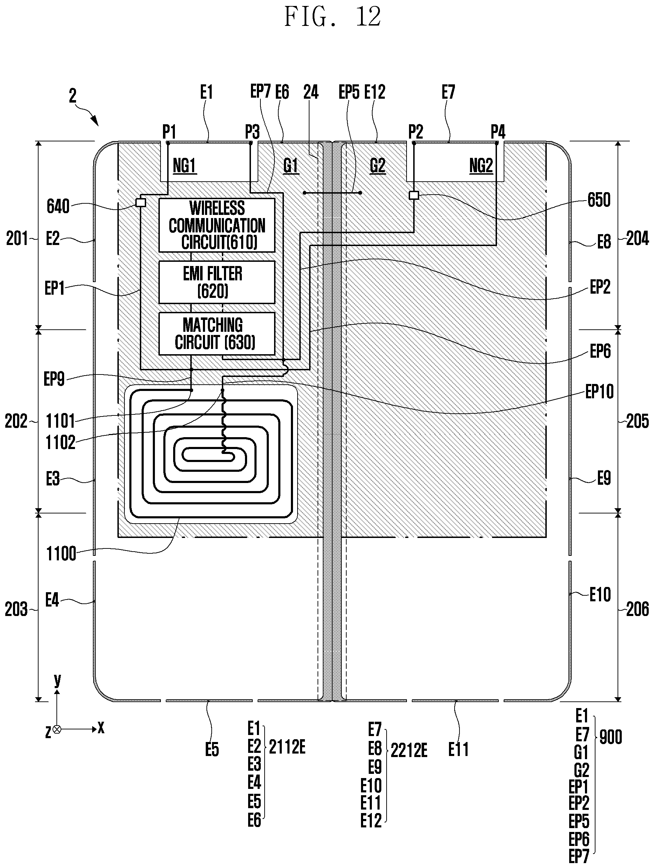

FIG. 12 is a view illustrating the foldable electronic device 2 according to an embodiment of the disclosure in the unfolded state. It is to be understood that the disclosure conceives and includes all of the combinations of features and/or embodiments disclosed with reference to FIG. 12. That is, all of the combinations of features described below with reference to FIG. 12 are to be considered as being included in the disclosure as specific examples.

Referring to FIG. 12, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first electrical path EP1, a second electrical path EP2, a fifth electrical path EP5, a sixth electrical path EP6, a seventh electrical path EP7, a wireless communication circuit 610, an EMI filter 620, a matching circuit 630, a first filter 640, a second filter 650, a spiral conductive pattern 1100, a ninth electrical path EP9, and/or a tenth electrical path EP10. The second exemplary antenna structure 900 may include a first metal E1, a seventh metal E7, a first ground area G1, a second ground area G2, a first electrical path EP1, a second electrical path EP2, a fifth electrical path EP5, a sixth electrical path EP6, and/or a seventh electrical path EP7. The embodiment of FIG. 12 may further include a spiral conductive pattern 1100, a ninth electrical path EP9, and a tenth electrical path EP10, compared to the embodiment of FIG. 9. Descriptions of some components of FIG. 12 that are indicated by the same reference numerals as those illustrated in FIG. 9 and/or FIG. 11 will be omitted.

According to an embodiment, the first end 1101 of the spiral conductive pattern 1100 may be electrically connected to the first electrical path EP1 through the ninth electrical path EP9. The second end 1102 of the spiral conductive pattern 1100 may be electrically connected to the second electrical path EP2 through the tenth electrical path EP10.

According to an embodiment, the wireless communication circuit 610 may provide (or feed) a +voltage to the first electrical path EP1 and a -voltage to the second electrical path EP2. The +voltage may be provided to the first point P1 of the first metal E1 through the first electrical path EP1. The +voltage may be provided to the fourth point P4 of the seventh metal E7 through the sixth electrical path EP6. The +voltage may be provided to the first end 1101 of the spiral conductive pattern 1100 through the ninth electrical path EP9. The -voltage may be provided to the second point P2 of the seventh metal E7 through the second electrical path EP2. The - voltage may be provided to the third point P3 of the first metal E1 through the seventh electrical path EP7. The -voltage may be provided to the second end 1102 of the spiral conductive pattern 1100 through the tenth electrical path EP10.

According to an embodiment, at the time of positive feeding to the first electrical path EP1 and negative feeding to the second electrical path EP2, the embodiment of FIG. 12 may further provide an electromagnetic field generated due to a third current path in which current (or radiation current) flows along the spiral conductive pattern 1100 and a distribution of current (or radiation current) along the third current path, compared to the embodiment of FIG. 9. The wireless communication circuit 610 may be configured to transmit and/or receive a signal in a frequency band (e.g., about 13.56 MHz for NFC) selected or predetermined through an electromagnetic field generated through the spiral conductive pattern 1100.

According to an embodiment, the spiral conductive pattern 1100 may overlap the second area 202 of the first rear surface area of the foldable electronic device 2 when viewed from above. At the time of positive feeding to the first electrical path EP1 and negative feeding to the second electrical path EP2, the electromagnetic field generated by the spiral conductive pattern 1100 may be radiated through the second area 202.

According to various embodiments, although not separately illustrated, the spiral conductive pattern 1100 may be accommodated in the first housing 21 (see FIG. 2) to overlap the third area 203 of the first rear surface area of the foldable electronic device 2 when viewed from above the first rear surface area of the foldable electronic device 2. At the time of positive feeding to the first electrical path EP1 and negative feeding to the second electrical path EP2, the electromagnetic field generated by the spiral conductive pattern 1100 may be radiated through the third area 203.

According to various embodiments, although not separately illustrated, the spiral conductive pattern 1100 may be accommodated in the second housing 22 (see FIG. 2) to overlap the fifth area 205 of the second rear surface area of the foldable electronic device 2 when viewed from above the second rear surface area of the foldable electronic device 2. At the time of positive feeding to the first electrical path EP1 and negative feeding to the second electrical path EP2, the electromagnetic field generated by the spiral conductive pattern 1100 may be radiated through the fifth area 205.

According to various embodiments, although not separately illustrated, the spiral conductive pattern 1100 may be accommodated in the second housing 22 (see FIG. 2) to overlap the sixth area 206 of the second rear surface area of the foldable electronic device 2 when viewed from above the second rear surface area of the foldable electronic device 2. At the time of positive feeding to the first electrical path EP1 and negative feeding to the second electrical path EP2, the electromagnetic field generated by the spiral conductive pattern 1100 may be radiated through the sixth area 206.

According to an embodiment, at the time of positive feeding to the first electrical path EP1 and negative feeding to the second electrical path EP2, the electromagnetic field generated corresponding to the first current path including the first metal E1 may be radiated through the first area 201 of the first rear surface area of the foldable electronic device 2, and the electromagnetic field generated corresponding to the second current path including the seventh metal E7 may be radiated through the fourth area 204 of the second rear surface area of the foldable electronic device 2. For example, compared to the second area 202 and the third area 203 of the first rear surface area, the first area 201 of the first rear surface area may be less likely to be included in a grip position of a user's hand for the foldable electronic device 2 in the unfolded or folded state. For example, compared to the second area 205 and the sixth area 206 of the second rear surface area, the fourth area 204 of the second rear surface area may be less likely to be included in a grip position of a user's hand for the foldable electronic device 2 in the unfolded or folded state. Even when the grip position of a user's hand for the foldable electronic device 2 in the unfolded or folded state overlaps the spiral conductive pattern 1100, radiation can be ensured by causing the electromagnetic field generated corresponding to the first current path including the first metal E1 to be radiated through the first area 201 and/or causing the electromagnetic field generated corresponding to the second current path including the seventh metal E7 to be radiated through the fourth area 204.

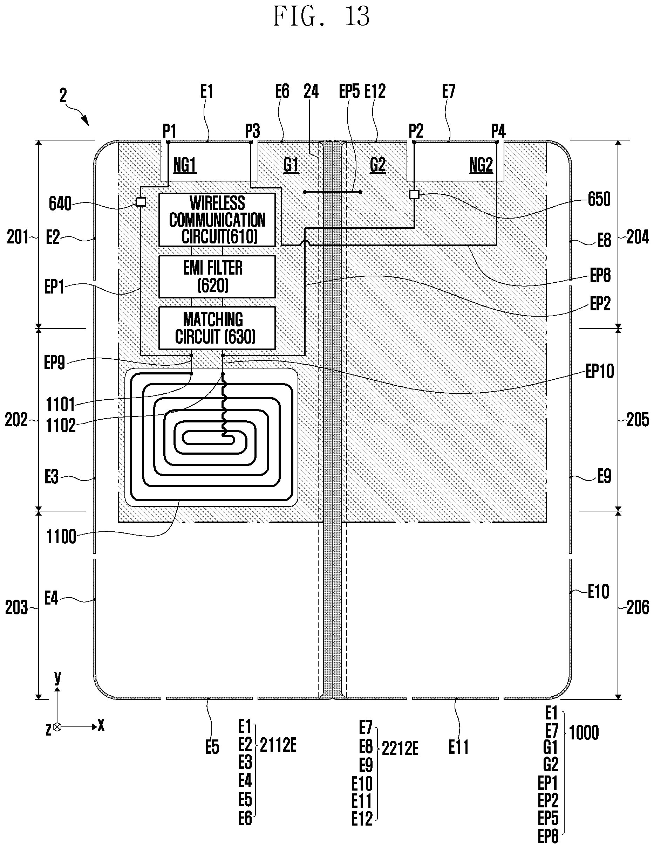

FIG. 13 is a view illustrating the foldable electronic device 2 according to an embodiment of the disclosure in an unfolded state. It is to be understood that the disclosure conceives and includes all of the combinations of features and/or embodiments disclosed with reference to FIG. 13. That is, all of the combinations of features described below with reference to FIG. 13 are to be considered as being included in the disclosure as specific examples.

Referring to FIG. 13, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first electrical path EP1, a second electrical path EP2, a fifth electrical path EP5, an eighth electrical path EP8, a wireless communication circuit 610, an EMI filter 620, a matching circuit 630, a first filter 640, a second filter 650, a spiral conductive pattern 1100, a ninth electrical path EP9, and/or a tenth electrical path EP10. The third exemplary antenna structure 1000 may include a first metal E1, a seventh metal E7, a first ground area G1, a second ground area G2, a first electrical path EP1, a second electrical path EP2, a fifth electrical path EP5, and/or an eight electrical path EP8. The embodiment of FIG. 13 may further include a spiral conductive pattern 1100, a ninth electrical path EP9, and a tenth electrical path EP 10, compared to the embodiment of FIG. 10. Descriptions of some components of FIG. 13 that are indicated by the same reference numerals as those illustrated in FIG. 10 and/or FIG. 11 will be omitted.

According to an embodiment, the first end 1101 of the spiral conductive pattern 1100 may be electrically connected to the first electrical path EP1 through the ninth electrical path EP9. The second end 1102 of the spiral conductive pattern 1100 may be electrically connected to the second electrical path EP2 through the tenth electrical path EP10.

According to an embodiment, the wireless communication circuit 610 may provide (or feed) a +voltage to the first electrical path EP1 and a -voltage to the second electrical path EP2. The +voltage may be provided to the first point P1 of the first metal E1 through the first electrical path EP1. The +voltage may be provided to the first end 1101 of the spiral conductive pattern 1100 through the ninth electrical path EP9. The -voltage may be provided to the second point P2 of the seventh metal E7 through the second electrical path EP2. The -voltage may be provided to the second end 1102 of the spiral conductive pattern 1100 through the tenth electrical path EP10.

According to an embodiment, at the time of positive feeding to the first electrical path EP1 and negative feeding to the second electrical path EP2, the embodiment of FIG. 13 may further provide an electromagnetic field generated due to a third current path in which current (or radiation current) flows along the spiral conductive pattern 1100 and a distribution of current (or radiation current) along the third current path, compared to the embodiment of FIG. 10. The wireless communication circuit 610 may be configured to transmit and/or receive a signal in a frequency band (e.g., about 13.56 MHz for NFC) selected or predetermined through an electromagnetic field generated through the spiral conductive pattern 1100.

According to an embodiment, the spiral conductive pattern 1100 may overlap the second area 202 of the first rear surface area of the foldable electronic device 2 when viewed from above. At the time of positive feeding to the first electrical path EP1 and negative feeding to the second electrical path EP2, the electromagnetic field generated by the spiral conductive pattern 1100 may be radiated through the second area 202.

According to various embodiments, although not separately illustrated, the spiral conductive pattern 1100 may be accommodated in the first housing 21 (see FIG. 2) to overlap the third area 203 of the first rear surface area of the foldable electronic device 2 when viewed from above the first rear surface area of the foldable electronic device 2. At the time of positive feeding to the first electrical path EP1 and negative feeding to the second electrical path EP2, the electromagnetic field generated by the spiral conductive pattern 1100 may be radiated through the third area 203.

According to various embodiments, although not separately illustrated, the spiral conductive pattern 1100 may be accommodated in the second housing 22 (see FIG. 2) to overlap the fifth area 205 of the second rear surface area of the foldable electronic device 2 when viewed from above the second rear surface area of the foldable electronic device 2. At the time of positive feeding to the first electrical path EP1 and negative feeding to the second electrical path EP2, the electromagnetic field generated by the spiral conductive pattern 1100 may be radiated through the fifth area 205.

According to various embodiments, although not separately illustrated, the spiral conductive pattern 1100 may be accommodated in the second housing 22 (see FIG. 2) to overlap the sixth area 206 of the second rear surface area of the foldable electronic device 2 when viewed from above the second rear surface area of the foldable electronic device 2. At the time of positive feeding to the first electrical path EP1 and negative feeding to the second electrical path EP2, the electromagnetic field generated by the spiral conductive pattern 1100 may be radiated through the sixth area 206.

According to an embodiment, at the time of positive feeding to the first electrical path EP1 and negative feeding to the second electrical path EP2, the electromagnetic field generated corresponding to the first current path including the first metal E1 may be radiated through the first area 201 of the first rear surface area of the foldable electronic device 2, and the electromagnetic field generated corresponding to the second current path including the seventh metal E7 may be radiated through the fourth area 204 of the second rear surface area of the foldable electronic device 2. For example, compared to the second area 202 and the third area 203 of the first rear surface area, the first area 201 of the first rear surface area may be less likely to be included in a grip position of a user's hand for the foldable electronic device 2 in the unfolded or folded state. For example, compared to the second area 205 and the sixth area 206 of the second rear surface area, the fourth area 204 of the second rear surface area may be less likely to be included in a grip position of a user's hand for the foldable electronic device 2 in the unfolded or folded state. Even when the grip position of a user's hand for the foldable electronic device 2 in the unfolded or folded state overlaps the spiral conductive pattern 1100, radiation can be ensured by causing the electromagnetic field generated corresponding to the first current path including the first metal E1 to be radiated through the first area 201 and/or causing the electromagnetic field generated corresponding to the second current path including the seventh metal E7 to be radiated through the fourth area 204.

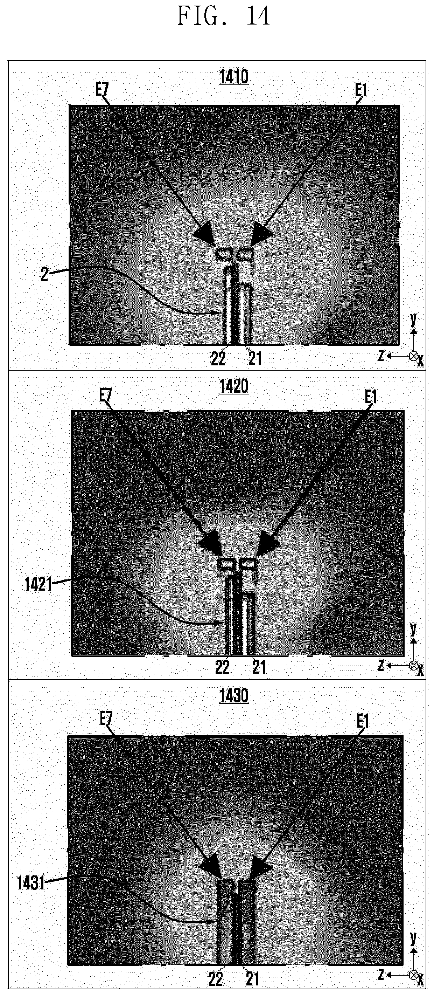

FIG. 14 is a view illustrating a heat map 1410 illustrating a magnetic field distribution at the time of feeding when a foldable electronic device 2 according to an embodiment of the disclosure is in the folded state, a heat map 1420 illustrating a magnetic field distribution at the time of feeding when a foldable electronic device 1421 of a first comparative example is in the folded state, and a heat map 1430 illustrating a magnetic field distribution at the time of feeding when a foldable electronic device 1431 of a second comparative example is in the folded state.

The foldable electronic device 2 according to an embodiment of the disclosure may be implemented according to the embodiment of FIG. 6, 9, or 10. Compared to the foldable electronic device 2 of FIG. 6 according to the disclosure, in the foldable electronic device 1421 of the first comparative example, the second electrical path EP2 may be electrically connected to the fourth point P4 of the seventh metal E7, and the fourth electrical path EP4 may be electrically connected to the second point P2 of the seventh metal E7. Compared to the foldable electronic device 2 of FIG. 9 according to the disclosure, in the foldable electronic device 1421 of the first comparative example, the second electrical path EP2 may be electrically connected to the fourth point P4 of the seventh metal E7, and the sixth electrical path EP6 may be electrically connected to the second point P2 of the seventh metal E7. Compared to the foldable electronic device 2 of FIG. 10 according to the disclosure, in the foldable electronic device 1421 of the first comparative example, the second electrical path EP2 may be electrically connected to the fourth point P4 of the seventh metal E7, and the eighth electrical path EP8 may be electrically connected to the second point P2 of the seventh metal E7. Compared to the foldable electronic device 2 of FIG. 6 according to the disclosure, in the foldable electronic device 1431 of the second comparative example, the first electrical path EP1 may be electrically connected to the third point P3 of the first metal E1, and the third electrical path EP3 may be electrically connected to the first point P1 of the first metal E1. Compared to the foldable electronic device 2 of FIG. 9 according to the disclosure, in the foldable electronic device 1431 of the second comparative example, the first electrical path EP1 may be electrically connected to the third point P3 of the first metal E1, and the seventh electrical path EP7 may be electrically connected to the first point P1 of the first metal E1. Compared to the foldable electronic device 2 of FIG. 10 according to the disclosure, in the foldable electronic device 1431 of the second comparative example, the first electrical path EP1 may be electrically connected to the third point P3 of the first metal E1, and the eighth electrical path EP8 may be electrically connected to the first point P1 of the first metal E1.

At the time of feeding when the electronic device 1421 of the first comparative example and the electronic device 1431 of the second comparative example are in the folded states, currents may flow in opposite directions (e.g., reverse directions) in the first metal E1 and the seventh metal E7 that are aligned with and overlap each other, causing destructive interference. Compared to the electronic device 1421 of the first comparative example and the electronic device 1431 of the second comparative example, the foldable electronic device 2 of FIG. 6, 9, or 10 according to the disclosure may have an improved magnetic field intensity and/or magnetic field distribution by causing the currents to flow in the same direction on the first metal E1 and the seventh metal E7 which are aligned with and overlap each other in the folded state.

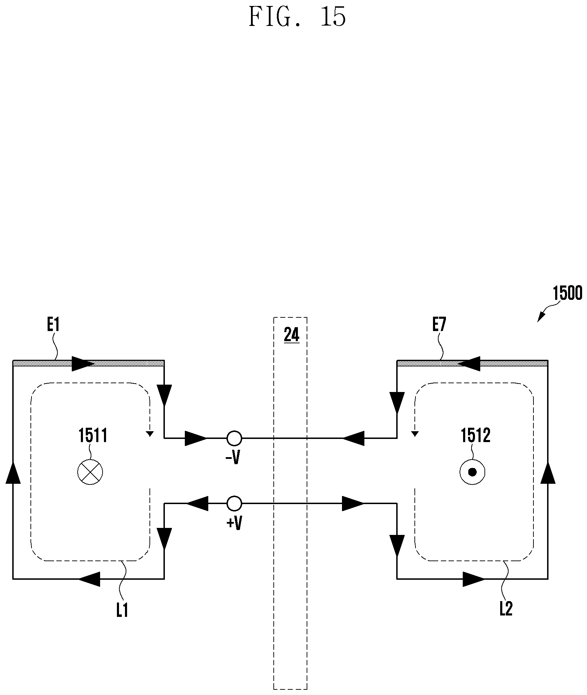

FIG. 15 is a circuit diagram of an antenna structure 1500 included in the foldable electronic device 2 according to an embodiment of the disclosure. It is to be understood that the disclosure conceives and includes all of the combinations of features and/or embodiments disclosed with reference to FIG. 15. That is, all of the combinations of features described below with reference to FIG. 15 are to be considered as being included in the disclosure as specific examples.

Referring to Figure 15, the antenna structure 1500 is a portion included in the first exemplary antenna structure 600 of FIG. 6 or 11 or the third exemplary antenna structure 1000 of FIG. 10 or 13, in which the first metal E1 and the seventh metal E7 may be connected in series to the wireless communication circuit 610.

According to an embodiment, the antenna structure 1500 may include a first current path (or first loop) L1 including the first metal E1, and a second current path (or second loop) L2 including the seven metal E7.

According to an embodiment, at the time of feeding when the foldable electronic device 2 is in the unfolded state, the flow of current in the first current path L1 may generate a first electromagnetic field (or first magnetic field distribution) 1511 (the first electromagnetic field 711 in FIG. 7), and the flow of current in the second current path L2 may generate a second electromagnetic field (or second magnetic field distribution) 1512.

According to an embodiment, at the time of feeding when the foldable electronic device 2 is in the unfolded state, the direction in which the current (or radiation current) flows in the first metal E1 and the direction in which the current (or radiation current) flows in the seventh metal E7 may be the same. When the foldable electronic device 2 is in the unfolded state, a coil including a first turn by the first current path L1 and a second turn by the second current path L2 may be formed. At the time of feeding, the coil formed by a combination of the first turn of the first current path L1 and the second turn of the second current path L2 when the foldable electronic device 2 is in the folded state may improve radiation performance by generating an electromagnetic field that is a composite of the electromagnetic field 1511 generated through the first current path L1 and the electromagnetic field 1512 generated through the second current path L2.

According to an embodiment, the portion interconnecting the first current path L1 and the second current path L2 (or the portion between the first current path L1 and the second current path L2) in the antenna structure 1500 may be provided (or formed) to be relatively narrow compared to the first current path L1 and the second current path L2. The portion interconnecting the first current path L1 and the second current path L2 in the antenna structure 1500 may be disposed across the hinge portion 24. In the antenna structure 1500, the portion interconnecting the first current path L1 and the second current path L2 may be included in, for example, an integrated or single flexible printed circuit board (e.g., the flexible printed circuit board 2500 in FIG. 25) extending from the first housing 21 (see FIG. 2) to the second housing 22 (see FIG. 2) across the hinge portion 24 (see FIG. 2). Due to the feature in which the portion interconnecting the first current path L1 and the second current path L2 in the antenna structure 1500 is collected into the integrated or single flexible printed circuit board, the portion interconnecting the first current path L1 and the second current path L2 in the antenna structure 1500 may be formed to be relatively narrow compared to the first current path L1 and the second current path L2. In the antenna structures 1500, the portion interconnecting the first current path L1 and the second current path L2 is narrower than the first current path L1 and the second current path L2 and may be referred to as a "concave structure".

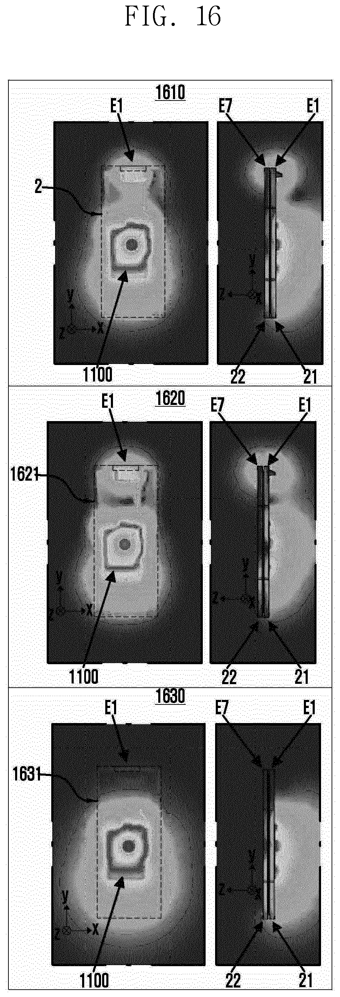

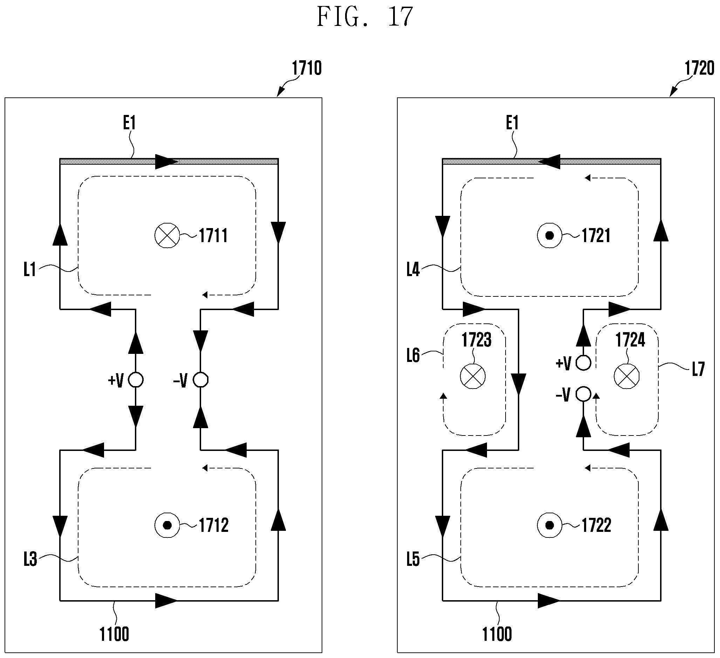

FIG. 16 is a view illustrating heat maps 1610 illustrating a magnetic field distribution at the time of feeding when a foldable electronic device 2 according to an embodiment of the disclosure is in the folded state, heat maps 1620 illustrating a magnetic field distribution at the time of feeding when a foldable electronic device 1621 of a third comparative example is in the folded state, and heat maps 1630 illustrating a magnetic field distribution at the time of feeding when a foldable electronic device 1631 of a fourth comparative example is in the folded state. FIG. 17 illustrates a circuit diagram of an antenna structure 1710 according to an embodiment of the disclosure and a circuit diagram of an antenna structure 1720 in a third comparative example.

The foldable electronic device 2 according to an embodiment of the disclosure may be implemented according to the embodiment of FIG. 11, 12, or 13. The antenna structure 1710 of FIG. 17 included in the foldable electronic device 2 according to the disclosure is included in the first exemplary antenna structure 600 of FIG. 11, the second exemplary antenna structure 900 of FIG. 12, or the thirteenth third exemplary antenna structure 1000 in FIG. 13, and the first metal E1 and the spiral conductive pattern 1100 may be connected in parallel to the wireless communication circuit 610. In the antenna structure 1720 included in the foldable electronic device 1621 of the third comparative example, the first metal E1 and the spiral conductive pattern 1100 may be connected in series to the wireless communication circuit 610. Compared to the foldable electronic device 2 according to the disclosure, the foldable electronic device 1731 of the fourth comparative example may not include the first exemplary antenna structure 600 of FIG. 11, the second exemplary antenna structure 900 of FIG. 12, or the third exemplary antenna structure 1000 of FIG. 13.

The antenna structure 1710 included in the foldable electronic device 2 according to an embodiment of the disclosure may include a first current path (or first loop) L1 including a first metal E1 and a third current path (or third loop) L3 including a spiral conductive pattern 1100. At the time of feeding, the flow of current in the first current path L1 may generate a first electromagnetic field (or first magnetic field distribution) 1711 (the first electromagnetic field 711 in FIG. 7), and the flow of current in the third current path L3 may generate a third electromagnetic field (or third magnetic field distribution) 1712. The direction in which a current (or radiation current) flows in the first metal E1 and the direction in which a current (or radiated) flows in the spiral conductive pattern 1000 may be substantially opposite to each other when viewed from a loop including the first current path L1 and the second current path L2.

The antenna structure 1720 of the foldable electronic device 1621 according to the third comparative example may include a fourth current path (or fourth loop) L4 including a first metal E1 and a fifth current path (or fifth loop) L5 including a spiral conductive pattern 1100. At the time of feeding, the flow of current in the fourth current path L4 may generate a fourth electromagnetic field (or fourth electromagnetic field) 1721, and the flow of current in the fourth current path L5 may generate a fifth electromagnetic field (or fifth magnetic field distribution) 1722. The direction in which a current (or radiation current) flows in the first metal E1 and the direction in which a current (or radiated) flows in the spiral conductive pattern 1000 may be substantially the same as each other when viewed from a loop including the fourth current path L4 and the fifth current path L5. The portion interconnecting the fourth current path L4 and the fifth current path L5 (or the portion between the first current path L4 and the second current path L5) in the antenna structure 1720 may be provided (or formed) in a concave structure that is relatively narrow compared to the fourth current path L4 and the fifth current path L5. The antenna structure 1720 of the third comparative example may generate a sixth electromagnetic field (or sixth magnetic field distribution) 1723 due to the current flow on the sixth current path L6 corresponding to the concave structure. The antenna structure 1720 of the third comparative example may generate a seventh electromagnetic field (or seventh magnetic field distribution) 1724 due to a current flow on the seventh current path L7 corresponding to the concave structure. The antenna structure 1720 according to the third comparative example may have a wide electromagnetic field distribution by including not only the fourth electromagnetic field 1721 and the fifth electromagnetic field 1722, but also the sixth electromagnetic field 1723 and the seventh electromagnetic field 1724. The electromagnetic field distribution of the antenna structure 1720 according to the third comparative example may provide a wide NFC recognition area for external electronic devices, while relatively reducing an NFC recognition distance with external electronic devices. The sixth electromagnetic field 1723 and the seventh electromagnetic field 1724 may be interpreted as electromagnetic field leakage that relatively weakens the fourth electromagnetic field 1721 and the fifth electromagnetic field 1722.

Compared to the antenna structure 1720 of the third comparative example, the antenna structure 1710 according to an embodiment of the disclosure may reduce electromagnetic field leakage corresponding to the concave structure (e.g., the portion interconnecting the first current path L1 and the third current path L3). The antenna structure 1710 according to an embodiment of the disclosure may improve the intensity or distribution of the first electromagnetic field 1711 and the third electromagnetic field 1712 compared to the antenna structure 1720 of the third comparative example. The antenna structure 1710 according to the disclosure may relatively improve an NFC recognition distance with an external electronic device compared to the antenna structure 1720 of the third comparative example.

Compared to the foldable electronic device 1631 of the fourth comparative example, the foldable electronic device 2 according to an embodiment of the disclosure may expand an electromagnetic field distribution by including the antenna structure 1710. Compared to the foldable electronic device 1631 of the fourth comparative example, the foldable electronic device 2 according to an embodiment of the disclosure may expand the NFC recognition area through the antenna structure 1710. For example, compared to the foldable electronic device 1631 of the fourth comparative example, radiation performance can be secured through the antenna structure 1710 even when a grip position of a user's hand for the foldable electronic device 2 in the unfolded or folded state overlaps the spiral conductive pattern 1100.

According to various embodiments, the embodiment of FIG. 6, 9, 10, 11, 12, or 13 may be configured to such that the wireless communication circuit 610 provides (or feeds) a +voltage to the second electrical path EP2 and provides (or feeds) a - voltage to the first electrical path EP1.

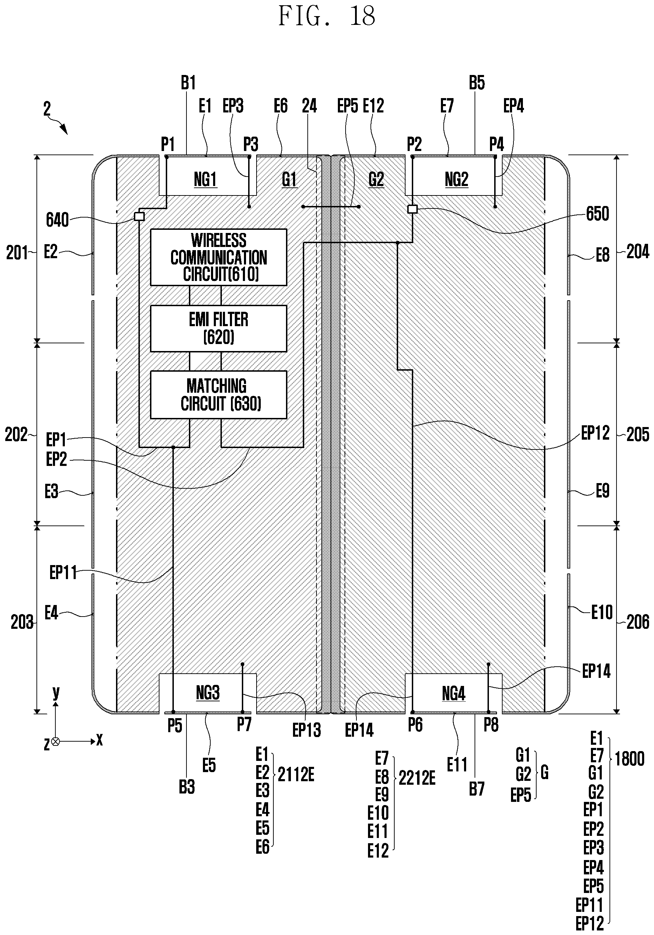

FIG. 18 is a view illustrating a foldable electronic device 2 according to an embodiment of the disclosure in an unfolded state. It is to be understood that the disclosure conceives and includes all of the combinations of features and/or embodiments disclosed with reference to FIG. 18. That is, all of the combinations of features described below with reference to FIG. 18 are to be considered as being included in the disclosure as specific examples.

Referring to FIG. 18, a foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first non-ground area NG1, a second non-ground area NG2, a third non-ground area NG3, a fourth non-ground area NG4, a first electrical path EP1, a second electrical path EP2, a third electrical path EP3, a fourth electrical path EP4, a fifth electrical path EP5, an eleventh electrical path E11, a twelfth electrical path E12, a thirteenth electrical path E13, a fourteenth electrical path E14, a wireless communication circuit 610, an EMI filter 620, a matching circuit 630, a first filter 640, and/or a second filter 650. A fourth exemplary antenna structure 1800 may include a first metal E1, a seventh metal E7, a fifth metal E5, an eleventh metal E11, a first ground area G1, a second ground area G2, a first electrical path EP1, a second electrical path EP2, a third electrical path EP3, a fourth electrical path EP4, a fifth electrical path EP5, an eleventh electrical path 11, a twelfth electrical path E12, a thirteenth electrical path E13, and/or a fourteenth electrical path E14. The embodiment of FIG. 18 may further include the eleventh electrical path EP 11 and the twelfth electrical path EP12 compared to the embodiment of FIG. 6. Descriptions of some components of FIG. 18 that are indicated by the same reference numerals as those illustrated in FIG. 6 will be omitted.

According to an embodiment, the eleventh electrical path E11 may electrically interconnect the first electrical path E1 and the fifth metal E5. A fifth point P5 on the fifth metal E5 may be electrically connected to the first electrical path E11. The eleventh electrical path E11 may be accommodated in the first housing 21 (see FIG. 2). The eleventh electrical path E11 may include a combination of one or more conductive paths (also referred to as conductors or conductive structures) (not illustrated separately) between the first electrical path E1 and the fifth metal E5.

According to an embodiment, the thirteenth electrical path E13 may electrically interconnect the fifth metal E5 and the first ground area G1. A seventh point P7 on the fifth metal E5 may be electrically connected to the thirteenth electrical path E13. The thirteenth electrical path E13 may be accommodated in the first housing 21 (see FIG. 2). The thirteenth electrical path E13 may include a combination of one or more conductive paths (also referred to as conductors or conductive structures) (not illustrated separately) between the fifth metal E5 and the first ground area G1.

According to an embodiment, the seventh point P7 on the fifth metal E5 may be located closer to the hinge portion 24 than the fifth point P5 on the fifth metal E5.

According to an embodiment, the twelfth electrical path E12 may electrically interconnect the first electrical path E2 and the fifth metal E11. A sixth point P6 on the eleventh metal E11 may be electrically connected to the twelfth electrical path E12. The twelfth electrical path E12 may be accommodated in the second housing 22 (see FIG. 2). The twelfth electrical path E12 may include a combination of one or more conductive paths (also referred to as conductors or conductive structures) (not illustrated separately) between the first electrical path E2 and the fifth metal E11.

According to an embodiment, the fourteenth electrical path E14 may electrically interconnect the eleventh metal E11 and the second ground area G2. The seventh point P7 on the eleventh metal E11 may be electrically connected to the fourteenth electrical path E14. The fourteenth electrical path E14 may be accommodated in the second housing 22 (see FIG. 2). The fourteenth electrical path E14 may include a combination of one or more conductive paths (also referred to as conductors or conductive structures) (not illustrated separately) between the eleventh metal E11 and the second ground area G2.

According to an embodiment, the sixth point P6 on the eleventh metal E1 1 may be located closer to the hinge portion 24 than the eighth point P8 on the eleventh metal E11.

According to an embodiment, the wireless communication circuit 610 may provide (or feed) a +voltage to the first electrical path EP1 and a -voltage to the second electrical path EP2. The +voltage may be provided to the first point P1 of the first metal E1 through the first electrical path EP1. The +voltage may be provided to the fifth point P5 of the fifth metal E5 through the eleventh electrical path EP11. The - voltage may be provided to the second point P2 of the seventh metal E7 through the second electrical path EP2. The -voltage may be provided to the sixth point P6 of the eleventh metal E11 through the twelfth electrical path EP12.

According to an embodiment, during positive feeding to the first electrical path EP1 and negative feeding to the second electrical path EP2, the embodiment of FIG. 18 may further provide an electromagnetic field generated due to a third current path on which current (or radiation current) flows along the fifth metal E5 and a distribution of current (or radiation current) along the third current path, compared to the embodiment of FIG. 6. During positive feeding to the first electrical path EP1 and negative feeding to the second electrical path EP2, the embodiment of FIG. 18 may further provide an electromagnetic field generated due to a fourth current path on which current (or radiation current) flows along the eleventh metal E11 and a distribution of current (or radiation current) along the fourth current path, compared to the embodiment of FIG. 6. The wireless communication circuit 610 may be configured to transmit and/or receive a signal of a selected or predetermined frequency band (e.g., about 13.56 MHz for NFC) through electromagnetic fields generated through the first metal E1, the fifth metal E5, the seventh metal E7, and the eleventh metal E11 when the foldable electronic device 2 is in the folded state.

According to an embodiment, when the foldable electronic device 2 is in the folded state, at the time of feeding, radiation currents may flow in the same direction on the first metal E1 and the fifth metal E5. According to an embodiment, when the foldable electronic device 2 is in the folded state, at the time of feeding, radiation currents may flow in the same direction on the fifth metal E5 and the eleventh metal E11. When the foldable electronic device 2 is in the folded state, at the time of feeding, radiation currents may flow in the same direction on the first metal E1 and the seventh metal E7 which are aligned with each other. When the foldable electronic device 2 is in the folded state, at the time of feeding, radiation currents may flow in the same direction on the fifth metal E5 and the eleventh metal E11 which are aligned with each other.

According to an embodiment, when the foldable electronic device 2 is in the folded state, at the time of feeding, the electromagnetic fields generated by the fifth metal E5 may be radiated through the third area 203. When the foldable electronic device 2 is in the folded state, at the time of feeing, the electromagnetic fields generated by the eleventh metal E11 may be radiated through the sixth area 206.

According to an embodiment, the third non-ground area NG3 may be located corresponding to the third edge B3. For example, the fifth metal E5 may be physically separated from the first ground area G1 with the third non-ground area NG3 interposed therebetween. For example, the third non-ground area NG3 may include a third opening in the form of a notch formed in the first ground area G1 to correspond to the fifth metal E5. The third non-ground area NG3 may include, for example, a non-conductive material disposed in the third opening.

According to an embodiment, the fourth non-ground area NG4 may be located corresponding to the seventh edge B7. For example, the eleventh metal E11 may be physically separated from the second ground area G2 with the fourth non-ground area NG4 interposed therebetween. For example, the fourth non-ground area NG4 may include a fourth opening in the form of a notch formed in the second ground area G2 to correspond to the eleventh metal E11. The fourth non-ground area NG4 may include, for example, a non-conductive material disposed in the fourth opening.

According to an embodiment, when the foldable electronic device 2 in the folded state, the third non-ground area NG3 and the fourth non-ground area NG4 may be aligned with and overlap each other. When the foldable electronic device 2 in the folded state, at the time of feeding, the electromagnetic force of the electromagnetic fields radiated through the fifth metal E5 and the electromagnetic force of the electromagnetic fields radiated through the eleventh metal E11 may pass through the third non-ground area NG3 and the fourth non-ground area NG4. The third non-ground area NG3 may prevent magnetic fluxes from being reduced by the first ground area G1, and the fourth non-ground area NG4 may prevent magnetic fluxes from being reduced by the second ground area G2, thereby reducing deterioration in the radiation performance of the fourth exemplary antenna structure 1800.

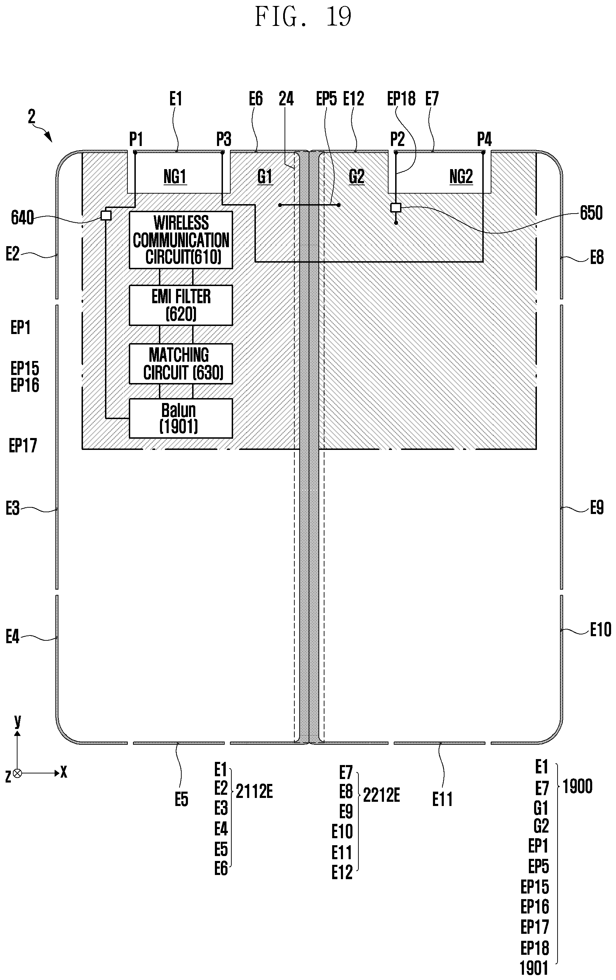

FIG. 19 is a view illustrating a foldable electronic device 2 according to an embodiment of the disclosure in an unfolded state. It is to be understood that the disclosure conceives and includes all of the combinations of features and/or embodiments disclosed with reference to FIG. 19. That is, all of the combinations of features described below with reference to FIG. 19 are to be considered as being included in the disclosure as specific examples.

Referring to FIG. 19, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first non-ground area NG1, a second non-ground area NG2, a first electrical path EP1, a fifth electrical path EP5, a fifteenth electrical path EP15, a sixteenth electrical path EP16, an eighteenth electrical path EP18, a balun 1901, a wireless communication circuit 610, an EMI filter 620, a matching circuit 630, a first filter 640, and/or a second filter 650. A fifth exemplary antenna structure 1900 may include a first metal E1, a seventh metal E7, a first ground area G1, a second ground area G2, a first electrical path EP1, a fifth electrical path EP5, a fifteenth electrical path EP15, a sixteenth electrical path EP16, a seventeenth electrical path EP17, an eighteenth electrical path EP18, and a balun 1901. Description of some components of FIG. 19 that have the same reference numerals as those described above with reference to the drawings will be omitted.

According to an embodiment, the balun 1901 may be accommodated in the first housing 21. The balun 1901 may be disposed on a printed circuit board (not illustrated separately) accommodated in the first housing 21.

According to an embodiment, a first point P1 of the first metal E1 may be electrically connected to the balun 1901 via the first electrical path EP1.

According to an embodiment, the first filter 640 may be disposed on the first electrical path EP1 or electrically connected to the first electrical path EP1.

According to an embodiment, the balun 1901 may be electrically connected to the wireless communication circuit 610 via the fifteenth electrical path EP15. The fifteenth electrical path EP15 may be accommodated in the first housing 21. The fifteenth electrical path EP15 may include a combination of one or more conductive paths (also referred to as conductors or conductive structures) (not illustrated separately) between the balun 1901 and the wireless communication circuit 610.

According to an embodiment, the balun 1901 may be electrically connected to the wireless communication circuit 610 via the sixteenth electrical path EP16. The sixteenth electrical path EP16 may be accommodated in the first housing 21. The sixteenth electrical path EP16 may include a combination of one or more conductive paths (also referred to as conductors or conductive structures) (not illustrated separately) between the balun 1901 and the wireless communication circuit 610.

According to an embodiment, the EMI filter 620 and the matching circuit 630 may be disposed on the fifteenth electrical path EP15 and/or the sixteenth electrical path EP16 or may be electrically connected to the fifteenth electrical path EP15 and/or the sixteenth electrical path EP16.

According to an embodiment, the seventeenth electrical path EP17 may electrically interconnect the third point P3 of the first metal E1 and the fourth point P4 of the seventh metal E7. The seventeenth electrical path EP17 may be disposed across the hinge portion 24. The seventeenth electrical path EP17 may include a combination (not illustrated separately) of one or more conductive paths (or, conductors or conductive structures) between the third point P3 of the first metal E1 and the fourth point P4 of the seventh metal E7.

According to an embodiment, the second point P2 of the seventh metal P7 may be electrically connected to the second ground area G2 via the eighteenth electrical path EP18. The eighteenth electrical path EP18 may include a combination of one or more conductive paths (also referred to as conductors or conductive structures) (not illustrated separately) between the second point P2 of the seventh metal P7 and the second ground area G2.

According to an embodiment, the second filter 640 may be disposed on the eighteenth electrical path EP18 or electrically connected to the eighteenth electrical path EP18. Although not illustrated separately, the second filter 640 may be disposed on the seventh electrical path EP17 or electrically connected to the seventeenth electrical path EP17.

According to an embodiment, the wireless communication circuit 610 may provide first power feeing (e.g., +voltage) to the fifteenth electrical path EP15 and second power feeding (e.g., -voltage) to the sixteenth electrical path EP16. The balun 1901 may transmit one of the first power feeding through the fifteenth electrical path EP15 and the second power feeding through the sixteenth electrical path EP16 to the first electrical path EP1. One selected by the balun from the first power feeing and the second power feeding may be provided to the first point P1 of the first metal E1 via the first electrical path EP1.

According to an embodiment, when the foldable electronic device 2 is in the folded state, at the time of feeding, radiation currents may flow on the first metal E1 and the seventh metal E7 due to the potential difference between the first point P1 of the first metal E1 electrically connected to the first electrical path EP1 and the second point P2 of the seventh metal E7 electrically connected to the second ground region G2 via the eighteenth electrical path EP18. When the foldable electronic device 2 is in the folded state, at the time of feeding, radiation currents may flow in the same direction on the first metal E1 and the seventh metal E7 which are aligned with each other. The wireless communication circuit 610 may be configured to transmit and/or receive a signal of a selected or predetermined frequency band (e.g., about 13.56 MHz for NFC) through electromagnetic fields generated through the first metal E1 and the seventh metal E7 when the foldable electronic device 2 is in the folded state.

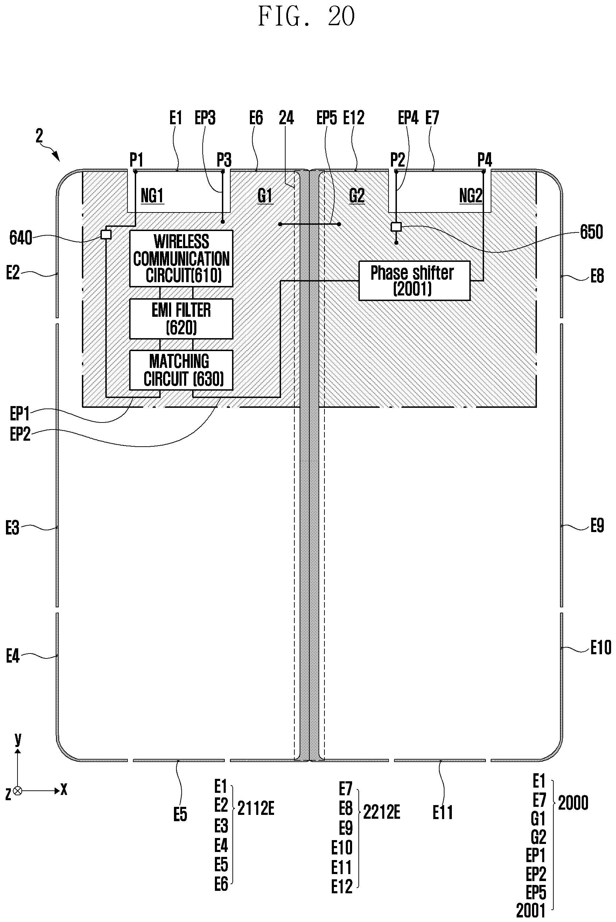

FIG. 20 is a view illustrating a foldable electronic device 2 according to an embodiment of the disclosure in an unfolded state. It is to be understood that the disclosure conceives and includes all of the combinations of features and/or embodiments disclosed with reference to FIG. 20. That is, all of the combinations of features described below with reference to FIG. 20 are to be considered as being included in the disclosure as specific examples.

Referring to FIG. 20, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first non-ground area NG1, a second non-ground area NG2, a first electrical path EP1, a second electrical path EP2, a third electrical path EP3, a fourth electrical path EP4, a fifth electrical path EP5, a phase shifter 2001, a wireless communication circuit 610, an EMI filter 620, a matching circuit 630, a first filter 640, and/or a second filter 650. A sixth exemplary antenna structure 2000 may include a first metal E1, a seventh metal E7, a first ground area G1, a second ground area G2, a first electrical path EP1, a second electrical path EP2, a third electrical path EP3, a fourth electrical path EP4, a fifth electrical path EP5, and a phase shifter 2001. Description of some components of FIG. 20 that have the same reference numerals as those described above with reference to the drawings will be omitted.

According to an embodiment, the first point P1 of the first metal E1 may be electrically connected to the wireless communication circuit 610 via the first electrical path EP1. The first electrical path EP1 may be accommodated in the first housing 21 (see FIG. 2). The first electrical path EP1 may include a combination of one or more conductive paths (also referred to as conductors or conductive structures) (not illustrated separately) between the first point P1 of the first metal E1 and the wireless communication circuit 610.

According to an embodiment, the second point P2 of the first metal E1 may be electrically connected to the first ground area G1 via the third electrical path EP3. The third electrical path EP3 may be accommodated in the first housing 21 (see FIG. 2). The third electrical path EP3 may include a combination of one or more conductive paths (also referred to as conductors or conductive structures) (not illustrated separately) between the third point P3 of the first metal E1 and the first ground area G1.

According to an embodiment, the second point P2 of the seventh metal E7 may be electrically connected to the second ground area G2 via the fourth electrical path EP4. The fourth electrical path EP4 may be accommodated in the second housing 22 (see FIG. 2). The fourth electrical path EP4 may include a combination of one or more conductive paths (also referred to as conductors or conductive structures) (not illustrated separately) between the second point P2 of the seventh metal E7 and the second ground area G2.

According to an embodiment, the fourth point P4 of the seventh metal E7 may be electrically connected to the wireless communication circuit 610 via the second electrical path EP2. The second electrical path EP2 may be disposed across the hinge portion 24. The second electrical path EP2 may include a combination of one or more conductive paths (also referred to as conductors or conductive structures) (not illustrated separately) between the fourth point P4 of the seventh metal E7 and the wireless communication circuit 610.

According to an embodiment, the phase shifter 2001 may be disposed on the second electrical path EP2. The phase shifter 2001 may be accommodated in second housing 22 (see FIG. 2). The phase shifter 2001 may be disposed on a printed circuit board (not illustrated separately) accommodated in the second housing 22.

According to an embodiment, although not illustrated separately, the phase shifter 2001 may be accommodated in the first housing 21 (see FIG. 2). The phase shifter 2001 may be disposed on a printed circuit board (not illustrated separately) accommodated in the first housing 21.

According to an embodiment, although not illustrated separately, the phase shifter 2001 may be disposed on the fifteenth electrical path EP15 and/or the sixteenth electrical path EP16 or may be electrically connected to the fifteenth electrical path EP15 and/or the sixteenth electrical path EP16. The phase shifter 2001 may be located, for example, between the wireless communication circuit 610 and the EMI filter 620. The phase shifter 2001 may be located, for example, between the EMI filter 620 and the matching circuit 630.

According to an embodiment, the wireless communication circuit 610 may provide first power feeing (e.g., +voltage) to the first electrical path EP1 and second power feeding (e.g., -voltage) to the second electrical path EP2. When the foldable electronic device 2 is in the folded state, at the time of feeding from the wireless communication circuit 610, the phase shifter 2001 may make the phases of the radiation currents flowing on the first metal E1 and the seventh metal E7, which are aligned with each other, coincide with each other.

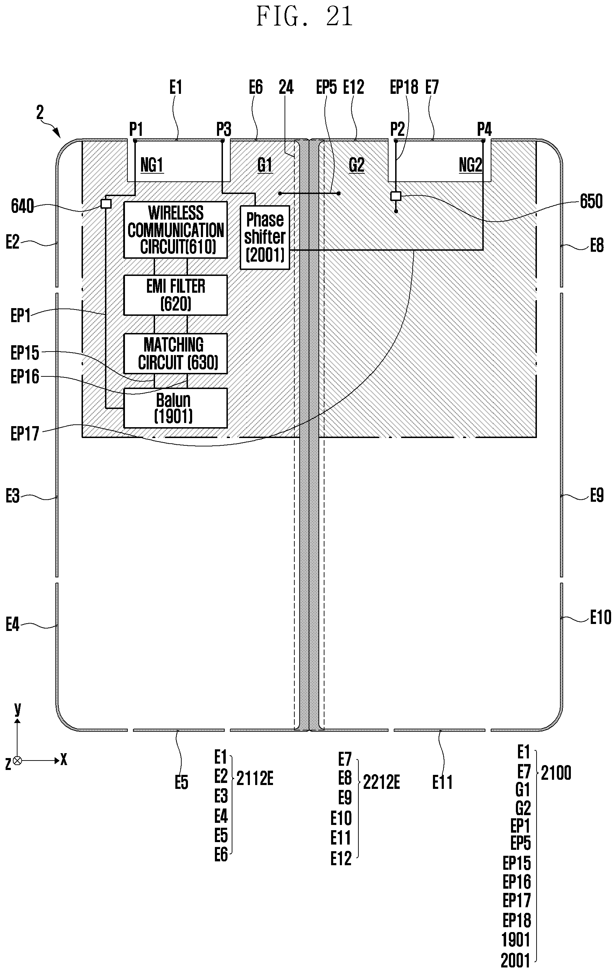

FIG. 21 is a view illustrating a foldable electronic device 2 according to an embodiment of the disclosure in an unfolded state. It is to be understood that the disclosure conceives and includes all of the combinations of features and/or embodiments disclosed with reference to FIG. 21. That is, all of the combinations of features described below with reference to FIG. 21 are to be considered as being included in the disclosure as specific examples.

Referring to FIG. 21, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first non-ground area NG1, a second non-ground area NG2, a first electrical path EP1, a fifth electrical path EP5, a fifteenth electrical path EP15, a sixteenth electrical path EP16, an eighteenth electrical path EP18, a balun 1901, a phase shifter 2001, a wireless communication circuit 610, an EMI filter 620, a matching circuit 630, a first filter 640, and/or a second filter 650. A seventh exemplary antenna structure 2100 may include a first metal E1, a seventh metal E7, a first ground area G1, a second ground area G2, a first electrical path EP1, a fifth electrical path EP5, a fifteenth electrical path EP15, a sixteenth electrical path EP16, a seventeenth electrical path EP17, an eighteenth electrical path EP18, a balun 1901, and a phase shifter 2001. Description of some components of FIG. 21 that have the same reference numerals as those described above with reference to the drawings will be omitted.

According to an embodiment, a first point P1 of the first metal E1 may be electrically connected to the balun 1901 via the first electrical path EP1.

According to an embodiment, the balun 1901 may be electrically connected to the wireless communication circuit 610 via the fifteenth electrical path EP15. The balun 1901 may be electrically connected to the wireless communication circuit 610 via the sixteenth electrical path EP16. The wireless communication circuit 610 may provide first power feeing (e.g., +voltage) to the fifteenth electrical path EP15 and second power feeding (e.g., -voltage) to the sixteenth electrical path EP16. The balun 1901 may transmit one of the first power feeding through the fifteenth electrical path EP15 and the second power feeding through the sixteenth electrical path EP16 to the first electrical path EP1. One selected by the balun from the first power feeing and the second power feeding may be provided to the first point P1 of the first metal E1 via the first electrical path EP1.

According to an embodiment, the seventeenth electrical path EP17 may electrically interconnect the third point P3 of the first metal E1 and the fourth point P4 of the seventh metal E7. The seventeenth electrical path EP17 may be disposed across the hinge portion 24.

According to an embodiment, the phase shifter 2001 may be disposed on the seventeenth electrical path EP17.

According to an embodiment, the phase shifter 2001 may be accommodated in the first housing 21 (see FIG. 2). The phase shifter 2001 may be disposed on a printed circuit board (not illustrated separately) accommodated in the first housing 21.

According to an embodiment, although not illustrated separately, the phase shifter 2001 may be accommodated in the second housing 22 (see FIG. 2). The phase shifter 2001 may be disposed on a printed circuit board (not illustrated separately) accommodated in the first housing 22.

According to an embodiment, the second point P2 of the seventh metal P7 may be electrically connected to the second ground area G2 via the eighteenth electrical path EP18.

According to an embodiment, when the foldable electronic device 2 is in the folded state, at the time of feeding, radiation currents may flow on the first metal E1 and the seventh metal E7 due to the potential difference between the first point P1 of the first metal E1 electrically connected to the first electrical path EP1 and the second point P2 of the seventh metal E7 electrically connected to the second ground region G2 via the eighteenth electrical path EP18. When the foldable electronic device 2 is in the folded state, at the time of feeding, radiation currents may flow in the same direction on the first metal E1 and the seventh metal E7 which are aligned with each other. The wireless communication circuit 610 may be configured to transmit and/or receive a signal of a selected or predetermined frequency band (e.g., about 13.56 MHz for NFC) through electromagnetic fields generated through the first metal E1 and the seventh metal E7 when the foldable electronic device 2 is in the folded state.

According to an embodiment, when the foldable electronic device 2 is in the folded state, at the time of feeding from the wireless communication circuit 610, the phase shifter 2001 may make the phases of the radiation currents flowing on the first metal E1 and the seventh metal E7, which are aligned with each other, coincide with each other.

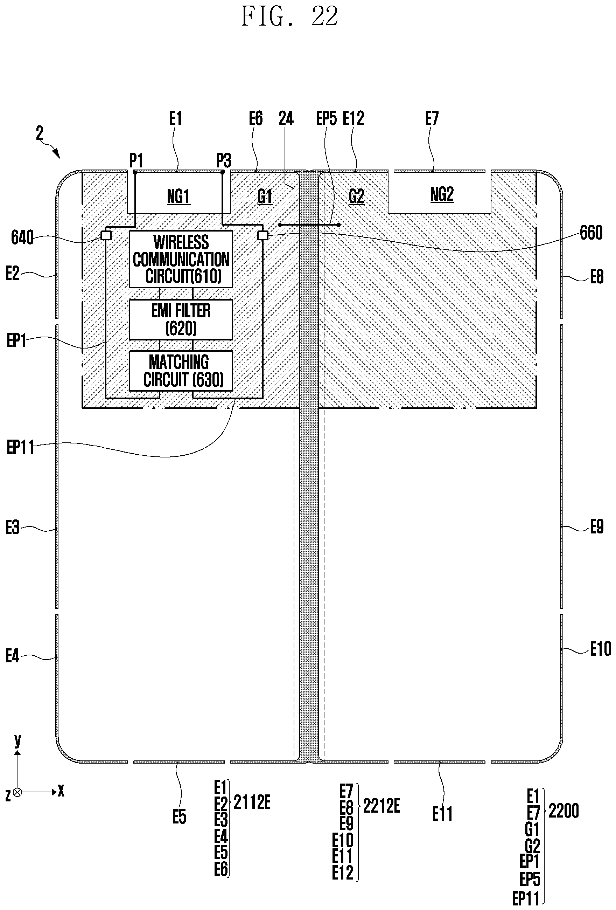

FIG. 22 is a view illustrating a foldable electronic device 2 according to an embodiment of the disclosure in an unfolded state. It is to be understood that the disclosure conceives and includes all of the combinations of features and/or embodiments disclosed with reference to FIG. 22. That is, all of the combinations of features described below with reference to FIG. 22 are to be considered as being included in the disclosure as specific examples.

Referring to FIG. 22, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first electrical path EP1, a fifth electrical path EP5, an eleventh electrical path EP11, a wireless communication circuit 610, an EMI filter 620, a matching circuit 630, a first filter 640, and/or a third filter 660. Descriptions of some components of FIG. 22 that are indicated by the same reference numerals as those illustrated in FIG. 6 will be omitted.

According to an embodiment, an eighth exemplary antenna structure 2200 included in the foldable electronic device 2 may include a first metal E1, a seventh metal E7, a first ground area G1, a second ground area G2, a first electrical path EP1, a fifth electrical path EP5, and/or an eleventh electrical path EP11.

According to an embodiment, the eleventh electrical path EP11 may electrically interconnect the wireless communication circuit 610 and the third point P3 of the first metal E1. The first metal E1 may be electrically connected to the third point P3 of the first metal E1 through the eleventh electrical path EP 1 1. The eleventh electrical path EP11 may include a combination of one or more conductive paths (or, conductors or conductive structures) (not separately illustrated) between the wireless communication circuit 610 and the third point P3 of the first metal E1.

According to an embodiment, the wireless communication circuit 610 may provide (or feed) a +voltage to the first electrical path EP1 and a -voltage to the eleventh electrical path EP11. The +voltage may be provided to the first point P1 of the first metal E1 through the first electrical path EP 1. The -voltage may be provided to the third point P3 of the first metal E1 through the eleventh electrical path EP11.

According to an embodiment, at the time of positive feeding to the first electrical path EP1 and negative feeding to the eleventh electrical path EP11, a current flow corresponding to the first metal E1 may be provided (or formed). The current flow may have a current path (or loop) in which a current (or radiation current) flows from the first electrical path EP1 to the eleventh electrical path EP11 through the first metal E1. The current path and the distribution of current (or radiation current) along the current path may form an electromagnetic field (or magnetic field distribution).

According to an embodiment, at the time of positive feeding to the first electrical path EP1 and negative feeding to the eleventh electrical path EP11, an electromagnetic field including electromagnetic force passing through the first non-ground area NG1 between the first metal E1 and the first ground area G1 may be provided (or formed).

According to an embodiment, the wireless communication circuit 610 may be configured to transmit and/or receive a signal in a frequency band selected or predetermined through an electromagnetic field generated corresponding to the current path including the first metal E1 at the time of positive feeding to the first electrical path EP1 and negative feeding to the eleventh electrical path EP1 1.

According to an embodiment, the wireless communication circuit 610 may be configured to transmit and/or receive a signal of about 13.56 MHz for NFC through an electromagnetic field generated corresponding to a current path including the first metal E1.

According to an embodiment, when the foldable electronic device 2 in the folded state (see FIG. 3), the first non-ground area NG1 and the second non-ground area NG2 may be aligned with and overlap each other. The electromagnetic force of an electromagnetic field generated corresponding to the current path including the first metal E1 at the time of positive feeding to the first electrical path EP1 and negative feeding to the eleventh electrical path EP11 may pass through the first non-ground area NG1 the second non-ground area NG2 which are aligned with and overlap each other. The second non-ground area NG2 prevents a magnetic flux from being reduced by the second ground area G2 so that deterioration in radiation performance of the eighth exemplary antenna structure 2200 can be reduced. When the magnetic flux is reduced by the second non-ground area NG2 when the foldable electronic device 2 is in the folded state, the energy of the electromagnetic field increases due to an increase in inductance value, thereby improving the radiation performance of the eighth exemplary antenna structure 2200.

According to an embodiment, the EMI filter 620 may be disposed in the first electrical path EP1 and/or the eleventh electrical path EP11 or may be electrically connected to the first electrical path EP1 and/or the eleventh electrical path EP11. The EMI filter 620 may reduce or shield noise affecting a signal (e.g., an NFC signal) in a selected or predetermined frequency band.

According to an embodiment, the matching circuit 630 may be disposed in the first electrical path EP1 and/or the eleventh electrical path EP11 or may be electrically connected to the first electrical path EP 1 and/or the eleventh electrical path EP11. The matching circuit 630 may adjust the frequency of the eighth exemplary antenna structure 2200 such that resonance can be generated, for example, in a selected or predetermined frequency band. The matching circuit 630 may move, for example, the resonance frequency of the eighth exemplary antenna structure 2200 to a predetermined frequency, or may move the resonance frequency by a predetermined amount.

According to an embodiment, the matching circuit 630 may adjust the frequency of the eighth exemplary antenna structure 2200 such that an electromagnetic field generated corresponding to a current path including the first metal E1 at the time of positive feeding to the first electrical path EP1 and negative feeding to the eleventh electrical path EP11 has a resonance frequency of about 13.56 MHz for NFC.

According to an embodiment, the matching circuit 630 may adjust the inductance of the eighth exemplary antenna structure 2200 to have a predetermined inductance value at the time of positive feeding to the first electrical path EP1 and negative feeding to the eleventh electrical path EP11. For example, the matching circuit 630 may adjust the frequency of the eighth exemplary antenna structure 2200 such that an electromagnetic field generated corresponding to a current path including the first metal E1 at the time of positive feeding to the first electrical path EP1 and negative feeding to the eleventh electrical path EP 11 has an inductance value of about 8 to about 10 microhenries for a resonance frequency of about 13.56 MHz for NFC.

According to an embodiment, the matching circuit 630 may provide (or form) impedance matching. At the time of positive feeding to the first electrical path EP1 and negative feeding to the eleventh electrical path EP11, the matching circuit 630 may reduce transmission loss through impedance matching.

According to an embodiment, the first filter 640 may be disposed on the first electrical path EP1 or electrically connected to the first electrical path EP1. When the first metal E1 is used as an antenna radiator in a non-NFC band such as LB, MB, HB, or UHB, the first filter 640 may reduce the influence of the eighth exemplary structure 2200 on the non-NFC band (e.g., electromagnetic interference). For example, when the first metal E1 is used as an antenna radiator in a non-NFC band such as LB, MB, HB, or UHB, the first filter 640 may reduce or prevent the occurrence of resonance in the NFC band.

According to an embodiment, the first filter 640 may be provided as at least one filter (also referred to as a filter circuit), at least one switch (also referred to as a switch circuit), or a combination thereof.

According to an embodiment, the first filter 640 may include a diplex or a duplexer capable of transmitting each of an NFC band and a non-NFC band separately.

According to an embodiment, the third filter 660 may be disposed on the eleventh electrical path EP11 or electrically connected to the eleventh electrical path EP11. When the first metal E1 is used as an antenna radiator in a non-NFC band such as LB, MB, HB, or UHB, the third filter 660 may reduce the influence of the eighth exemplary structure 2200 on the non-NFC band (e.g., electromagnetic interference). For example, when the first metal E1 is used as an antenna radiator in a non-NFC band such as LB, MB, HB, or UHB, the third filter 660 may reduce or prevent the occurrence of resonance in the NFC band.

According to an embodiment, the third filter 660 may be provided as at least one filter (also referred to as a filter circuit), at least one switch (also referred to as a switch circuit), or a combination thereof.

According to an embodiment, the third filter 660 may include a diplex or a duplexer capable of transmitting each of an NFC band and a non-NFC band separately.

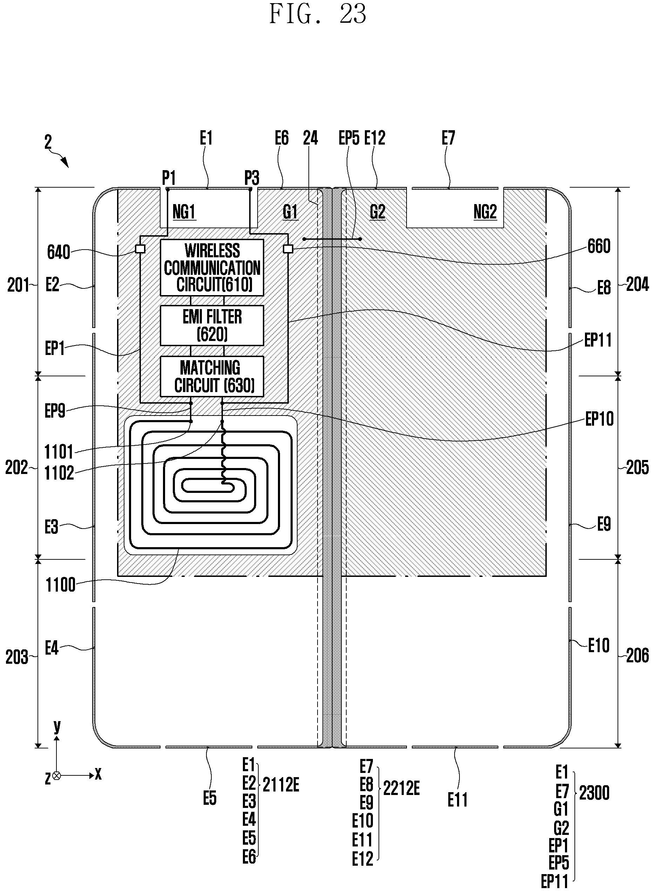

FIG. 23 is a view illustrating the foldable electronic device 2 according to an embodiment of the disclosure in the unfolded state. It is to be understood that the disclosure conceives and includes all of the combinations of features and/or embodiments disclosed with reference to FIG. 23. That is, all of the combinations of features described below with reference to FIG. 23 are to be considered as being included in the disclosure as specific examples.

Referring to FIG. 23, the foldable electronic device 2 may include a first side metal 2112E including a plurality of metals E1, E2, E3, E4, E5, and E6, a second side metal 2212E including a plurality of metals E7, E8, E9, E10, E11, and E12, a first ground area G1, a second ground area G2, a first electrical path EP1, a fifth electrical path EP5, an eleventh electrical path EP11, a wireless communication circuit 610, an EMI filter 620, a matching circuit 630, a first filter 640, a third filter 660, a spiral conductive pattern 1100, a ninth electrical path EP9, and/or a tenth electrical path EP10. The eighth exemplary antenna structure 2200 may include a first metal E1, a seventh metal E7, a first ground area G1, a second ground area G2, a first electrical path EP1, a fifth electrical path EP5, and/or an eleventh electrical path EP11. The embodiment of FIG. 23 may further include a spiral conductive pattern 1100, a ninth electrical path EP9, and a tenth electrical path EP10, compared to the embodiment of FIG. 22. Descriptions of some components of FIG. 23 that are indicated by the same reference numerals as those illustrated in FIG. 22 will be omitted.

According to an embodiment, the spiral conductive pattern 1100 may have a loop of a current path extending from a first end 1101 to a second end 1102. For example, the spiral conductive pattern 1100 may include a plane-shaped coil (e.g., a planar coil or a pattern coil) including a plurality of turns.

According to an embodiment, the first end 1101 of the spiral conductive pattern 1100 may be electrically connected to the first electrical path EP1 through the ninth electrical path EP9. The second end 1102 of the spiral conductive pattern 1100 may be electrically connected to the eleventh electrical path EP11 through the tenth electrical path EP10.

According to an embodiment, the wireless communication circuit 610 may provide (or feed) a +voltage to the first electrical path EP1 and a -voltage to the eleventh electrical path EP1 1. The +voltage may be provided to the first point P1 of the first metal E1 through the first electrical path EP1. The +voltage may be provided to the first end 1101 of the spiral conductive pattern 1100 through the ninth electrical path EP9. The -voltage may be provided to the third point P3 of the first metal E1 through the eleventh electrical path EP11. The -voltage may be provided to the second end 1102 of the spiral conductive pattern 1100 through the tenth electrical path EP10.

According to an embodiment, at the time of positive feeding to the first electrical path EP1 and negative feeding to the eleventh electrical path EP11, the embodiment of FIG. 23 may further provide an electromagnetic field generated due to a current path in which current (or radiation current) flows along the spiral conductive pattern 1100 and a distribution of current (or radiation current) along the current path, compared to the embodiment of FIG. 22. The wireless communication circuit 610 may be configured to transmit and/or receive a signal in a frequency band (e.g., about 13.56 MHz for NFC) selected or predetermined through an electromagnetic field generated through the spiral conductive pattern 1100.

According to an embodiment, the spiral conductive pattern 1100 may overlap the second area 202 of the first rear surface area of the foldable electronic device 2 when viewed from above. At the time of positive feeding to the first electrical path EP1 and negative feeding to the eleventh electrical path EP11, the electromagnetic field generated by the spiral conductive pattern 1100 may be radiated through the second area 202.

According to various embodiments, although not separately illustrated, the spiral conductive pattern 1100 may be accommodated in the first housing 21 (see FIG. 2) to overlap the third area 203 of the first rear surface area of the foldable electronic device 2 when viewed from above the first rear surface area of the foldable electronic device 2. At the time of positive feeding to the first electrical path EP1 and negative feeding to the eleventh electrical path EP11, the electromagnetic field generated by the spiral conductive pattern 1100 may be radiated through the third area 203.

According to various embodiments, although not separately illustrated, the spiral conductive pattern 1100 may be accommodated in the second housing 22 (see FIG. 2) to overlap the fifth area 205 of the second rear surface area of the foldable electronic device 2 when viewed from above the second rear surface area of the foldable electronic device 2. At the time of positive feeding to the first electrical path EP1 and negative feeding to the eleventh electrical path EP11, the electromagnetic field generated by the spiral conductive pattern 1100 may be radiated through the fifth area 205.

According to various embodiments, although not separately illustrated, the spiral conductive pattern 1100 may be accommodated in the second housing 22 (see FIG. 2) to overlap the sixth area 206 of the second rear surface area of the foldable electronic device 2 when viewed from above the second rear surface area of the foldable electronic device 2. At the time of positive feeding to the first electrical path EP1 and negative feeding to the eleventh electrical path EP11, the electromagnetic field generated by the spiral conductive pattern 1100 may be radiated through the sixth area 206.

According to various embodiments, the embodiment of FIG. 22 or 23 may be configured to such that the wireless communication circuit 610 provides (or feeds) a +voltage to the eleventh electrical path EP11 and provides (or feeds) a -voltage to the first electrical path EP1.

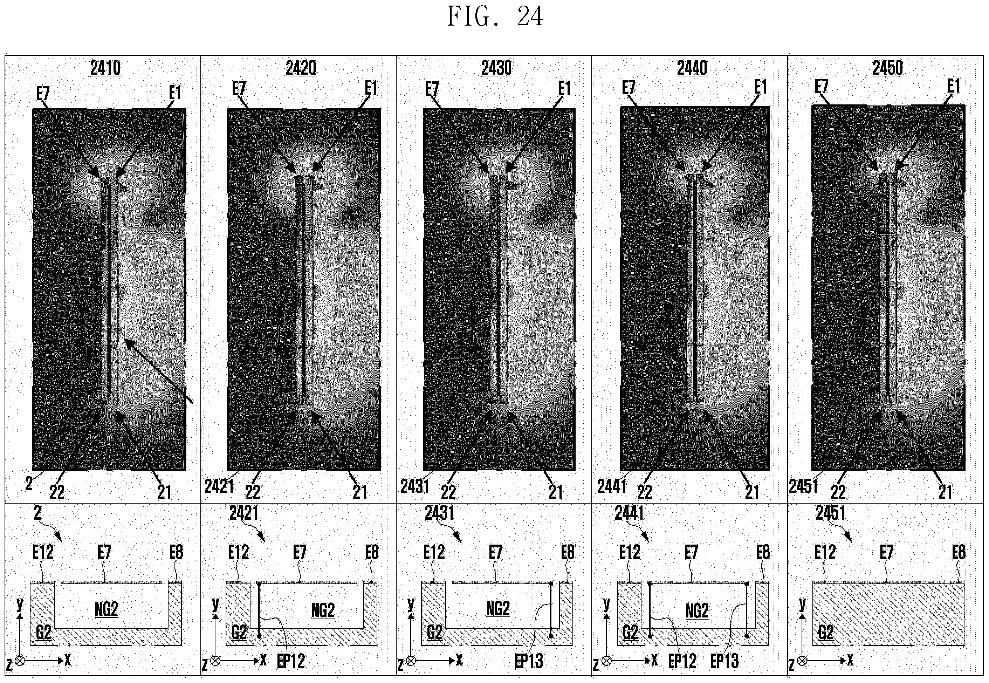

FIG. 24 illustrates a heat map 2010 showing a heat map 2410 showing an electromagnetic distribution at the time of feeding when the foldable electronic device 2 of FIG. 23 according to an embodiment of the disclosure and heat maps 2420, 2430, 2440, and 2450 showing magnetic field distributions at the time of feeding when foldable electronic devices 2421, 2431, 2441, and 2451 of comparative examples are in the folded state.

In the foldable electronic device 2 of FIG. 23 according to an embodiment of the disclosure, the seventh metal E7 and the second ground area G2 may be physically and electrically separated from each other.

The foldable electronic devices 2421, 2431, 2441, and 2451 of the comparative examples include a foldable electronic device 2421 of a fifth comparative example, a foldable electronic device 2431 of a sixth comparative example, a foldable electronic device 2441 of a seventh comparative example, and/or a foldable electronic device 2451 of an eighth comparative example. The foldable electronic device 2421 of the fifth comparative example may include a twelfth electrical path EP12 electrically interconnecting the second point P2 of the seventh metal E7 and the second ground area G2. The foldable electronic device 2431 of the sixth comparative example may include a thirteenth electrical path EP13 electrically interconnecting the second point P4 of the seventh metal E7 and the second ground area G2. The foldable electronic device 2441 of the seventh comparative example may include a twelfth electrical path EP12 electrically interconnecting the second point P2 of the seventh metal E7 and the second ground area G2, and a thirteenth electrical path EP13 electrically interconnecting the fourth point P4 of the metal E7 and the second ground area G2. In the foldable electronic device 2451 of the eighth comparative example, the second non-ground area NG2 (see FIG. 23) may be omitted. FIG. 24 illustrates a heat map 2420 showing the magnetic field distribution at the time of feeding when the foldable electronic device 2421 of the fifth comparative example is in the folded state, a heat map 2430 showing the magnetic field distribution at the time of feeding when the foldable electronic device 2431 of the sixth comparative example is in the folded state, a heat map 2440 showing the magnetic field distribution at the time of feeding when the foldable electronic device 2441 of the seventh comparative example is in the folded state, and a heat map 2450 showing the magnetic field distribution at the time of feeding when the foldable electronic device 2451 of the eighth comparative example is in the folded state.

At the time of positive feeding to the first electrical path EP1 and negative feeding to the eleventh electrical path EP11 when the foldable electronic device 2 of FIG. 23 according to an embodiment of the disclosure is in the folded state, a current may flow in the seventh metal E7 due to electrical coupling between the first metal E1 and the seventh metal E7. When the foldable electronic device 2 of FIG. 23 according to an embodiment of the disclosure is in the folded state, the direction in which a current flows in the seventh metal E7 may be opposite to the direction in which a current flows in the first metal E1. However, since a current path (or loop) is not substantially formed due to the insulation between the seventh metal E7 and the second ground area G2, deterioration in radiation performance of the eighth exemplary antenna structure 2200 can be reduced.

When the foldable electronic device 2421 of the fifth comparative example, the foldable electronic device 2431 of the sixth comparative example, or the foldable electronic device 2441 of the seventh comparative example is in the folded state, a reverse current phenomenon in the current path (or loop) including the seventh metal E7 is difficult to reduce due to the electrical connection between the seventh metal E7 and the second ground area G2, so that radiation performance may be deteriorated compared to the foldable electronic device 2 of FIG. 23 according to the disclosure. The foldable electronic device 2 of FIG. 23 according to the disclosure may have an improved magnetic field distribution and/or radiation performance by reducing the reverse current phenomenon in the current path including the seventh metal E7 in the folded state, compared to the foldable electronic device 2421 of the fifth comparative example, the foldable electronic device 2431 of the sixth comparative example, or the foldable electronic device 2441 of the seventh comparative example.

Compared to the foldable electronic device 2451 of the eighth comparative example that does not include the second non-ground area NG2, the foldable electronic device 2 of FIG. 23 according to an embodiment of the disclosure may have an improved magnetic field distribution so that radiation performance can be improved.

According to various embodiments, the first exemplary antenna structure 600 of FIG. 6 or 11, the second exemplary antenna structure 900 of FIG. 9 or 12, the third exemplary antenna structure 1000 of FIG. 10 or 13, the fourth exemplary antenna structure 1800, the fifth exemplary antenna structure 1900 of FIG. 19, the sixth exemplary antenna structure 2000 of FIG. 20, the seventh exemplary structure 2100 of FIG. 21, or the eighth exemplary antenna structure 2200 of FIG. 22 or 23, may include, in replacement of the first metal E1 and the seventh metal E7, two different metals which are aligned with and overlap each other when the foldable electronic device 2 is in the folded state.

According to various embodiments, although not separately illustrated, the foldable electronic device 2 of the disclosure is not limited to being implemented as being foldable about the center line A (see FIG. 2) parallel to the +y-axis, and may be implemented to be foldable about the center line parallel to the +x-axis direction.

FIG. 25 is a view illustrating a flexible printed circuit board 2500 according to various embodiments of the disclosure. It is to be understood that the disclosure conceives and includes all of the combinations of features and/or embodiments disclosed with reference to FIG. 25. That is, all of the combinations of features described below with reference to FIG. 21 are to be considered as being included in the disclosure as specific examples.

Referring to FIG. 25, the flexible printed circuit board 2500 may extend from the first housing 21 (see FIG. 2) to the second housing 22 (see FIG. 2) across the hinge portion 24 (see FIG. 3). The flexible printed circuit board 2500 may be bent when the foldable electronic device 2 (see FIG. 2) switches between the unfolded state and the folded state.

According to an embodiment, the flexible printed circuit board 2500 may electrically interconnect a first printed circuit board (not separately illustrated) accommodated in the first housing 21 (see FIG. 2) and a second printed circuit board (not separately illustrated) accommodated in the second housing 22 (see FIG. 2). The flexible printed circuit board 2500 may include a first connector (also referred to as a first connector end) 2501 electrically connected to the first printed circuit board, and a second connector (also referred to as a second connector end) 2502 electrically connected to the second printed circuit board, and may extend to a first connector 2501 and a second connector 2502.

According to an embodiment, the flexible printed circuit board 2500 may include a plurality of signal lines 2510 and a ground structure (not separately illustrated). The plurality of signal lines 2510 and the ground structure may extend from the first connector 2501 to the second connector 2502. The ground structure may at least partially surround the plurality of signal lines 2510 and may reduce or prevent electromagnetic interference (EMI) with respect to the plurality of signal lines 2510. The ground structure may reduce or prevent the electromagnetic influence of noise from the outside of the foldable flexible printed circuit board 2510 on the plurality of signal lines 2510. The ground structure may reduce or prevent electromagnetic interference among the plurality of signal lines. Although not separately illustrated, the number of signal lines or the relative positions of the plurality of signal lines are not limited to the illustrated example and may vary.

According to an embodiment, the ground structure (not separately illustrated) of the flexible printed circuit board 2500 may be included the fifth electrical path EP5 in the embodiment of FIG. 6, 9, 10, 11, 12, 13, 18, 19, 20, 21, 22, or 23.

According to an embodiment, in the embodiment of FIG. 6 or 11, one of the plurality of signal lines 2510 may be included in the second electrical path EP2. Among the plurality of signal lines 2510, one signal line included in the second electrical path EP2 may be, for example, one of two outermost signal lines 2511 and 2519. One signal line included in the second electrical path EP2 among the plurality of signal lines 2110 may be one signal line 2512, 2513, 2514, 2515, 2516, 2517, or 2518 located, for example, between the two outermost signal lines 2511 and 2519.

According to an embodiment, in the embodiment of FIG. 9 or 12, one of the plurality of signal lines 2510 may be included in the second electrical path EP2. In the embodiment of FIG. 9 or 12, one of the plurality of signal lines 2510 may be included in the sixth electrical path EP6. For example, one signal line included in the second electrical path EP2 among the plurality of signal lines 2510 may be one of the two outermost signal lines 2511 and 2519, and one signal line included in the sixth electrical path EP6 among the plurality of signal lines 2510 may be the remaining one of the two outermost signal lines 2511 and 2519. One signal line included in the second electrical path EP2 among the plurality of signal lines 2510 and one signal line included in the sixth electrical path EP6 among the plurality of signal lines 2510 may be, for example, two signal lines located between the two outermost signal lines 2511 and 2519 among the plurality of signal lines 2510. One signal line included in the second electrical path EP2 among the plurality of signal lines 2510 and one signal line included in the sixth electrical path EP6 among the plurality of signal lines 2510 may be, for example, adjacent to each other without another signal line therebetween, or may be spaced apart from each other with at least one other signal line therebetween.

According to an embodiment, in the embodiment of FIG. 10 or 13, one of the plurality of signal lines 2510 may be included in the second electrical path EP2. In the embodiment of FIG. 10 or 13, one of the plurality of signal lines 2510 may be included in the eighth electrical path EP8. For example, one signal line included in the second electrical path EP2 among the plurality of signal lines 2510 may be one of the two outermost signal lines 2511 and 2519, and one signal line included in the eighth electrical path EP8 among the plurality of signal lines 2510 may be the remaining one of the two outermost signal lines 2511 and 2519. One signal line included in the second electrical path EP2 among the plurality of signal lines 2510 and one signal line included in the eighth electrical path EP8 among the plurality of signal lines 2510 may be, for example, two signal lines located between the two outermost signal lines 2511 and 2519 among the plurality of signal lines 2510. One signal line included in the second electrical path EP2 among the plurality of signal lines 2510 and one signal line included in the eighth electrical path EP8 among the plurality of signal lines 2510 may be, for example, adjacent to each other without another signal line therebetween, or may be spaced apart from each other with at least one other signal line therebetween.

According to an embodiment, in the embodiment of FIG. 18, one of the plurality of signal lines 2510 may be included in the second electrical path EP2. Among the plurality of signal lines 2510, one signal line included in the second electrical path EP2 may be, for example, one of two outermost signal lines 2511 and 2519. One signal line included in the second electrical path EP2 among the plurality of signal lines 2510 may be one signal line 2512, 2513, 2514, 2515, 2516, 2517, or 2518 located, for example, between the two outermost signal lines 2511 and 2519.

According to an embodiment, in the embodiment of FIG. 19 or 21, one of the plurality of signal lines 2510 may be included in the seventh electrical path EP17. Among the plurality of signal lines 2510, one signal line included in the seventeenth electrical path EP17 may be, for example, one of two outermost signal lines 2511 and 2519. One signal line included in the seventeenth electrical path EP17 among the plurality of signal lines 2510 may be one signal line 2512, 2513, 2514, 2515, 2516, 2517, or 2518 located, for example, between the two outermost signal lines 2511 and 2519.

According to an embodiment, in the embodiment of FIG. 20, one of the plurality of signal lines 2510 may be included in the second electrical path EP2. Among the plurality of signal lines 2510, one signal line included in the second electrical path EP2 may be, for example, one of two outermost signal lines 2511 and 2519. One signal line included in the second electrical path EP2 among the plurality of signal lines 2510 may be one signal line 2512, 2513, 2514, 2515, 2516, 2517, or 2518 located, for example, between the two outermost signal lines 2511 and 2519.

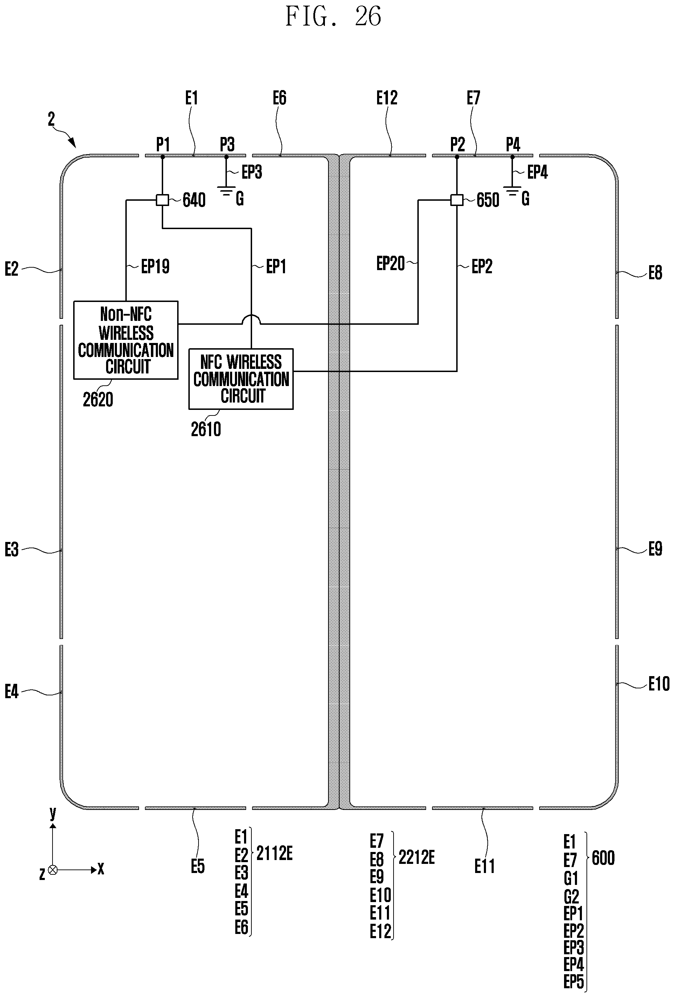

FIG. 26 is a view illustrating the foldable electronic device 2 according to an embodiment of the disclosure in the unfolded state. It is to be understood that the disclosure conceives and includes all of the combinations of features and/or embodiments disclosed with reference to FIG. 26. That is, all of the combinations of features described below with reference to FIG. 26 are to be considered as being included in the disclosure as specific examples.

Referring to FIG. 26, the foldable electronic device 2 may include a first side metal 2112E including a plurality of metals E1, E2, E3, E4, E5, and E6, a second side metal 2212E including a plurality of metals E7, E8, E9, E10, E11, and E12, antenna ground G, a first electrical path EP1, a second electrical path EP2, a third electrical path EP3, a fourth electrical path EP4, a nineteenth electrical path EP19, a twentieth electrical path EP20, an NFC wireless communication circuit (also referred to as a first wireless communication circuit) 2610, a non-NFC wireless communication circuit (also referred to as a second wireless communication circuit) 2620, a first filter 640, and/or a second filter 650. Descriptions of some components of FIG. 26 that are indicated by the same reference numerals as those illustrated in FIG. 6 will be omitted. For example, the non-NFC wireless communication circuit 2620 may include a wireless communication circuit other than a wireless communication circuit that supports NFC communication, such as the NFC wireless communication circuit 2610.

According to an embodiment, the NFC wireless communication circuit 2610 may be configured to transmit and/or receive a signal in the NFC band and may include, for example, the wireless communication circuit 610 of FIG. 6. For example, the NFC wireless communication circuit 2610 may further include the EMI filter 620 and/or the matching circuit 630 of FIG. 6.

According to an embodiment, the non-NFC wireless communication circuit 2620 may be configured to transmit and/or receive a signal in a non-NFC band such as LB, MB, HB, or UHB.

According to an embodiment, the nineteenth electrical path EP19 may electrically interconnect the first filter 640 and the non-NFC wireless communication circuit 2620. The nineteenth electrical path EP19 may be electrically connected to the first electrical path EP1 through the first filter 640. The non-NFC wireless communication circuit 2620 may be electrically connected to the first metal E1 through the fourteenth electrical path EP19, the first filter 640, and the first electrical path EP1. The non-NFC wireless communication circuit 2620 may be configured to transmit and/or receive a signal in a non-NFC band through the first metal E1.

According to an embodiment, when the non-NFC wireless communication circuit 2620 provides (or feeds) an electromagnetic signal (or, a wireless signal, an RF signal, or a radiation current) to the nineteenth electrical path EP19, a first signal path through which the electromagnetic signal flows may be formed between the first point P1 of the first metal E1 to which the first electrical path EP1 is electrically connected and the third point P3 of the first metal E1 to which the antenna ground G is electrically connected through the third electrical path EP3 of the first metal E1. When an electromagnetic signal is provided (or fed) from the non-NFC wireless communication circuit 2620 to the nineteenth electrical path EP19, a first radiation pattern (or, a first radiation field or a first electromagnetic field) may be provided (formed) through electromagnetic coupling between the first signal path and the antenna ground G. The first radiation pattern may have a first resonance frequency corresponding to the electrical length (e.g., the length expressed as a ratio of wavelengths) of the first signal path.

According to an embodiment, when the non-NFC wireless communication circuit 2620 transmits and/or receives a signal through the first metal E1, the first filter 640 may reduce the influence (e.g., electromagnetic interference) of the first exemplary antenna structure 600 on the non-NFC band. For example, when the non-NFC wireless communication circuit 2620 transmits and/or receives a signal through the first metal E1, the first filter 640 may reduce or prevent the occurrence of resonance in the NFC band.

According to an embodiment, the first filter 640 may be provided as at least one filter (also referred to as a filter circuit), at least one switch (also referred to as a switch circuit), or a combination thereof.

According to an embodiment, the first filter 640 may include a diplex or a duplexer capable of transmitting each of an NFC band and a non-NFC band separately.

According to various embodiments, the first filter 640 may include a matching circuit. The matching circuit may, for example, adjust the frequency such that resonance occurs in a selected or predetermined frequency band. The matching circuit may, for example, shift the resonance frequency to a predetermined frequency, or shift the resonance frequency by a predetermined amount. The matching circuit may provide (or form), for example, impedance matching.

According to various embodiments, it has been described that the nineteenth electrical path EP29 is branched from the first electrical path EP1 through the first filter 640, but without being limited thereto, there may be provided a configuration in which the nineteenth electrical path EP19 is electrically connected to the first metal E1, and the first electrical path EP1 is branched from the nineteenth electrical path EP19 through the first filter 640.

According to an embodiment, the twentieth electrical path EP20 may electrically interconnect the second filter 650 and the non-NFC wireless communication circuit 2620. The twentieth electrical path EP20 may be electrically connected to the second electrical path EP2 through the second filter 650. The non-NFC wireless communication circuit 2620 may be electrically connected to the seventh metal E7 through the fifteenth electrical path EP20, the second filter 650, and the second electrical path EP2. The non-NFC wireless communication circuit 2620 may be configured to transmit and/or receive a signal in a non-NFC band through the seventh metal E7.

According to an embodiment, when the non-NFC wireless communication circuit 2620 provides (or feeds) an electromagnetic signal (or, a wireless signal, an RF signal, or a radiation current) to the twentieth electrical path EP20, a second signal path through which the electromagnetic signal flows may be formed between the second point P2 of the seventh metal E7 to which the second electrical path EP2 is electrically connected and the fourth point P4 of the seventh metal E7 to which the antenna ground G is electrically connected through the fourth electrical path EP4. When an electromagnetic signal is provided (or fed) from the non-NFC wireless communication circuit 2620 to the twentieth electrical path EP20, a second radiation pattern (or, a second radiation field or a second electromagnetic field) may be provided (formed) through the second signal path. The second radiation pattern may have a second resonance frequency corresponding to the electrical length (e.g., the length expressed as a ratio of wavelengths) of the second signal path.

According to an embodiment, when the non-NFC wireless communication circuit 2620 transmits and/or receives a signal through the seventh metal E7, the second filter 650 may reduce the influence (e.g., electromagnetic interference) of the first exemplary antenna structure 600 on the non-NFC band. For example, when the non-NFC wireless communication circuit 2620 transmits and/or receives a signal through the seventh metal E7, the second filter 650 may reduce or prevent the occurrence of resonance in the NFC band.

According to an embodiment, the second filter 650 may be provided as at least one filter (also referred to as a filter circuit), at least one switch (also referred to as a switch circuit), or a combination thereof.

According to an embodiment, the second filter 650 may include a diplex or a duplexer capable of transmitting each of an NFC band and a non-NFC band separately.

According to various embodiments, the second filter 650 may include a matching circuit. The matching circuit may, for example, adjust the frequency such that resonance occurs in a selected or predetermined frequency band. The matching circuit may, for example, shift the resonance frequency to a predetermined frequency, or shift the resonance frequency by a predetermined amount. The matching circuit may provide (or form), for example, impedance matching.

According to various embodiments, it has been described that the twentieth electrical path EP20 is branched from the second electrical path EP2 through the second filter 650, but without being limited thereto, there may be provided a configuration in which the twentieth electrical path EP20 is electrically connected to the seventh metal E7, and the second electrical path EP2 is branched from the twentieth electrical path EP20 through the second filter 650.

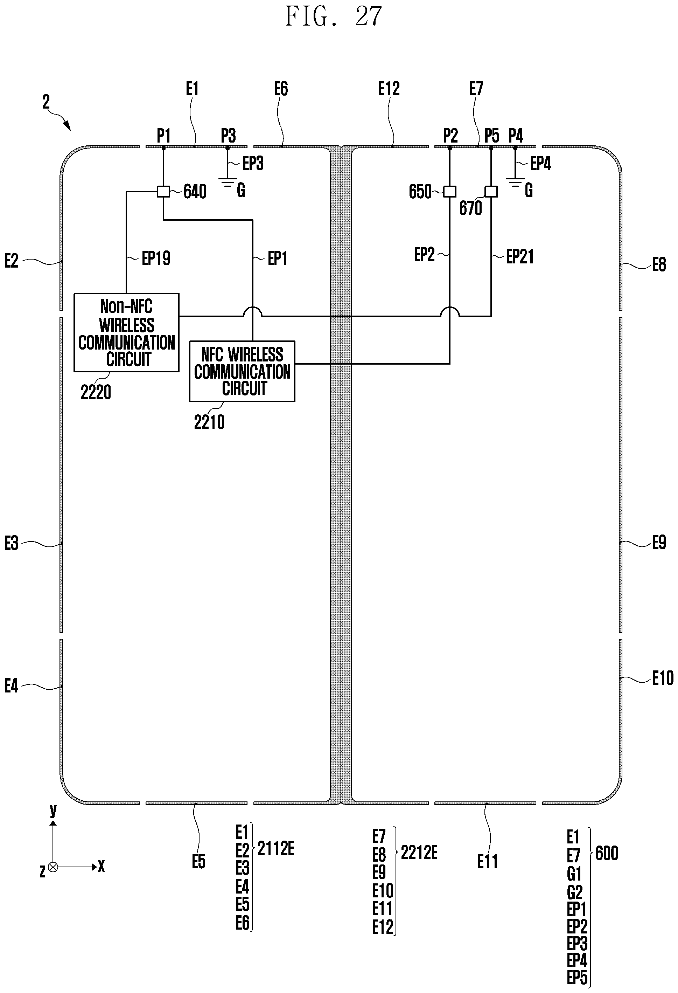

FIG. 27 is a view illustrating a foldable electronic device 2 according to an embodiment of the disclosure in an unfolded state. It is to be understood that the disclosure conceives and includes all of the combinations of features and/or embodiments disclosed with reference to FIG. 27. That is, all of the combinations of features described below with reference to FIG. 27 are to be considered as being included in the disclosure as specific examples.

Referring to FIG. 27, the foldable electronic device 2 may include a first side metal 2112E including a plurality of metals E1, E2, E3, E4, E5, and E6, a second side metal 2212E including a plurality of metals E7, E8, E9, E10, E11, and E12, antenna ground G, a first electrical path EP1, a second electrical path EP2, a third electrical path EP3, a fourth electrical path EP4, a nineteenth electrical path EP19, a twenty-first electrical path EP21, an NFC wireless communication circuit (also referred to as a first wireless communication circuit) 2610, a non-NFC wireless communication circuit (also referred to as a second wireless communication circuit) 2620, a first filter 640, a second filter 650, and/or a fourth filter 670. Descriptions of some components of FIG. 23 that are indicated by the same reference numerals as those illustrated in FIG. 6 and FIG. 22 will be omitted.

According to an embodiment, the twenty-first electrical path EP21 may electrically interconnect the seventh metal E7 and the non-NFC wireless communication circuit 2620. The twenty-first electrical path EP21 may include a combination of one or more conductive paths (or, conductors or conductive structures) (not separately illustrated) between the seventh metal E7 and the non-NFC wireless communication circuit 2620.

According to an embodiment, the twenty-first electrical path EP21 may be electrically connected to the fifth point P5 of the seventh metal E7. The fifth point P5 may be spaced apart from the second point P2 of the seventh metal E7 which is electrically connected to the second electrical path EP2 and the fourth point P4 of the seventh metal E7 which is electrically connected to the fourth electrical path EP4. For example, the fifth point P5 may be located between the second point P2 and the fourth point P4, but the locations or number of fifth points P5 are not restricted.

According to an embodiment, the non-NFC wireless communication circuit 2620 may be configured to transmit and/or receive a signal in a non-NFC band through the seventh metal E7. When the non-NFC wireless communication circuit 2620 provides (or feeds) an electromagnetic signal (or, a wireless signal, an RF signal, or a radiation current) to the fifth point P5 of the seventh metal E7 through the twenty-first electrical path EP21, a third signal path through which the electromagnetic signal flows may be formed between the fifth point P5 of the seventh metal E7 to which the twenty-first electrical path EP21 is electrically connected and the fourth point P4 of the seventh metal E7 to which the antenna ground G is electrically connected through the fourth electrical path EP4. When an electromagnetic signal is provided (or fed) from the non-NFC wireless communication circuit 2620 to the twenty-first electrical path EP21, a third radiation pattern (or, a third radiation field or a third electromagnetic field) may be provided (formed) through electromagnetic coupling between the third signal path and the antenna ground G. The third radiation pattern may have a third resonance frequency corresponding to the electrical length (e.g., the length expressed as a ratio of wavelengths) of the third signal path.

According to an embodiment, the fourth filter 670 may be disposed on the twenty-first electrical path EP21 or electrically connected to the twenty-first electrical path EP21. The non-NFC wireless communication circuit 2220 may be electrically connected to the seventh metal E7 through, for example, the fourth filter 670. When the non-NFC wireless communication circuit 2620 transmits and/or receives a signal through the seventh metal E7, the fourth filter 670 may reduce the influence (e.g., electromagnetic interference) of the first exemplary antenna structure 600 on the non-NFC band. For example, when the non-NFC wireless communication circuit 2620 transmits and/or receives a signal through the seventh metal E7, the fourth filter 670 may reduce or prevent the occurrence of resonance in the NFC band.

According to an embodiment, the fourth filter 670 may be provided as at least one filter (also referred to as a filter circuit), at least one switch (also referred to as a switch circuit), or a combination thereof.

According to an embodiment, the fourth filter 670 may include a diplex or a duplexer capable of transmitting each of an NFC band and a non-NFC band separately.

According to various embodiments, the fourth filter 670 may include a matching circuit. The matching circuit may, for example, adjust the frequency such that resonance occurs in a selected or predetermined frequency band. The matching circuit may, for example, shift the resonance frequency to a predetermined frequency, or shift the resonance frequency by a predetermined amount. The matching circuit may provide (or form), for example, impedance matching.

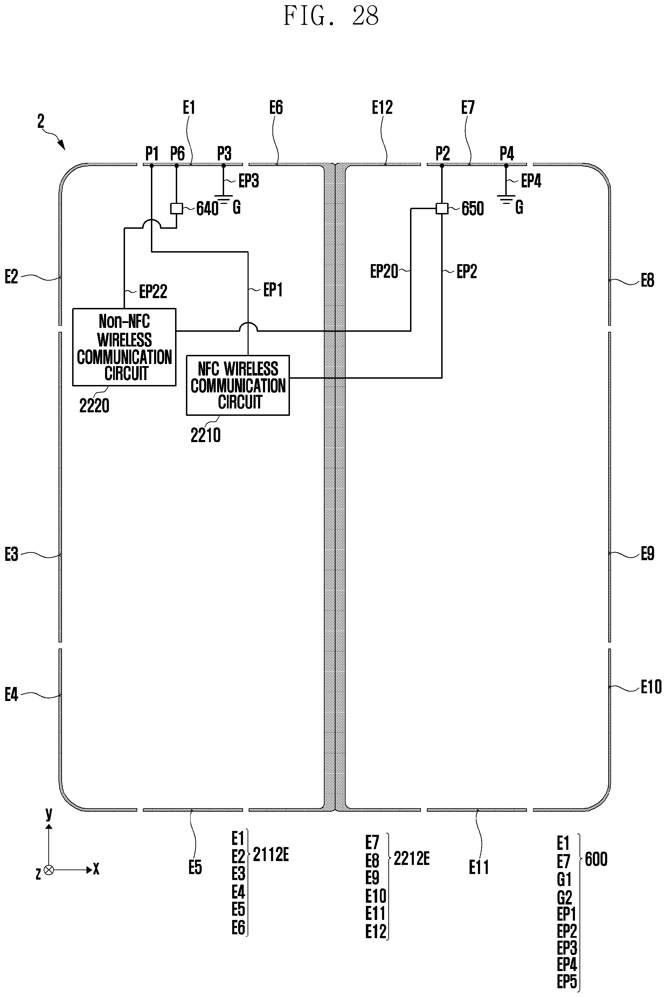

FIG. 28 is a view illustrating the foldable electronic device 2 according to an embodiment of the disclosure in the unfolded state. It is to be understood that the disclosure conceives and includes all of the combinations of features and/or embodiments disclosed with reference to FIG. 28. That is, all of the combinations of features described below with reference to FIG. 28 are to be considered as being included in the disclosure as specific examples.

Referring to FIG. 28, the foldable electronic device 2 may include a first side metal 2112E including a plurality of metals E1, E2, E3, E4, E5, and E6, a second side metal 2212E including a plurality of metals E7, E8, E9, E10, E11, and E12, antenna ground G, a first electrical path EP1, a second electrical path EP2, a third electrical path EP3, a fourth electrical path EP4, a twentieth electrical path EP20, a twenty-second electrical path EP22, an NFC wireless communication circuit (also referred to as a first wireless communication circuit) 2610, a non-NFC wireless communication circuit (also referred to as a second wireless communication circuit) 2620, a first filter 640, and/or a second filter 650. Descriptions of some components of FIG. 28 that are indicated by the same reference numerals as those illustrated in FIG. 6 and FIG. 26 will be omitted.

According to an embodiment, the twenty-second electrical path EP22 may electrically interconnect the first metal E1 and the non-NFC wireless communication circuit 2620. The twenty-second electrical path EP22 may include a combination of one or more conductive paths (or, conductors or conductive structures) (not separately illustrated) between the first metal E1 and the non-NFC wireless communication circuit 2620.

According to an embodiment, the twenty-second electrical path EP22 may be electrically connected to the sixth point P6 of the first metal E1. The sixth point P6 may be spaced apart from the first point P1 of the first metal E1 which is electrically connected to the first electrical path EP 1 and the third point P3 of the first metal E1 which is electrically connected to the third electrical path EP3. For example, the sixth point P6 may be located between the first point P1 and the third point P3, but the locations or number of fifth points P6 are not restricted.

According to an embodiment, the non-NFC wireless communication circuit 2620 may be configured to transmit and/or receive a signal in a non-NFC band through the first metal E1. When the non-NFC wireless communication circuit 2620 provides (or feeds) an electromagnetic signal (or, a wireless signal, an RF signal, or a radiation current) to the sixth point P6 of the first metal E1 through the twenty-second electrical path EP22, a fourth signal path through which the electromagnetic signal flows may be formed between the sixth point P6 of the first metal E1 to which the twenty-second electrical path EP22 is electrically connected and the third point P3 of the first metal E1 to which the antenna ground G is electrically connected through the third electrical path EP3. When an electromagnetic signal is provided (or fed) from the non-NFC wireless communication circuit 2220 to the twenty-second electrical path EP22, a fourth radiation pattern (or, a fourth radiation field or a fourth electromagnetic field) may be provided (formed) through the fourth signal path. The fourth radiation pattern may have a fourth resonance frequency corresponding to the electrical length (e.g., the length expressed as a ratio of wavelengths) of the fourth signal path.

According to an embodiment, the first filter 640 may be disposed on the twenty-second electrical path EP22 or electrically connected to the twenty-second electrical path EP22. The non-NFC wireless communication circuit 2620 may be electrically connected to the first metal E1 through, for example, the first filter 640. When the non-NFC wireless communication circuit 2620 transmits and/or receives a signal through the first metal E1, the first filter 640 may reduce the influence (e.g., electromagnetic interference) of the first exemplary antenna structure 600 on the non-NFC band. For example, when the non-NFC wireless communication circuit 2620 transmits and/or receives a signal through the first metal E1, the first filter 640 may reduce or prevent the occurrence of resonance in the NFC band.

According to an embodiment, the first filter 640 may be provided as at least one filter (also referred to as a filter circuit), at least one switch (also referred to as a switch circuit), or a combination thereof.

According to an embodiment, the first filter 640 may include a diplex or a duplexer capable of transmitting each of an NFC band and a non-NFC band separately.

According to various embodiments, the first filter 640 may include a matching circuit. The matching circuit may, for example, adjust the frequency such that resonance occurs in a selected or predetermined frequency band. The matching circuit may, for example, shift the resonance frequency to a predetermined frequency, or shift the resonance frequency by a predetermined amount. The matching circuit may provide (or form), for example, impedance matching.

According to various embodiments, although not separately illustrated, the first filter 640 may be disposed on the first electrical path EP1 or electrically connected to the first electrical path EP1. The NFC wireless communication circuit 2610 may be electrically connected to the first metal E1 through, for example, the first filter 640.

Hereinafter, various example foldable electronic devices will be described with reference to the attached drawings. One exemplary foldable electronic device may be obtained by changing at least some of a plurality of components of another exemplary foldable electronic device, and may be interpreted as being included in the scope of various embodiments of the disclosure. In connection with the description of one exemplary foldable electronic device, the same terminologies and/or the same reference numerals may be used for components that are at least partially identical, similar, or related to components of another exemplary foldable electronic device. In any two exemplary foldable electronic devices, two components with the same terminology but different reference numerals may be understood as being substantially the same as each other or being changed or modified in form.

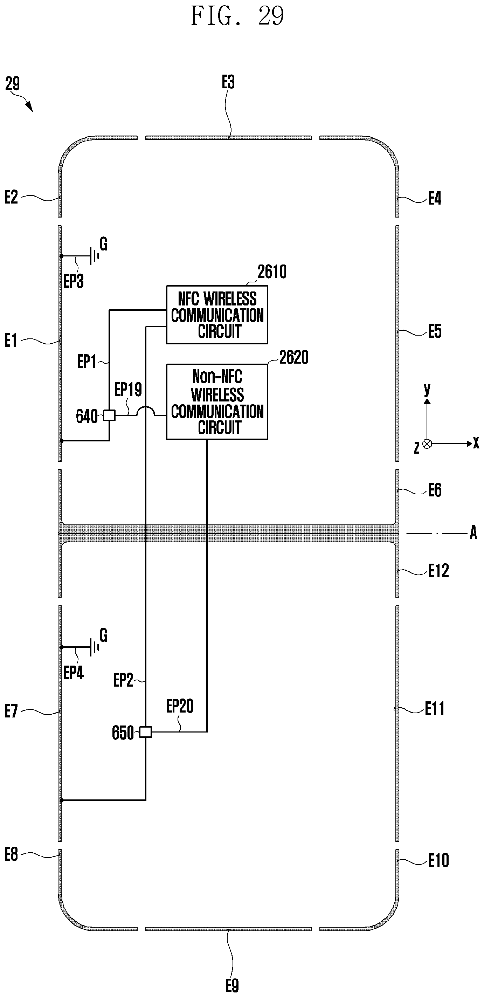

FIG. 29 is a view illustrating the foldable electronic device 29 according to an embodiment of the disclosure in the unfolded state. It is to be understood that the disclosure conceives and includes all of the combinations of features and/or embodiments disclosed with reference to FIG. 29. That is, all of the combinations of features described below with reference to FIG. 29 are to be considered as being included in the disclosure as specific examples.

Referring to FIG. 29, compared to the foldable electronic device 2 of FIG. 2 implemented to be foldable about the center line A parallel to the +y-axis, the foldable electronic device 29 may be implemented to be foldable about a center line A parallel to the +x-axis direction.

According to an embodiment, the foldable electronic device 29 may include a first side metal 2112E including a plurality of metals E1, E2, E3, E4, E5, and E6, a second side metal 2212E including a plurality of metals E7, E8, E9, E10, E11, and E12, antenna ground G, a first electrical path EP1, a second electrical path EP2, a third electrical path EP3, a fourth electrical path EP4, a nineteenth electrical path EP19, a twentieth electrical path EP20, an NFC wireless communication circuit (also referred to as a first wireless communication circuit) 2610, a non-NFC wireless communication circuit (also referred to as a second wireless communication circuit) 2260, a first filter 640, and/or a second filter 650.

According to an embodiment, as in substantially the same manner as the foldable electronic device 2 of FIG. 22, the foldable electronic device 25 may be configured such that the NFC wireless communication circuit 2610 and the non-NFC wireless communication circuit 2620 transmit and/or receive a signal through the first metal E1 and the second metal E7.

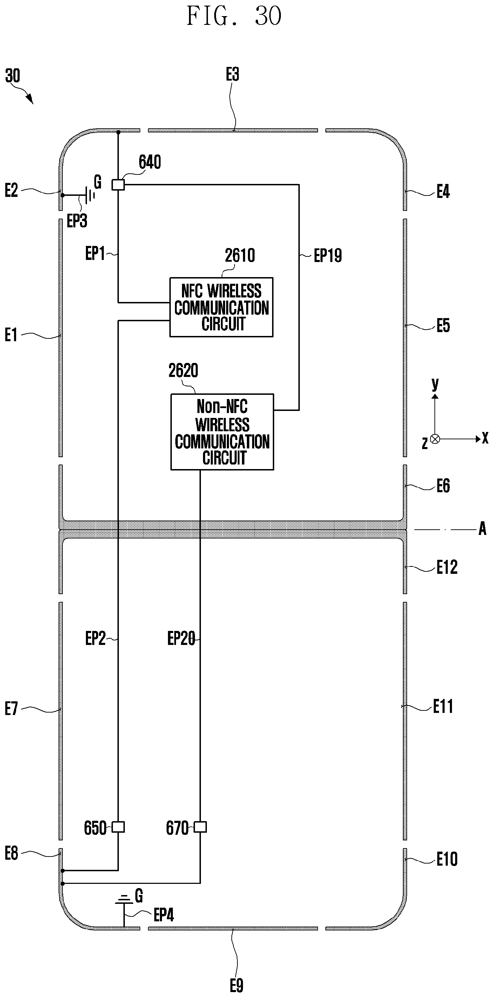

FIG. 30 is a view illustrating a foldable electronic device 30 according to an embodiment of the disclosure in an unfolded state. It is to be understood that the disclosure conceives and includes all of the combinations of features and/or embodiments disclosed with reference to FIG. 30. That is, all of the combinations of features described below with reference to FIG. 30 are to be considered as being included in the disclosure as specific examples.

Referring to FIG. 30, compared to the foldable electronic device 2 of FIG. 2 implemented to be foldable about the center line A parallel to the +y-axis, the foldable electronic device 30 may be implemented to be foldable about a center line A parallel to the +x-axis direction.

According to an embodiment, the foldable electronic device 30 may include a first side metal 2112E including a plurality of metals E1, E2, E3, E4, E5, and E6, a second side metal 2212E including a plurality of metals E7, E8, E9, E10, E11, and E12, antenna ground G, a first electrical path EP1, a second electrical path EP2, a third electrical path EP3, a fourth electrical path EP4, a nineteenth electrical path EP19, a twentieth electrical path EP20, an NFC wireless communication circuit (also referred to as a first wireless communication circuit) 2610, a non-NFC wireless communication circuit (also referred to as a second wireless communication circuit) 2620, a first filter 640, a second filter 650, and/or a fourth filter 670.

According to an embodiment, as in substantially the same manner as the foldable electronic device 2 of FIG. 27, the foldable electronic device 26 may be configured such that the NFC wireless communication circuit 2610 and the non-NFC wireless communication circuit 2620 transmit and/or receive a signal through the second metal E2 and the eighth metal E8.

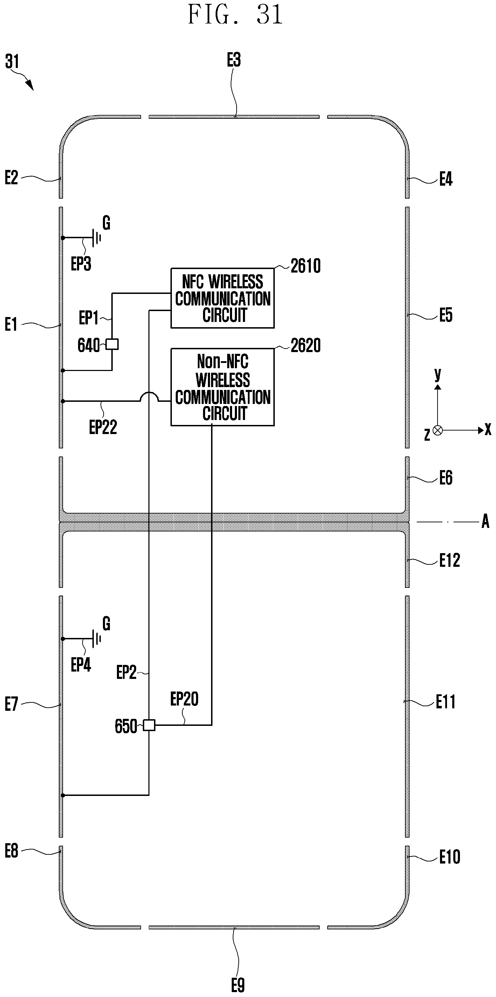

FIG. 31 is a view illustrating a foldable electronic device 27 according to an embodiment of the disclosure in an unfolded state. It is to be understood that the disclosure conceives and includes all of the combinations of features and/or embodiments disclosed with reference to FIG. 31. That is, all of the combinations of features described below with reference to FIG. 31 are to be considered as being included in the disclosure as specific examples.

Referring to FIG. 31, compared to the foldable electronic device 2 of FIG. 2 implemented to be foldable about the center line A parallel to the +y-axis, the foldable electronic device 31 may be implemented to be foldable about a center line A parallel to the +x-axis direction.

According to an embodiment, the foldable electronic device 31 may include a first side metal 2112E including a plurality of metals E1, E2, E3, E4, E5, and E6, a second side metal 2212E including a plurality of metals E7, E8, E9, E10, E11, and E12, antenna ground G, a first electrical path EP1, a second electrical path EP2, a third electrical path EP3, a fourth electrical path EP4, a twentieth electrical path EP20, a twenty-second electrical path EP22, an NFC wireless communication circuit (also referred to as a first wireless communication circuit) 2610, a non-NFC wireless communication circuit (also referred to as a second wireless communication circuit) 2620, a first filter 640, and/or a second filter 650.

According to an embodiment, as in substantially the same manner as the foldable electronic device 2 of FIG. 24, the foldable electronic device 31 may be configured such that the NFC wireless communication circuit 2610 and the non-NFC wireless communication circuit 2620 transmit and/or receive a signal through the first metal E1 and the seventh metal E7.

Hereinafter, various example multi-foldable electronic devices will be described with reference to the attached drawings. One exemplary multi-foldable electronic device may be obtained by changing at least some of a plurality of components of another exemplary multi-foldable electronic device, and may be interpreted as being included in the scope of various embodiments of the disclosure. In connection with the description of one exemplary multi-foldable electronic device, the same terminologies and/or the same reference numerals may be used for components that are at least partially identical, similar, or related to components of another exemplary multi-foldable electronic device. In any two exemplary multi-foldable electronic devices, two components with the same terminology but different reference numerals may be understood as being substantially the same as each other or being changed or modified in form.

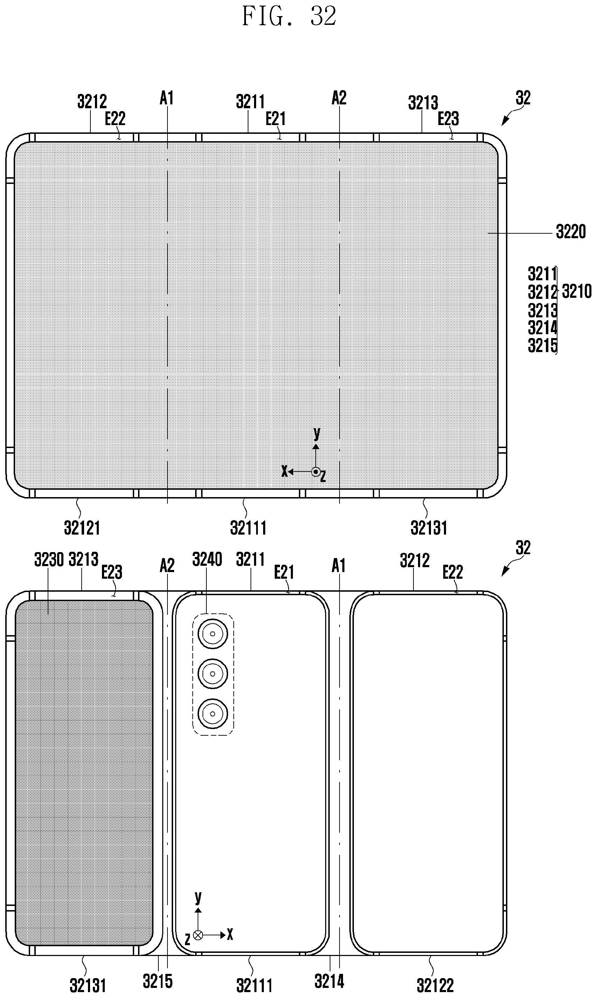

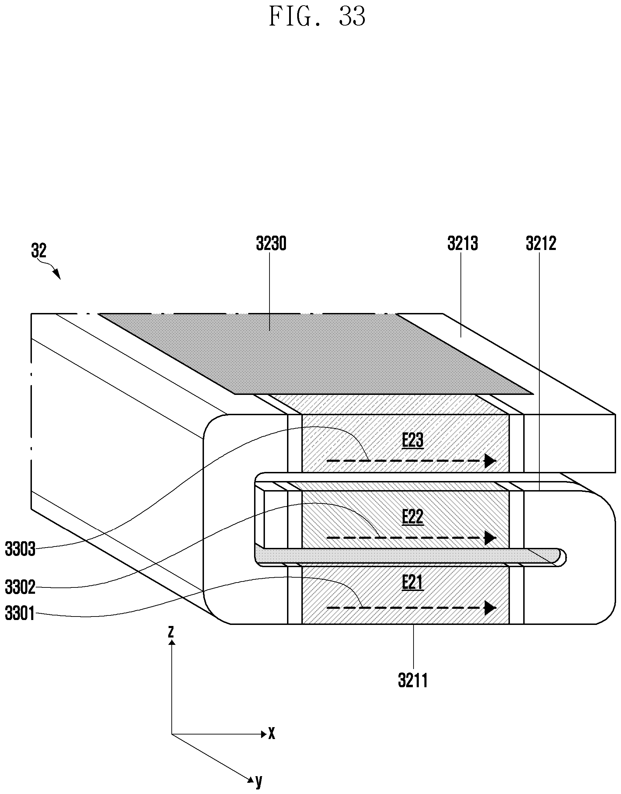

FIG. 32 is a view illustrating a multi-foldable electronic device 32 according to an embodiment of the disclosure in the unfolded state. FIG. 33 is a perspective view of the multi-foldable electronic device 32 according to an embodiment of the disclosure in the folded state. It is to be understood that the disclosure conceives and includes all of the combinations of features and/or embodiments disclosed with reference to FIGS. 32 and 33. That is, all of the combinations of features described below with reference to FIGS. 32 and 33 are to be considered as being included in the disclosure as specific examples.

Referring to FIGS. 32 and 33, the multi-foldable electronic device 32 may include a foldable housing 3210, a first display module 3220, a second display module 3230, and/or a plurality of camera modules 3240.

According to an embodiment, the foldable housing 3210 may include a first housing 3211, a second housing 3212, and/or a third housing 3213. When the multi-foldable electronic device 28 is in the unfolded state, the first housing 3211 may be disposed between the second housing 3212 and the third housing 3213. The foldable housing 3210 may be implemented to be foldable between the first housing 3211 and the second housing 3212. The first housing 3211 and the second housing 3212 may be connected, for example, by a hinge. The foldable housing 3210 may be implemented to be foldable between the first housing 3211 and the third housing 3213. The first housing 3211 and the third housing 3213 may be connected, for example, by a hinge.

According to an embodiment, the foldable housing 3210 may include a first hinge portion 3214 that includes one or more hinge modules interconnecting the first housing 3211 and the second housing 3212. The first hinge portion 3214 may allow the foldable housing 3210 to be folded about the first folding axis (also referred to as a first center line) A1. The foldable housing 3210 may include a second hinge portion 3215 that includes one or more hinge modules interconnecting the first housing 3211 and the third housing 3213. The second hinge portion 3215 may allow the foldable housing 3210 to be folded about the second folding axis (also referred to as a second center line) A2.

According to an embodiment, the foldable housing 3210 may be implemented to be foldable such that the second housing 3212 is located between the first housing 3211 and the third housing 3213 when the multi-foldable electronic device 32 is in the folded state.

According to an embodiment, the first display module 3220 may be disposed in the foldable housing 3210. The first display module 3220 may include a flexible display or foldable display. The display area of the first display module 3220 may include a first display area disposed in the first housing 32111, a second display area extending from the first display area and disposed in the second housing 3212, and a third display area extending from the first display area and disposed in the third housing 3212. When the multi-foldable electronic device 32 is in the unfolded state, the first display area may be located between the second display area and the third display area. When the multi-foldable electronic device 32 is in the unfolded state, the display area of the first display module 3220 may provide the front surface of the multi-foldable electronic device 32. The illustrated coordinate axes are indicated based on the first housing 3211, and the +z-axis direction may be defined or interpreted as a direction where the substantially flat display area is oriented. The x-y plane may be substantially parallel to the plane provided by the first display area. The +y-axis direction and the -y-axis direction may be substantially parallel to the first folding axis A1 and the second folding axis A2.

According to an embodiment, the second display area 3230 may be accommodated in the third housing 3213. The display area of the second display area 3230 may be oriented in an opposite direction to the third display area of the first display module 3220.

According to an embodiment, the plurality of camera modules 3240 may be located in the first housing 3211. The plurality of camera modules 3240 may face in a direction opposite to the first display area of the first display module 3220.

According to an embodiment, the first housing 3211 may include a first frame including a first side 3211 and a first support (or a first support plate) (not separately illustrated). The first side 3211 may provide (or form) at least a portion of the side surface of the first housing 3211. The first support may extend from or may be connected to the first side 3211 and may be located inside the multi-foldable electronic device 32 to support a plurality of components.

According to an embodiment, the second housing 3212 may include a second frame including a second side 32121 and a second support (or a second support plate) (not separately illustrated). The second side 32121 may provide (or form) at least a portion of the side surface of the second housing 3212. The second support may extend from or may be connected to the second side 32121 and may be located inside the multi-foldable electronic device 32 to support a plurality of components.

According to an embodiment, the third housing 3213 may include a third frame including a third side 3213 and a third support (or a third support plate) (not separately illustrated). The third side 32131 may provide (or form) at least a portion of the side surface of the third housing 3213. The third support may extend from or may be connected to the third side 32131 and may be located inside the multi-foldable electronic device 28 to support a plurality of components.

According to an embodiment, the first side 32111 of the first housing 3211, the second side 32121 of the second housing 3212, and the third side 32131 of the third housing 3213 may include a plurality of physically separated metals that are at least partially the same as or similar to the first side 2112 or the second side 2212 of FIG. 5. At least some of the plurality of metals of the first side 32111, at least some of the plurality of metals of the second side 28121, and at least some of the plurality of metals of the third side 32131 may be aligned with and overlap each other when the multi-foldable electronic 28 is in the folded state. For example, the first metal E21 of the first side 32111, the second metal E22 of the second side 32121, and the third metal E23 of the third side 32131 may be aligned with and overlap each other.

According to an embodiment, the multi-foldable electronic device 32 may be configured to transmit and/or receive a signal in the NFC band through the first metal E21, the second metal E22, and the third metal E23.

According to an embodiment, when the multi-foldable electronic device 32 is in the folded state, at the time of feeding from the NFC wireless communication circuit, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 32 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 32 is in the folded state, at the time of feeding from the NFC wireless communication circuit, the direction in which the current (or radiation current) flows on the first metal E21 (3301), the direction in which the current flows on the second metal E22 (3302), and the direction in which the current flows on the third metal E23 (3303) may be substantially the same. On the first metal E21, the second metal E22, and the third metal E23 which are aligned with and overlap each other when the multi-foldable electronic device 32 is in the folded state, the currents (or radiation currents) may flow in the same direction that is opposite to the illustrated direction. When the currents are caused to flow in substantially the same direction on the first metal E21, the second E22, and the third metal E23 which are aligned with and overlap each other when the multi-foldable electronic device 32 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 32 is in the folded state.

According to an embodiment, when the multi-foldable electronic device 32 is in the folded state, at the time of feeding from the NFC wireless communication circuit, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to various embodiments, the technical features of the disclosure are applicable to a multi-foldable electronic device (not separately illustrated) in which a screen (or a flexible display) can be folded three or more times.

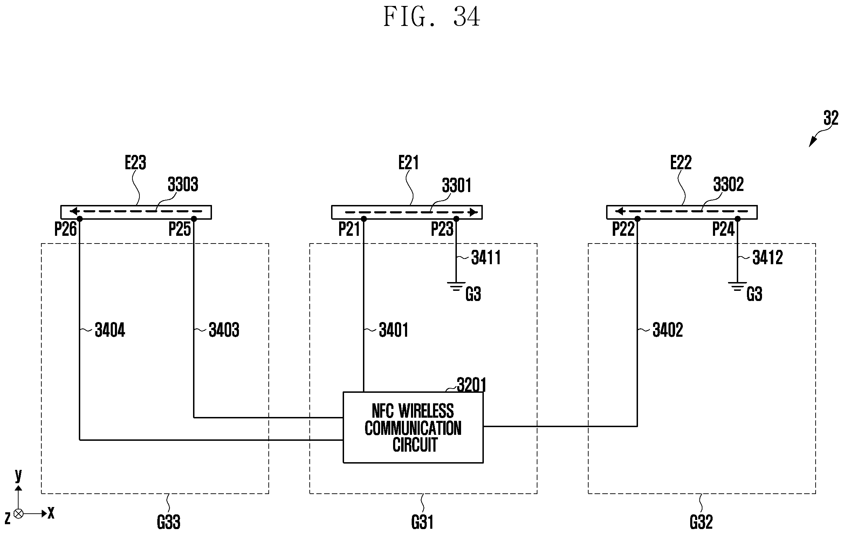

FIG. 34 is a view illustrating a multi-foldable electronic device 32 according to an embodiment of the disclosure in the unfolded state. It is to be understood that the disclosure conceives and includes all of the combinations of features and/or embodiments disclosed with reference to FIG. 34. That is, all of the combinations of features described below with reference to FIG. 34 are to be considered as being included in the disclosure as specific examples.

Referring to FIG. 34, the multi-foldable electronic device 32 may include a first metal E21, a second metal E22, a third metal E23, an antenna ground G3, and an NFC wireless communication circuit 3201.

According to an embodiment, the antenna ground G3 may include a first ground area G31 located corresponding to the first housing 3211 (see FIG. 32), a second ground area G32 located corresponding to the second housing 3212 (see FIG. 32), and/or a third ground area G33 located corresponding to the third housing 3213 (see FIG. 32).

According to an embodiment, the first ground area G31 may include a combination of at least one ground plane included in at least one printed circuit board (not separately illustrated) accommodated in the first housing 3211 (see FIG. 32) and/or at least one other conductor (or, conductive area or conductive structure).

According to an embodiment, the second ground area G32 may include a combination of at least one ground plane included in at least one printed circuit board (not separately illustrated) accommodated in the second housing 3212 (see FIG. 32) and/or at least one other conductor (or, conductive area or conductive structure).

According to an embodiment, the third ground area G33 may include a combination of at least one ground plane included in at least one printed circuit board (not separately illustrated) accommodated in the third housing 2813 (see FIG. 28) and/or at least one other conductor (or, conductive area or conductive structure).

According to an embodiment, the first ground area G31, the second ground area G32 and the third ground area G33 may be electrically connected to each other.

According to an embodiment, the first ground area G31 and the second ground area G32 may be electrically connected to each other through a printed circuit board (e.g., the flexible printed circuit board 2500 in FIG. 25) disposed across the first hinge portion 3214 (see FIG. 32). In an embodiment, the first ground area G31 and the second ground area G32 may be electrically connected to each other through at least one hinge module included in the first hinge portion 3214 (see FIG. 32).

According to an embodiment, the first ground area G31 and the third ground area G33 may be electrically connected to each other through a flexible printed circuit board (e.g., the flexible printed circuit board 2500 in FIG. 25) disposed across the second hinge portion 3215 (see FIG. 32). In an embodiment, the first ground area G31 and the third ground area G33 may be electrically connected to each other through at least one hinge module included in the second hinge portion 3215 (see FIG. 32).

According to an embodiment, the NFC wireless communication circuit 3201 may be accommodated in the first housing 3211 (see FIG. 32).

According to an embodiment, the NFC wireless communication circuit 3201 may be electrically connected to the first point P21 of the first metal E21 through a first feeding path 3801. For example, the first feeding path 3801 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a second feeding path 3802. For example, the second feeding path 3802 may include a combination of one or more conductive paths (or, conductors or conductive structures) (not separately illustrated) between the NFC wireless communication circuit 3201 and the second point P22 of the second metal E22.

According to an embodiment, the NFC wireless communication circuit 3201 may be electrically connected to the fifth point P25 of the third metal E23 through a third feeding path 3403. For example, the third feeding path 3403 may include a combination of one or more conductive paths (or, conductors or conductive structures) (not separately illustrated) between the NFC wireless communication circuit 3201 and the fifth point P25 of the third metal E23.

According to an embodiment, the NFC wireless communication circuit 3201 may be electrically connected to the sixth point P26 of the third metal E23 through a fourth feeding path 3404. For example, the fourth feeding path 3404 may include a combination of one or more conductive paths (or, conductors or conductive structures) (not separately illustrated) between the NFC wireless communication circuit 3201 and the sixth point P26 of the third metal E23.

According to an embodiment, the third point P23 of the first metal E21 may be electrically connected to the antenna ground G3 through the first ground path 3811. For example, the first ground path 3811 may include a combination (not separately illustrated) of one or more conductive paths (or, conductors or conductive structures) between the third point P23 of the first metal E21 and the first ground area G31 of the antenna ground G3.

According to an embodiment, the fourth point P24 of the second metal E22 may be electrically connected to the antenna ground G3 through the second ground path 3812. For example, the second ground path 3812 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the first metal E21 through the first feeding path 3801. At the time of positive feeding to the first feeding path 3801, a current (or radiation current) may flow on the first metal E21 from the first point P21 to the third point P23.

According to an embodiment, the NFC wireless communication circuit 3201 may provide (or feed) a -voltage to the second metal E22 through the second feeding path 3802. At the time of negative feeding to the second feeding path 3802, a current (or radiation current) may flow on the second metal E22 from the fourth point P24 to the second point P22.

According to an embodiment, the NFC wireless communication circuit 3201 may provide (or feed) a +voltage to the third metal E23 through the third feeding path 3403. The NFC wireless communication circuit 3201 may provide (or feed) a - voltage to the third metal E23 through the fourth feeding path 3404. At the time of positive feeding to the third feeding path 3403 and negative feeding to the fourth feeding path 3404, a current (or radiation current) may flow on the third metal E23 from the fifth point P25 to the sixth point P26.

According to an embodiment, when the multi-foldable electronic device 32 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 32 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (or the phase of current) (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 32 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 28 is in the folded state.

According to an embodiment, when the multi-foldable electronic device 32 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to various embodiments, on the first metal E21, the second metal E22, and the third metal E23 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 3001, a +voltage to the second feeding path 3002, a -voltage to the third feeding path 3003, and a +voltage to the fourth feeding path 3004.

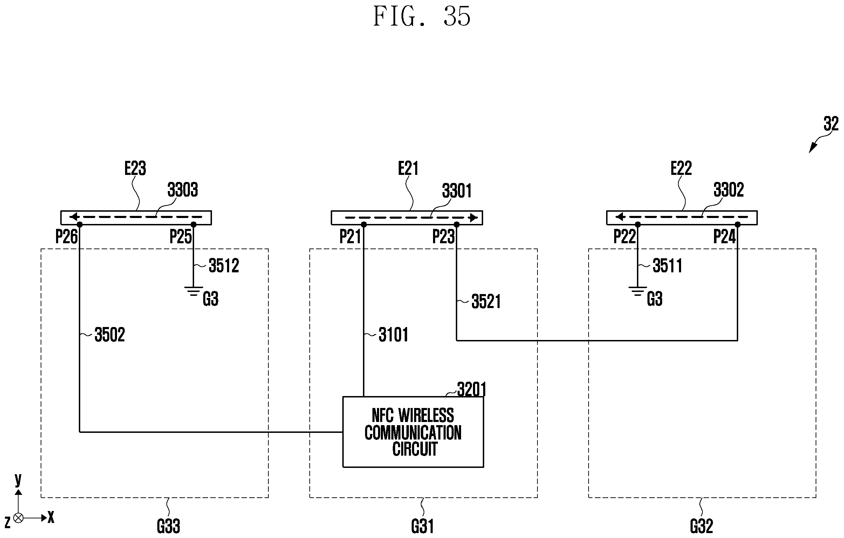

FIG. 35 is a view illustrating a multi-foldable electronic device 32 according to an embodiment of the disclosure in the unfolded state. It is to be understood that the disclosure conceives and includes all of the combinations of features and/or embodiments disclosed with reference to FIG. 35. That is, all of the combinations of features described below with reference to FIG. 35 are to be considered as being included in the disclosure as specific examples.

Referring to FIG. 35, the multi-foldable electronic device 32 may include a first metal E21, a second metal E22, a third metal E23, an antenna ground G3, and an NFC wireless communication circuit 3201.

According to an embodiment, the NFC wireless communication circuit 3201 may be accommodated in the first housing 3201 (see FIG. 32).

According to an embodiment, the NFC wireless communication circuit 3201 may be electrically connected to the first point P21 of the first metal E21 through a first feeding path 3501. For example, the first feeding path 3501 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the sixth point P26 of the third metal E23 through a second feeding path 3502. For example, the second feeding path 3502 may include a combination of one or more conductive paths (or, conductors or conductive structures) (not separately illustrated) between the NFC wireless communication circuit 3201 and the sixth point P26 of the third metal E23.

According to an embodiment, the second point P22 of the second metal E22 may be electrically connected to the antenna ground G3 through the first ground path 3511. For example, the first ground path 3511 may include a combination (not separately illustrated) of one or more conductive paths (or, conductors or conductive structures) between the second point P22 of the second metal E22 and the second ground area G32 of the antenna ground G3.

According to an embodiment, the fifth point P25 of the third metal E23 may be electrically connected to the antenna ground G3 through the second ground path 3512. For example, the second ground path 3512 may include a combination (not separately illustrated) of one or more conductive paths (or, conductors or conductive structures) between the fifth point P25 of the third metal E23 and the third ground area G33 of the antenna ground G3.

According to an embodiment, the third point P23 of the first metal E21 and the fourth point P24 of the second metal E22 may be electrically connected to each other through a connection path 3521. For example, the connection path 3521 may include a combination (not separately illustrated) of one or more conductive paths (or, conductors or conductive structures) between the third point P23 of the first metal E21 and the fourth point P24 of the second metal E22.

According to an embodiment, the NFC wireless communication circuit 3201 may provide (or feed) a +voltage to the first metal E21 through the first feeding path 3501. At the time of positive feeding to the first feeding path 3501, the current (or radiation current) may flow on the first metal E21 from the first point P21 to the third point P23, and may flow on the second metal E22 from the fourth point P24 to the second point P22.

According to an embodiment, the NFC wireless communication circuit 3201 may provide (or feed) a -voltage to the third metal E23 through the second feeding path 3502. At the time of negative feeding to the second feeding path 3 502, a current (or radiation current) may flow on the third metal E23 from the fifth point P25 to the sixth point P26.

According to an embodiment, when the multi-foldable electronic device 32 is in the folded state, at the time of feeding from the NFC wireless communication circuit 3201, a first current path (or first loop) including the first metal E21, a second current path (or second loop) including the second metal E22, and a third current path

(or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 32 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 32 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 32 is in the folded state.

According to an embodiment, when the multi-foldable electronic device 32 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to various embodiments, on the first metal E21, the second metal E22, and the third metal E23 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 3501 and a +voltage to the second feeding path 3502.

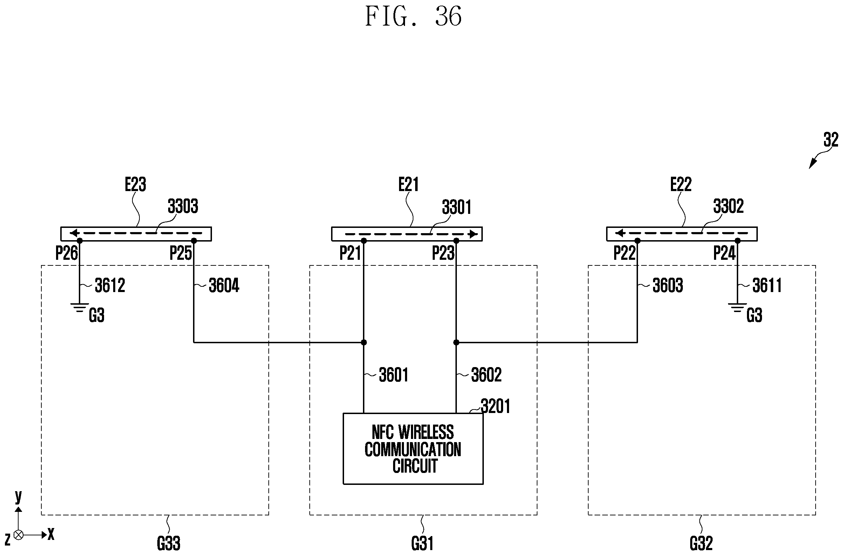

FIG. 36 is a view illustrating a multi-foldable electronic device 32 according to an embodiment of the disclosure in the unfolded state. It is to be understood that the disclosure conceives and includes all of the combinations of features and/or embodiments disclosed with reference to FIG. 36. That is, all of the combinations of features described below with reference to FIG. 36 are to be considered as being included in the disclosure as specific examples.

Referring to FIG. 36, the multi-foldable electronic device 32 may include a first metal E21, a second metal E22, a third metal E23, an antenna ground G3, and an NFC wireless communication circuit 3201.

According to an embodiment, the NFC wireless communication circuit 3201 may be accommodated in the first housing 3211 (see FIG. 32).

According to an embodiment, the NFC wireless communication circuit 3201 may be electrically connected to the first point P21 of the first metal E21 through a first feeding path 3601. For example, the first feeding path 3601 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the third point P23 of the first metal E21 through a second feeding path 3602. For example, the second feeding path 3602 may include a combination of one or more conductive paths (or, conductors or conductive structures) (not separately illustrated) between the NFC wireless communication circuit 3201 and the third point P23 of the first metal E21.

According to an embodiment, the NFC wireless communication circuit 3201 may be electrically connected to the second point P22 of the second metal E22 through a third feeding path 3603. For example, the third feeding path 3603 may include a combination of one or more conductive paths (or, conductors or conductive structures) (not separately illustrated) between the NFC wireless communication circuit 3201 and the second point P22 of the second metal E22.

According to an embodiment, the NFC wireless communication circuit 3201 may be electrically connected to the fifth point P25 of the third metal E23 through a fourth feeding path 3604. For example, the fourth feeding path 3604 may include a combination of one or more conductive paths (or, conductors or conductive structures) (not separately illustrated) between the NFC wireless communication circuit 3201 and the fifth point P25 of the third metal E23.

According to an embodiment, the fourth point P24 of the second metal E22 may be electrically connected to the antenna ground G3 through the first ground path 3611. For example, the first ground path 3611 may include a combination (not separately illustrated) of one or more conductive paths (or, conductors or conductive structures) between the fourth point P24 of the second metal E22 and the second ground area G32 of the antenna ground G3.

According to an embodiment, the sixth point P26 of the third metal E23 may be electrically connected to the antenna ground G3 through the second ground path 3612. For example, the second ground path 3612 may include a combination (not separately illustrated) of one or more conductive paths (or, conductors or conductive structures) between the sixth point P26 of the third metal E23 and the third ground area G33 of the antenna ground G3.

According to an embodiment, the NFC wireless communication circuit 3201 may provide (or feed) a +voltage to the first metal E21 through the first feeding path 3601. The NFC wireless communication circuit 3201 may provide (or feed) a - voltage to the first metal E21 through the second feeding path 3602. At the time of positive feeding to the first feeding path 3601 and negative feeding to the second feeding path 3602, a current (or radiation current) may flow on the first metal E21 from the first point P21 to the third point P23.

According to an embodiment, the NFC wireless communication circuit 3201 may provide (or feed) a -voltage to the second metal E22 through the third feeding path 3603. At the time of negative feeding to the third feeding path 3603, a current (or radiation current) may flow on the second metal E22 from the fourth point P24 to the second point P22.

According to an embodiment, the NFC wireless communication circuit 3201 may provide (or feed) a +voltage to the third metal E23 through the fourth feeding path 3604. At the time of positive feeding to the fourth feeding path 3604, a current (or radiation current) may flow on the third metal E23 from the fifth point P25 to the sixth point P26.

According to an embodiment, when the multi-foldable electronic device 32 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 32 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 32 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 32 is in the folded state.

According to an embodiment, when the multi-foldable electronic device 32 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to an embodiment, the positive feeding to the first feeding path 3601 and the negative feeding to the second feeding path 3602 for the first metal E21 may relatively improve, compared to that in the first direction (e.g., the +z-axis direction in FIG. 33) in which the display area of the second display module 3230 (see FIG. 32) is oriented, NFC radiation performance in the second direction (e.g., the -z-axis direction in FIG. 33) opposite to the first direction when the multi-foldable electronic device 32 is in the folded state.

According to various embodiments, on the first metal E21, the second metal E22, and the third metal E23 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 3601 and a +voltage to the second feeding path 3602.

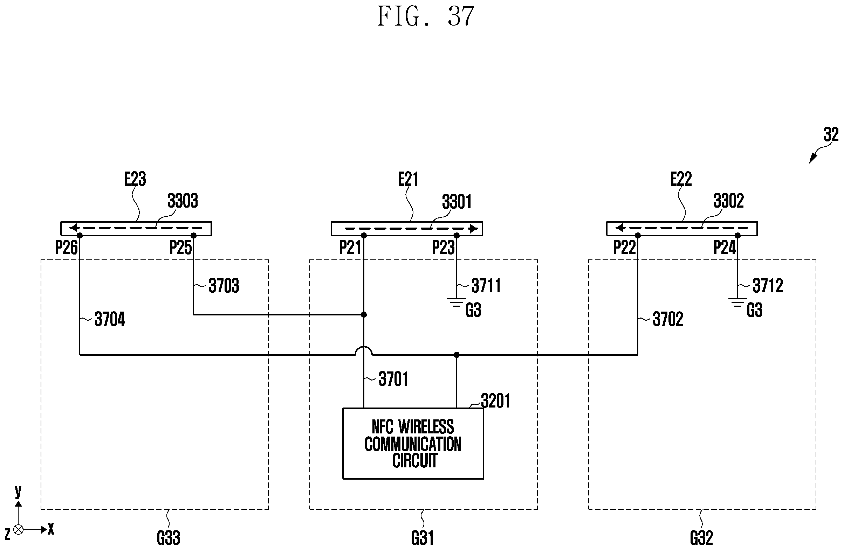

FIG. 37 is a view illustrating a multi-foldable electronic device 32 according to an embodiment of the disclosure in the unfolded state. It is to be understood that the disclosure conceives and includes all of the combinations of features and/or embodiments disclosed with reference to FIG. 37. That is, all of the combinations of features described below with reference to FIG. 37 are to be considered as being included in the disclosure as specific examples.

Referring to FIG. 37, the multi-foldable electronic device 32 may include a first metal E21, a second metal E22, a third metal E23, an antenna ground G3, and an NFC wireless communication circuit 3201.

According to an embodiment, the NFC wireless communication circuit 3201 may be accommodated in the first housing 3211 (see FIG. 32).

According to an embodiment, the NFC wireless communication circuit 3201 may be electrically connected to the first point P21 of the first metal E21 through a first feeding path 3701. For example, the first feeding path 3701 may include a combination of one or more conductive paths (or, as conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a second feeding path 3702. For example, the second feeding path 3702 may include a combination of one or more conductive paths (or, as conductors or conductive structures) (not separately illustrated) between the NFC wireless communication circuit 3201 and the second point P22 of the second metal E22.

According to an embodiment, the NFC wireless communication circuit 3201 may be electrically connected to the fifth point P25 of the third metal E23 through a portion of the first feeding path 3701 and a third feeding path 3703. For example, the third feeding path 3703 may include a combination of one or more conductive paths (or, conductors or conductive structures) (not separately illustrated) between the first feeding path 3701 and the fifth point P25 of the third metal E23.

According to an embodiment, the NFC wireless communication circuit 3201 may be electrically connected to the sixth point P26 of the third metal E23 through a fourth feeding path 3704. For example, the fourth feeding path 3704 may include a combination of one or more conductive paths (or, conductors or conductive structures) (not separately illustrated) between the NFC wireless communication circuit 3201 and the sixth point P26 of the third metal E23.

According to an embodiment, the third point P23 of the first metal E21 may be electrically connected to the antenna ground G3 through the first ground path 3711. For example, the first ground path 3711 may include a combination (not separately illustrated) of one or more conductive paths (or, conductors or conductive structures) between the third point P23 of the first metal E21 and the first ground area G31 of the antenna ground G3.

According to an embodiment, the fourth point P24 of the second metal E22 may be electrically connected to the antenna ground G3 through the second ground path 3712. For example, the second ground path 3712 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the first metal E21 through the first feeding path 3701. At the time of positive feeding to the first feeding path 3701, a current (or radiation current) may flow on the first metal E21 from the first point P21 to the third point P23.

According to an embodiment, the NFC wireless communication circuit 3201 may provide (or feed) a -voltage to the second metal E22 through the second feeding path 3702. At the time of negative feeding to the second feeding path 3702, a current (or radiation current) may flow on the second metal E22 from the fourth point P24 to the second point P22.

According to an embodiment, the NFC wireless communication circuit 3201 may provide (or feed) a +voltage to the third metal E23 through the third feeding path 3703. The NFC wireless communication circuit 3201 may provide (or feed) a - voltage to the third metal E23 through the fourth feeding path 3704. At the time of positive feeding to the third feeding path 3703 and negative feeding to the fourth feeding path 3704, a current (or radiation current) may flow on the third metal E23 from the fifth point P25 to the sixth point P26.

According to an embodiment, when the multi-foldable electronic device 32 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 32 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 32 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 32 is in the folded state.

According to an embodiment, when the multi-foldable electronic device 32 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to an embodiment, the positive feeding to the third feeding path 3703 and the negative feeding to the fourth feeding path 3704 for the third metal E23 may reduce a difference between the NFC radiation performance in a first direction (e.g., the +z-axis direction in FIG. 33) in which the display area of the second display module 3230 (see FIG. 32) is oriented and the NFC radiation performance in a second direction (e.g., the -z-axis direction in FIG. 33) opposite to the first direction when the multi-foldable electronic device 32 is in the folded state.

According to various embodiments, on the first metal E21, the second metal E22, and the third metal E23 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 3701 and the third feeding path 3703 and a +voltage to the second feeding path 3702 and the fourth feeding path 3704.

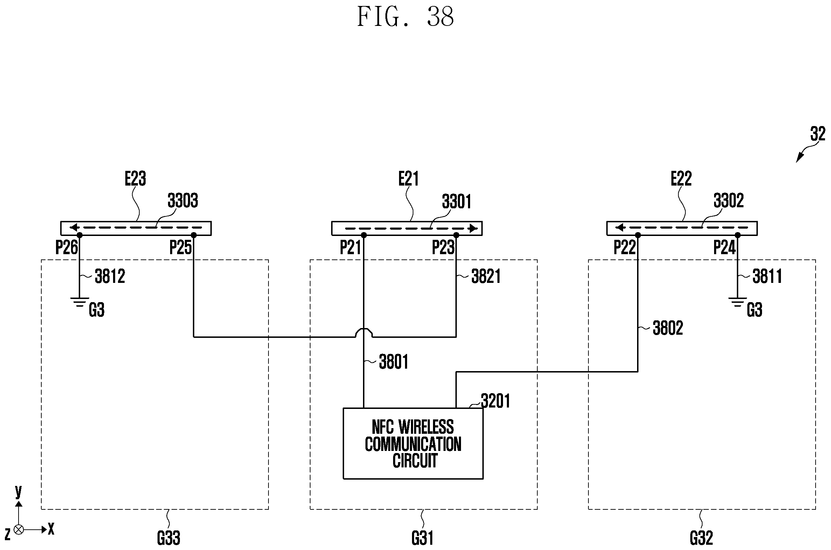

FIG. 38 is a view illustrating a multi-foldable electronic device 28 according to an embodiment of the disclosure in the unfolded state. It is to be understood that the disclosure conceives and includes all of the combinations of features and/or embodiments disclosed with reference to FIG. 38. That is, all of the combinations of features described below with reference to FIG. 38 are to be considered as being included in the disclosure as specific examples.

Referring to FIG. 38, the multi-foldable electronic device 32 may include a first metal E21, a second metal E22, a third metal E23, an antenna ground G3, and an NFC wireless communication circuit 3201.

According to an embodiment, the NFC wireless communication circuit 3201 may be accommodated in the first housing 3211 (see FIG. 32).

According to an embodiment, the NFC wireless communication circuit 3201 may be electrically connected to the first point P21 of the first metal E21 through a first feeding path 3801. For example, the first feeding path 3801 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a second feeding path 3802. For example, the second feeding path 3802 may include a combination of one or more conductive paths (or, conductors or conductive structures) (not separately illustrated) between the NFC wireless communication circuit 3201 and the second point P22 of the second metal E22.

According to an embodiment, the fourth point P24 of the second metal E22 may be electrically connected to the antenna ground G3 through the first ground path 3811. For example, the first ground path 3811 may include a combination (not separately illustrated) of one or more conductive paths (or, conductors or conductive structures) between the fourth point P24 of the second metal E22 and the second ground area G32 of the antenna ground G3.

According to an embodiment, the sixth point P26 of the third metal E23 may be electrically connected to the antenna ground G3 through the second ground path 3812. For example, the second ground path 3812 may include a combination (not separately illustrated) of one or more conductive paths (or, conductors or conductive structures) between the sixth point P26 of the third metal E23 and the third ground area G33 of the antenna ground G3.

According to an embodiment, the third point P23 of the first metal E21 and the fifth point P25 of the third metal E23 may be electrically connected to each other through a connection path 3821. For example, the connection path 3821 may include a combination (not separately illustrated) of one or more conductive paths (or, conductors or conductive structures) between the third point P23 of the first metal E21 and the fifth point P25 of the third metal E23.

According to an embodiment, the NFC wireless communication circuit 3201 may provide (or feed) a +voltage to the first metal E21 through the first feeding path 3801. At the time of positive feeding to the first feeding path 3801, the current (or radiation current) may flow on the first metal E21 from the first point P21 to the third point P23, and may flow on the third metal E23 from the fifth point P25 to the sixth point P26.

According to an embodiment, the NFC wireless communication circuit 3201 may provide (or feed) a -voltage to the second metal E22 through the second feeding path 3802. At the time of negative feeding to the second feeding path 3802, a current (or radiation current) may flow on the second metal E22 from the fourth point P24 to the second point P22.

According to an embodiment, when the multi-foldable electronic device 32 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 32 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 32 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 32 is in the folded state.

According to an embodiment, when the multi-foldable electronic device 32 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to various embodiments, on the first metal E21, the second metal E22, and the third metal E23 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 3801 and a +voltage to the second feeding path 3802.

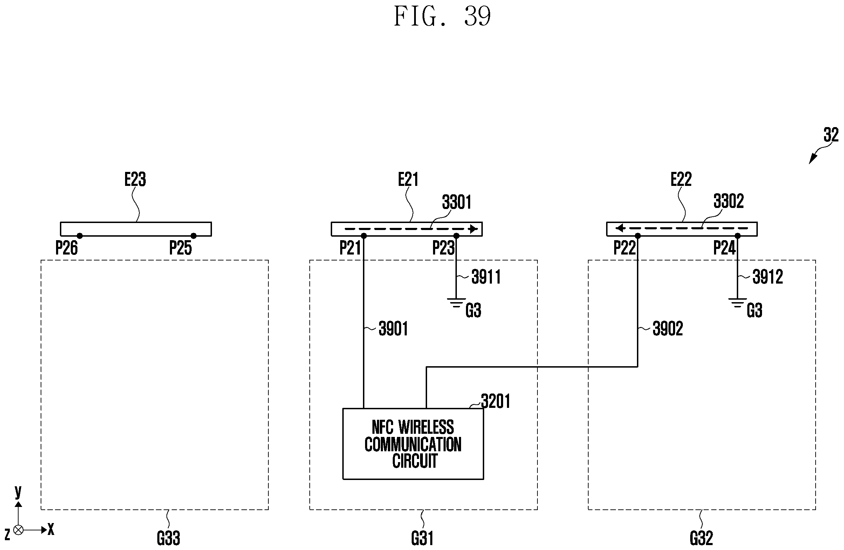

FIG. 39 is a view illustrating a multi-foldable electronic device 32 according to an embodiment of the disclosure in the unfolded state. It is to be understood that the disclosure conceives and includes all of the combinations of features and/or embodiments disclosed with reference to FIG. 38. That is, all of the combinations of features described below with reference to FIG. 38 are to be considered as being included in the disclosure as specific examples.

Referring to FIG. 39, the multi-foldable electronic device 32 may include a first metal E21, a second metal E22, a third metal E23, an antenna ground G3, and an NFC wireless communication circuit 3201.

According to an embodiment, the NFC wireless communication circuit 3201 may be accommodated in the first housing 3211 (see FIG. 28).

According to an embodiment, the NFC wireless communication circuit 3201 may be electrically connected to the first point P21 of the first metal E21 through a first feeding path 3901. For example, the first feeding path 3901 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a second feeding path 3902. For example, the second feeding path 3902 may include a combination of one or more conductive paths (or, conductors or conductive structures) (not separately illustrated) between the NFC wireless communication circuit 3201 and the second point P22 of the second metal E22.

According to an embodiment, the third point P23 of the first metal E21 may be electrically connected to the antenna ground G3 through the first ground path 3911. For example, the first ground path 3911 may include a combination (not separately illustrated) of one or more conductive paths (or, conductors or conductive structures) between the third point P23 of the first metal E21 and the first ground area G31 of the antenna ground G3.

According to an embodiment, the fourth point P24 of the second metal E22 may be electrically connected to the antenna ground G3 through the second ground path 3912. For example, the second ground path 3912 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the first metal E21 through the first feeding path 3901. At the time of positive feeding to the first feeding path 3901, a current (or radiation current) may flow on the first metal E21 from the first point P21 to the third point P23.

According to an embodiment, the NFC wireless communication circuit 3201 may provide (or feed) a -voltage to the second metal E22 through the second feeding path 3902. At the time of negative feeding to the second feeding path 3902, a current (or radiation current) may flow on the second metal E22 from the fourth point P24 to the second point P22.

According to an embodiment, when the multi-foldable electronic device 32 is in the folded state, at the time of feeding from the NFC wireless communication circuit 3201, a first current path (or first loop) including the first metal E21 and a second current path (or second loop) including the second metal E22 may be formed as a coil (or coil-shaped loop). The first current path may provide (or form) a first turn of the coil. The second current path may provide (or form) a second turn of the coil. When the multi-foldable electronic device 32 is in the folded state, the coil formed by the combination of the first turn of the first current path and the second turn of the second current path may improve radiation performance by generating an electromagnetic field that is a composite of the first electromagnetic field generated through the first current path and the second electromagnetic field generated through the second current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (3301) and the direction in which the current flows on the second metal E22 from the fourth point P24 to the second point P22 (3302) may be substantially the same. When the currents are caused to flow in substantially the same direction on the first metal E21 and the second metal E22 which are aligned with and overlap each other when the multi-foldable electronic device 32 is in the folded state, it is possible to improve radiation performance by generating an electromagnetic field with a relatively high intensity of electromagnetic force, compared to the case where the currents are caused to flow in opposite directions (e.g., reverse directions) on the first metal E21 and the second metal E22 which are aligned with and overlap each other when the multi-foldable electronic device 32 is in the folded state.

According to an embodiment, when the multi-foldable electronic device 32 is in the folded state, at the time of feeding from the NFC wireless communication circuit 3201, the phase of the current (or radiation current) flowing on the first metal E21 and the phase of the current flowing on the second metal E22 may be substantially the same. When the phases of the currents flowing on the first metal E21 and the second metal E22, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on the first metal E21 and the second metal E22, which are aligned with and overlapped each other when the multi-foldable electronic device 32 is in the folded state, different from each other.

According to various embodiments, on the first metal E21 and the second metal E22 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 3901 and a +voltage to the second feeding path 3902.

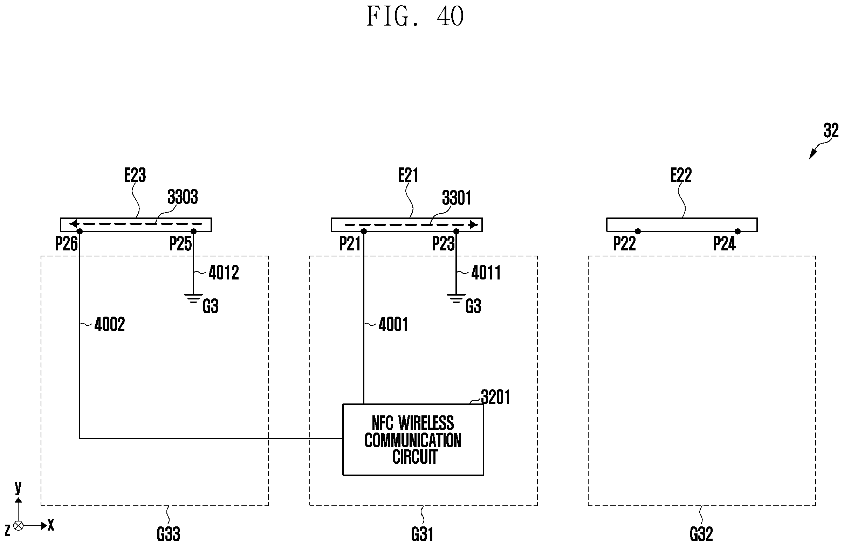

FIG. 40 is a view illustrating a multi-foldable electronic device 32 according to an embodiment of the disclosure in the unfolded state. It is to be understood that the disclosure conceives and includes all of the combinations of features and/or embodiments disclosed with reference to FIG. 40. That is, all of the combinations of features described below with reference to FIG. 40 are to be considered as being included in the disclosure as specific examples.

Referring to FIG. 40, the multi-foldable electronic device 32 may include a first metal E21, a second metal E22, a third metal E23, an antenna ground G3, and an NFC wireless communication circuit 3201.

According to an embodiment, the NFC wireless communication circuit 3201 may be accommodated in the first housing 3211 (see FIG. 32).

According to an embodiment, the NFC wireless communication circuit 3201 may be electrically connected to the first point P21 of the first metal E21 through a first feeding path 4001. For example, the first feeding path 4001 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the sixth point P26 of the third metal E23 through a second feeding path 4002. For example, the second feeding path 4002 may include a combination of one or more conductive paths (or, conductors or conductive structures) (not separately illustrated) between the NFC wireless communication circuit 3201 and the sixth point P26 of the third metal E23.

According to an embodiment, the third point P23 of the first metal E21 may be electrically connected to the antenna ground G3 through the first ground path 4011. For example, the first ground path 4011 may include a combination (not separately illustrated) of one or more conductive paths (or, conductors or conductive structures) between the third point P23 of the first metal E21 and the first ground area G31 of the antenna ground G3.

According to an embodiment, the fifth point P25 of the third metal E23 may be electrically connected to the antenna ground G3 through the second ground path 4012. For example, the second ground path 4012 may include a combination (not separately illustrated) of one or more conductive paths (or, conductors or conductive structures) between the fifth point P25 of the third metal E23 and the third ground area G33 of the antenna ground G3.

According to an embodiment, the NFC wireless communication circuit 3201 may provide (or feed) a +voltage to the first metal E21 through the first feeding path 4001. At the time of positive feeding to the first feeding path 4001, a current (or radiation current) may flow on the first metal E21 from the first point P21 to the third point P23.

According to an embodiment, the NFC wireless communication circuit 3201 may provide (or feed) a -voltage to the third metal E23 through the second feeding path 4002. At the time of negative feeding to the second feeding path 4002, a current (or radiation current) may flow on the third metal E23 from the fifth point P25 to the sixth point P26.

According to an embodiment, when the multi-foldable electronic device 32 is in the folded state, at the time of feeding from the NFC wireless communication circuit 3201, a first current path (or first loop) including the first metal E21 and a third current path (or second loop) including the third metal E23 may be formed as a coil (or coil-shaped loop). The first current path may provide (or form) a first turn of the coil. The third current path may provide (or form) a third turn of the coil. When the multi-foldable electronic device 32 is in the folded state, the coil formed by the combination of the first turn of the first current path and the third turn of the third current path may improve radiation performance by generating an electromagnetic field that is a composite of the electromagnetic field generated through the first current path and the third electromagnetic field generated through the third current path.

According to an embodiment, when the multi-foldable electronic device 32 is in the folded state, at the time of feeding from the NFC wireless communication circuit 3201, the direction in which the current (or radiation current) flows on the first metal E21 from the first point P21 to the third point P23 (3301) and the direction in which the current flows on the third metal E23 from the fifth point P25 to the sixth point P26 (3303) may be substantially the same. When the currents are caused to flow in substantially the same direction on the first metal E21 and the third metal E23 which are aligned with and overlap each other when the multi-foldable electronic device 32 is in the folded state, it is possible to improve radiation performance by generating an electromagnetic field with a relatively high intensity of electromagnetic force, compared to the case where the currents are caused to flow in opposite directions (e.g., reverse directions) on the first metal E21 and the third metal E23 which are aligned with and overlap each other when the multi-foldable electronic device 32 is in the folded state.

According to an embodiment, when the multi-foldable electronic device 32 is in the folded state, at the time of feeding from the NFC wireless communication circuit 3201, the phase of the current (or radiation current) flowing on the first metal E21 and the phase of the current flowing on the third metal E23 may be substantially the same. When the phases of the currents flowing on the first metal E21 and the third metal E23, which are aligned with and overlapped each other when the multi-foldable electronic device 32 is in the folded state, are made to be the same, radiation performance can be improved by generating an electromagnetic field with relatively high electromagnetic force, compared to making the phases of currents flowing on the first metal E21 and the third metal E23, which are aligned with and overlapped each other when the multi-foldable electronic device 32 is in the folded state, different from each other.

According to various embodiments, on the first metal E21 and the second metal E22 which are aligned with and overlap each other when the multi-foldable electronic device 32 is in the folded state, the currents (or radiation currents) may flow in the same direction that is opposite to the direction illustrated in FIG. 33. For example, the NFC wireless communication circuit 3201 may be configured to provide (or feed) a -voltage to the first feeding path 4001 and a +voltage to the second feeding path 4002.

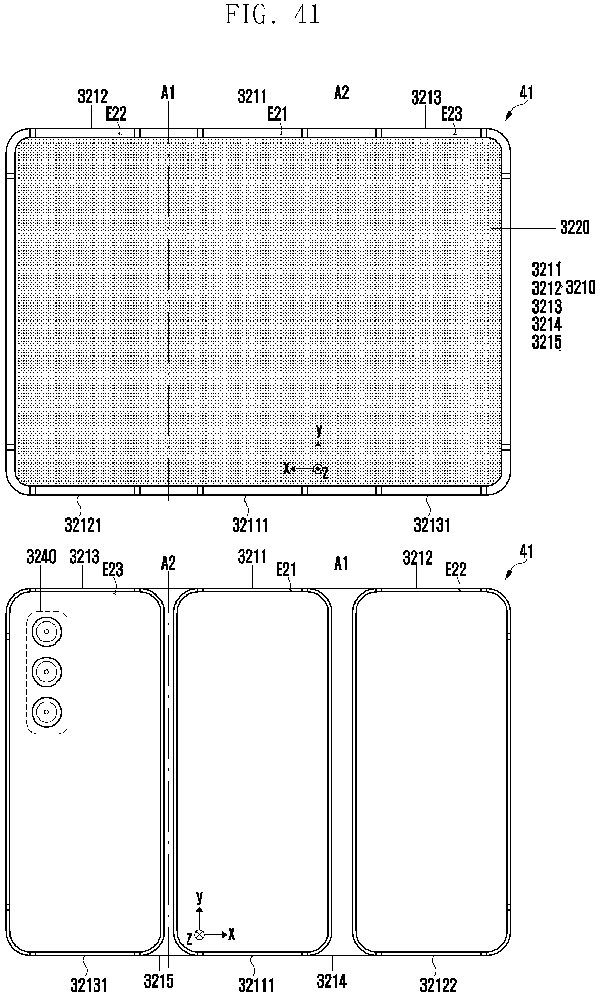

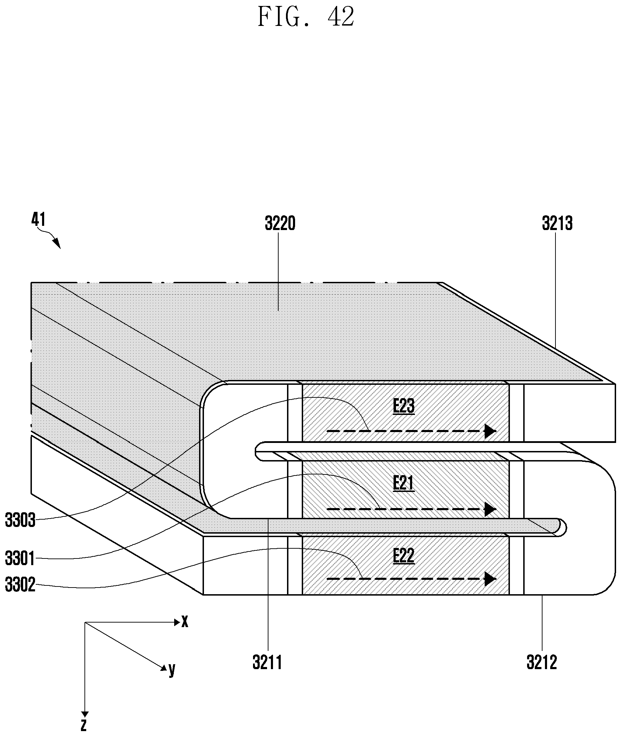

FIG. 41 is a view illustrating a multi-foldable electronic device 41 according to an embodiment of the disclosure in the unfolded state. FIG. 42 is a perspective view of the multi-foldable electronic device 42 according to an embodiment of the disclosure in the folded state. It is to be understood that the disclosure conceives and includes all of the combinations of features and/or embodiments disclosed with reference to FIGS. 41 and 42. That is, all of the combinations of features described below with reference to FIGS. 41 and 42 are to be considered as being included in the disclosure as specific examples.

Referring to FIGS. 41 and 42, the multi-foldable electronic device41 may include a foldable housing 3210, a first display module 3220, and/or a plurality of camera modules 3240.

According to an embodiment, the foldable housing 3210 may include a first housing 3211, a second housing 3212, a third housing 3213, a first hinge portion 3214, and/or a second hinge portion 3215. The foldable housing 3210 may be implemented to be foldable such that the first housing 3211 is located between the first housing 3212 and the third housing 3212 when the multi-foldable electronic device 41 is in the folded state.

According to an embodiment, the plurality of camera modules 3240 may be located in the third housing 3213. The plurality of camera modules 3240 may face in a direction opposite to the third display area of the first display module 3220.

According to an embodiment, the multi-foldable electronic device 41 may be configured to transmit and/or receive a signal in the NFC band through the first metal E21 included in the first side 32111 of the first housing 3211, the second metal E22 included in the second side 32121 of the second housing 3212, and the third metal E23 included in the third side 28131 of the third housing 3213.

According to an embodiment, when the multi-foldable electronic device 41 is in the folded state, at the time of feeding from the NFC wireless communication circuit, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 41 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 41 is in the folded state, at the time of feeding from the NFC wireless communication circuit, the direction in which the current (or radiation current) flows on the first metal E21 (3301), the direction in which the current flows on the second metal E22 (3302), and the direction in which the current flows on the third metal E23 (3303) may be substantially the same. On the first metal E21, the second metal E22, and the third metal E23 which are aligned with and overlap each other when the multi-foldable electronic device 41 is in the folded state, the currents (or radiation currents) may flow in the same direction that is opposite to the illustrated direction. When the currents are caused to flow in substantially the same direction on the first metal E21, the second E22, and the third metal E23 which are aligned with and overlap each other when the multi-foldable electronic device 41 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 37 is in the folded state.

According to an embodiment, when the multi-foldable electronic device 41 is in the folded state, at the time of feeding from the NFC wireless communication circuit, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 32 is in the folded state, different from each other.

According to various embodiments, the technical features of the disclosure are applicable to a multi-foldable electronic device (not separately illustrated) in which a screen (or a flexible display) can be folded three or more times.

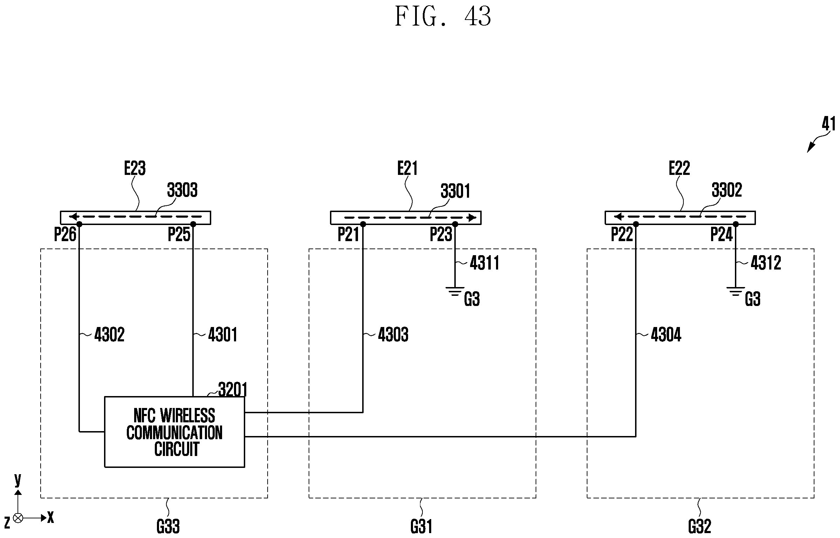

FIG. 43 is a view illustrating a multi-foldable electronic device 41 according to an embodiment of the disclosure in the unfolded state. It is to be understood that the disclosure conceives and includes all of the combinations of features and/or embodiments disclosed with reference to FIG. 43. That is, all of the combinations of features described below with reference to FIG. 43 are to be considered as being included in the disclosure as specific examples.

Referring to FIG. 43, the multi-foldable electronic device 41 may include a first metal E21, a second metal E22, a third metal E23, an antenna ground G3, and an NFC wireless communication circuit 3201.

According to an embodiment, the NFC wireless communication circuit 3201 may be accommodated in the third housing 3213 (see FIG. 41).

According to an embodiment, the NFC wireless communication circuit 3201 may be electrically connected to the fifth point P25 of the third metal E23 through a first feeding path 4301. For example, the first feeding path 4301 may include a combination of one or more conductive paths (or, conductors or conductive structures) (not separately illustrated) between the NFC wireless communication circuit 3201 and the fifth point P25 of the third metal E23.

According to an embodiment, the NFC wireless communication circuit 3201 may be electrically connected to the sixth point P26 of the third metal E23 through a second feeding path 4302. For example, the second feeding path 4302 may include a combination of one or more conductive paths (or, conductors or conductive structures) (not separately illustrated) between the NFC wireless communication circuit 3201 and the sixth point P26 of the third metal E23.

According to an embodiment, the NFC wireless communication circuit 3201 may be electrically connected to the first point P21 of the first metal E21 through a third feeding path 4303. For example, the third feeding path 4303 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a fourth feeding path 4304. For example, the fourth feeding path 4304 may include a combination of one or more conductive paths (or, conductors or conductive structures) (not separately illustrated) between the NFC wireless communication circuit 3201 and the second point P22 of the second metal E22.

According to an embodiment, the third point P23 of the first metal E21 may be electrically connected to the antenna ground G3 through the first ground path 4311. For example, the first ground path 4311 may include a combination (not separately illustrated) of one or more conductive paths (or, conductors or conductive structures) between the third point P23 of the first metal E21 and the first ground area G31 of the antenna ground G3.

According to an embodiment, the fourth point P24 of the second metal E22 may be electrically connected to the antenna ground G3 through the second ground path 4312. For example, the second ground path 4312 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the third metal E23 through the first feeding path 4301. The NFC wireless communication circuit 3201 may provide (or feed) a - voltage to the third metal E23 through the second feeding path 4302. At the time of positive feeding to the first feeding path 4301 and negative feeding to the second feeding path 4302, a current (or radiation current) may flow on the third metal E23 from the fifth point P25 to the sixth point P26.

According to an embodiment, the NFC wireless communication circuit 3201 may provide (or feed) a +voltage to the first metal E21 through the third feeding path 4303. At the time of positive feeding to the third feeding path 4303, a current (or radiation current) may flow on the first metal E21 from the first point P21 to the third point P23.

According to an embodiment, the NFC wireless communication circuit 3201 may provide (or feed) a -voltage to the second metal E22 through the fourth feeding path 4304. At the time of negative feeding to the fourth feeding path 4304, a current (or radiation current) may flow on the second metal E22 from the fourth point P24 to the second point P22.

According to an embodiment, when the multi-foldable electronic device 41 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 41 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 41 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 41 is in the folded state.

According to an embodiment, when the multi-foldable electronic device 41 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 41 is in the folded state, different from each other.

According to various embodiments, on the first metal E21, the second metal E22, and the third metal E23 which are aligned with and overlap each other when the multi-foldable electronic device 41 is in the folded state, the currents (or radiation currents) may flow in the same direction that is opposite to the direction illustrated in FIG. 42. For example, the NFC wireless communication circuit 3201 may be configured to provide (or feed) a -voltage to the first feeding path 4301, a +voltage to the second feeding path 4302, a -voltage to the third feeding path 4303, and a +voltage to the fourth feeding path 4304.

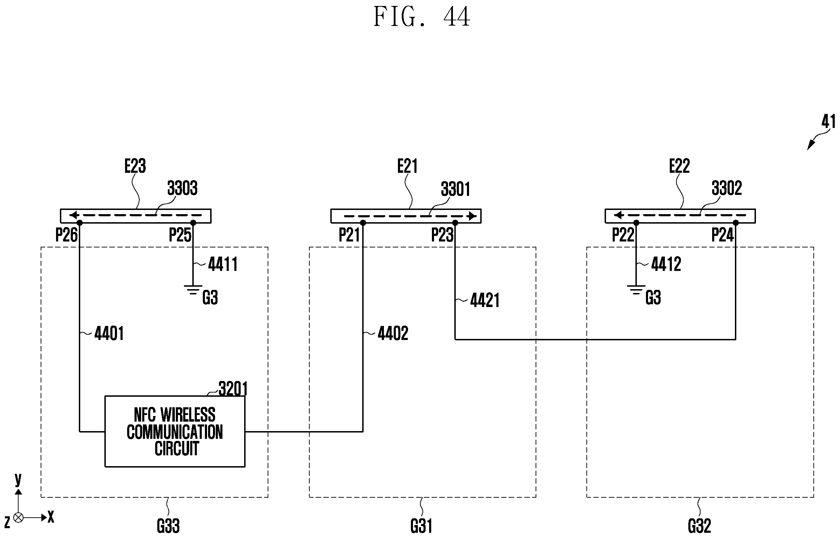

FIG. 44 is a view illustrating a multi-foldable electronic device 41 according to an embodiment of the disclosure in the unfolded state. It is to be understood that the disclosure conceives and includes all of the combinations of features and/or embodiments disclosed with reference to FIG. 44. That is, all of the combinations of features described below with reference to FIG. 44 are to be considered as being included in the disclosure as specific examples.

Referring to FIG. 44, the multi-foldable electronic device 37 may include a first metal E21, a second metal E22, a third metal E23, an antenna ground G3, and an NFC wireless communication circuit 3201.

According to an embodiment, the NFC wireless communication circuit 3201 may be accommodated in the third housing 3211 (see FIG. 41).

According to an embodiment, the NFC wireless communication circuit 3201 may be electrically connected to the sixth point P26 of the third metal E23 through a first feeding path 4401. For example, the first feeding path 4401 may include a combination of one or more conductive paths (or, conductors or conductive structures) (not separately illustrated) between the NFC wireless communication circuit 3201 and the sixth point P26 of the third metal E23.

According to an embodiment, the NFC wireless communication circuit 3201 may be electrically connected to the first point P21 of the first metal E21 through a second feeding path 4402. For example, the second feeding path 4402 may include a combination of one or more conductive paths (or, conductors or conductive structures) (not separately illustrated) between the NFC wireless communication circuit 3201 and the first point P21 of the first metal E21.

According to an embodiment, the fifth point P25 of the third metal E23 may be electrically connected to the antenna ground G3 through the first ground path 4411. For example, the first ground path 4411 may include a combination (not separately illustrated) of one or more conductive paths (or, conductors or conductive structures) between the fifth point P25 of the third metal E23 and the third ground area G33 of the antenna ground G3.

According to an embodiment, the second point P22 of the second metal E22 may be electrically connected to the antenna ground G3 through the second ground path 4412. For example, the second ground path 4412 may include a combination (not separately illustrated) of one or more conductive paths (or, conductors or conductive structures) between the second point P22 of the second metal E22 and the second ground area G32 of the antenna ground G3.

According to an embodiment, the third point P23 of the first metal E21 and the fourth point P24 of the second metal E22 may be electrically connected to each other through a connection path 4421. For example, the connection path 4421 may include a combination (not separately illustrated) of one or more conductive paths (or, conductors or conductive structures) between the third point P23 of the first metal E21 and the fourth point P24 of the second metal E22.

According to an embodiment, the NFC wireless communication circuit 3201 may provide (or feed) a -voltage to the third metal E23 through the first feeding path 4401. At the time of negative feeding to the first feeding path 4401, a current (or radiation current) may flow on the third metal E23 from the fifth point P25 to the sixth point P26.

According to an embodiment, the NFC wireless communication circuit 3201 may provide (or feed) a +voltage to the first metal E21 through the second feeding path 4402. At the time of positive feeding to the second feeding path 4402, the current (or radiation current) may flow on the first metal E21 from the first point P21 to the third point P23, and may flow on the second metal E22 from the fourth point P24 to the second point P22.

According to an embodiment, when the multi-foldable electronic device 41 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 41 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 41 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 41 is in the folded state.

According to an embodiment, when the multi-foldable electronic device 41 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 41 is in the folded state, different from each other.

According to various embodiments, on the first metal E21, the second metal E22, and the third metal E23 which are aligned with and overlap each other when the multi-foldable electronic device 41 is in the folded state, the currents (or radiation currents) may flow in the same direction that is opposite to the direction illustrated in FIG. 37. For example, the NFC wireless communication circuit 3201 may be configured to provide (or feed) a -voltage to the first feeding path 4401 and a +voltage to the second feeding path 4402.

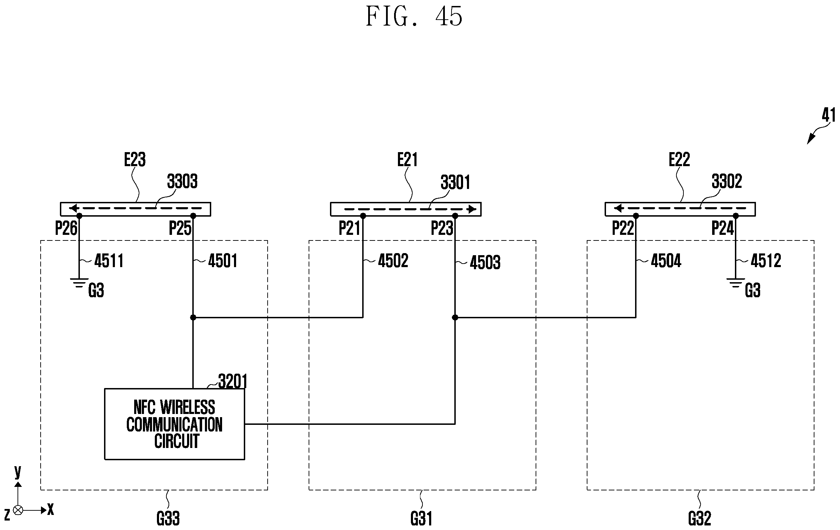

FIG. 45 is a view illustrating a multi-foldable electronic device 41 according to an embodiment of the disclosure in the unfolded state. It is to be understood that the disclosure conceives and includes all of the combinations of features and/or embodiments disclosed with reference to FIG. 45. That is, all of the combinations of features described below with reference to FIG. 45 are to be considered as being included in the disclosure as specific examples.

Referring to FIG. 45, the multi-foldable electronic device 41 may include a first metal E21, a second metal E22, a third metal E23, an antenna ground G3, and an NFC wireless communication circuit 3201.

According to an embodiment, the NFC wireless communication circuit 3201 may be accommodated in the third housing 3213 (see FIG. 41).

According to an embodiment, the NFC wireless communication circuit 3201 may be electrically connected to the fifth point P25 of the third metal E23 through a first feeding path 4501. For example, the first feeding path 4501 may include a combination of one or more conductive paths (or, conductors or conductive structures) (not separately illustrated) between the NFC wireless communication circuit 3201 and the fifth point P25 of the third metal E23.

According to an embodiment, the NFC wireless communication circuit 3201 may be electrically connected to the first point P21 of the first metal E21 through a second feeding path 4502. For example, the second feeding path 4502 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the third point P23 of the first metal E21 through a third feeding path 4503. For example, the third feeding path 4503 may include a combination of one or more conductive paths (or, conductors or conductive structures) (not separately illustrated) between the NFC wireless communication circuit 3201 and the third point P23 of the first metal E21.

According to an embodiment, the NFC wireless communication circuit 3201 may be electrically connected to the second point P22 of the second metal E22 through a fourth feeding path 4504. For example, the fourth feeding path 4504 may include a combination of one or more conductive paths (or, conductors or conductive structures) (not separately illustrated) between the NFC wireless communication circuit 3201 and the second point P22 of the second metal E22.

According to an embodiment, the sixth point P26 of the third metal E23 may be electrically connected to the antenna ground G3 through the first ground path 4511. For example, the first ground path 4511 may include a combination (not separately illustrated) of one or more conductive paths (or, conductors or conductive structures) between the sixth point P26 of the third metal E23 and the third ground area G33 of the antenna ground G3.

According to an embodiment, the fourth point P24 of the second metal E22 may be electrically connected to the antenna ground G3 through the second ground path 4512. For example, the second ground path 4512 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the third metal E23 through the first feeding path 4501. At the time of positive feeding to the first feeding path 4501, a current (or radiation current) may flow on the third metal E23 from the fifth point P25 to the sixth point P26.

According to an embodiment, the NFC wireless communication circuit 3201 may provide (or feed) a +voltage to the first metal E21 through the second feeding path 4502. The NFC wireless communication circuit 3201 may provide (or feed) a -voltage to the first metal E21 through the third feeding path 4503. At the time of positive feeding to the first feeding path 4502 and negative feeding to the third feeding path 4503, a current (or radiation current) may flow on the first metal E21 from the first point P21 to the third point P23.

According to an embodiment, the NFC wireless communication circuit 3201 may provide (or feed) a -voltage to the second metal E22 through the fourth feeding path 4504. At the time of negative feeding to the fourth feeding path 4504, a current (or radiation current) may flow on the second metal E22 from the fourth point P24 to the second point P22.

According to an embodiment, when the multi-foldable electronic device 41 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 41 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 41 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 41 is in the folded state.

According to an embodiment, when the multi-foldable electronic device 41 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 41 is in the folded state, different from each other.

According to an embodiment, the positive feeding to the second feeding path 4502 and the negative feeding to the third feeding path 4503 for the first metal E21 may reduce a difference between the NFC radiation performance in a second direction (e.g., the -z-axis direction in FIG. 41) in which the third display area of the first display module 3220 is oriented and the NFC radiation performance in a first direction (e.g., the +z-axis direction in FIG. 41) opposite to the second direction when the multi-foldable electronic device 41 is in the folded state.

According to various embodiments, on the first metal E21, the second metal E22, and the third metal E23 which are aligned with and overlap each other when the multi-foldable electronic device 41 is in the folded state, the currents (or radiation currents) may flow in the same direction that is opposite to the direction illustrated in FIG. 41. For example, the NFC wireless communication circuit 3201 may be configured to provide (or feed) a -voltage to the first feeding path 4501, a -voltage to the second feeding path 4502, a +voltage to the third feeding path 4503, and a +voltage to the fourth feeding path 4504.

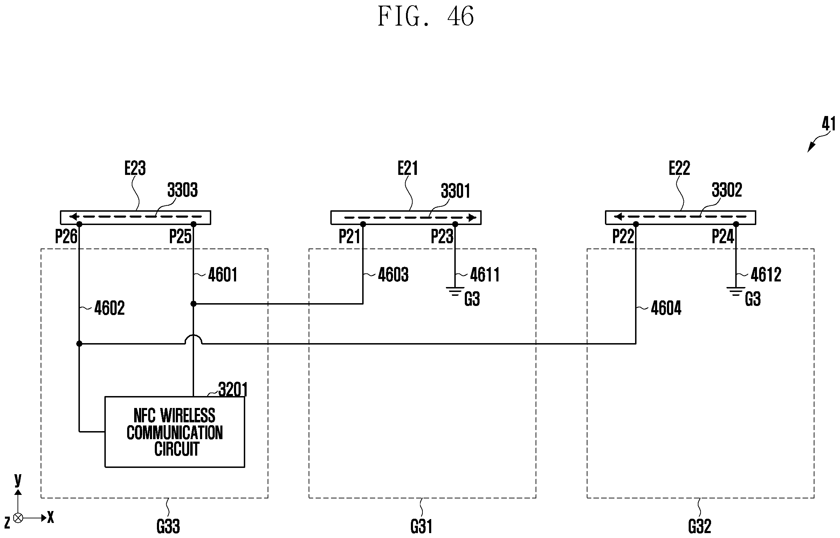

FIG. 46 is a view illustrating a multi-foldable electronic device 41 according to an embodiment of the disclosure in the unfolded state. It is to be understood that the disclosure conceives and includes all of the combinations of features and/or embodiments disclosed with reference to FIG. 46. That is, all of the combinations of features described below with reference to FIG. 46 are to be considered as being included in the disclosure as specific examples.

Referring to FIG. 46, the multi-foldable electronic device 41 may include a first metal E21, a second metal E22, a third metal E23, an antenna ground G3, and an NFC wireless communication circuit 3201.

According to an embodiment, the NFC wireless communication circuit 3201 may be accommodated in the third housing 3213 (see FIG. 41).

According to an embodiment, the NFC wireless communication circuit 3201 may be electrically connected to the fifth point P25 of the third metal E23 through a first feeding path 4601. For example, the first feeding path 4601 may include a combination of one or more conductive paths (or, conductors or conductive structures) (not separately illustrated) between the NFC wireless communication circuit 3201 and the fifth point P25 of the third metal E23.

According to an embodiment, the NFC wireless communication circuit 3201 may be electrically connected to the sixth point P26 of the third metal E23 through a second feeding path 4602. For example, the second feeding path 4602 may include a combination of one or more conductive paths (or, conductors or conductive structures) (not separately illustrated) between the NFC wireless communication circuit 4201 and the sixth point P26 of the third metal E23.

According to an embodiment, the NFC wireless communication circuit 3201 may be electrically connected to the first point P21 of the first metal E21 through a third feeding path 4603. For example, the third feeding path 4603 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a fourth feeding path 4604. For example, the fourth feeding path 4604 may include a combination of one or more conductive paths (or, conductors or conductive structures) (not separately illustrated) between the NFC wireless communication circuit 3201 and the second point P22 of the second metal E22.

According to an embodiment, the third point P23 of the first metal E21 may be electrically connected to the antenna ground G3 through the first ground path 4611. For example, the first ground path 4611 may include a combination (not separately illustrated) of one or more conductive paths (or, conductors or conductive structures) between the third point P23 of the first metal E21 and the first ground area G31 of the antenna ground G3.

According to an embodiment, the fourth point P24 of the second metal E22 may be electrically connected to the antenna ground G3 through the second ground path 4612. For example, the second ground path 4612 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the third metal E23 through the first feeding path 4601. The NFC wireless communication circuit 3201 may provide (or feed) a - voltage to the third metal E23 through the second feeding path 4602. At the time of positive feeding to the first feeding path 4601 and negative feeding to the second feeding path 4602, a current (or radiation current) may flow on the third metal E23 from the fifth point P25 to the sixth point P26.

According to an embodiment, the NFC wireless communication circuit 3201 may provide (or feed) a +voltage to the first metal E21 through the third feeding path 4603. At the time of positive feeding to the third feeding path 4603, a current (or radiation current) may flow on the first metal E21 from the first point P21 to the third point P23.

According to an embodiment, the NFC wireless communication circuit 3201 may provide (or feed) a -voltage to the second metal E22 through the fourth feeding path 4604. At the time of negative feeding to the fourth feeding path 4604, a current (or radiation current) may flow on the second metal E22 from the fourth point P24 to the second point P22.

According to an embodiment, when the multi-foldable electronic device 41 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 41 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 41 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 41 is in the folded state.

According to an embodiment, when the multi-foldable electronic device 41 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 41 is in the folded state, different from each other.

According to an embodiment, the positive feeding to the first feeding path 4601 and the negative feeding to the second feeding path 4602 for the third metal E23 may relatively improve, compared to that in the first direction (e.g., the +z-axis direction in FIG. 41) opposite the second direction in which the third display area of the first display module 3220 is oriented, NFC radiation performance in the second direction (e.g., the -z-axis direction in FIG. 41) when the multi-foldable electronic device 41 is in the folded state.

According to various embodiments, on the first metal E21, the second metal E22, and the third metal E23 which are aligned with and overlap each other when the multi-foldable electronic device 41 is in the folded state, the currents (or radiation currents) may flow in the same direction that is opposite to the direction illustrated in FIG. 41. For example, the NFC wireless communication circuit 3201 may be configured to provide (or feed) a -voltage to the first feeding path 4601 and the third feeding path 4603 and a +voltage to the second feeding path 4602 and the fourth feeding path 4604.

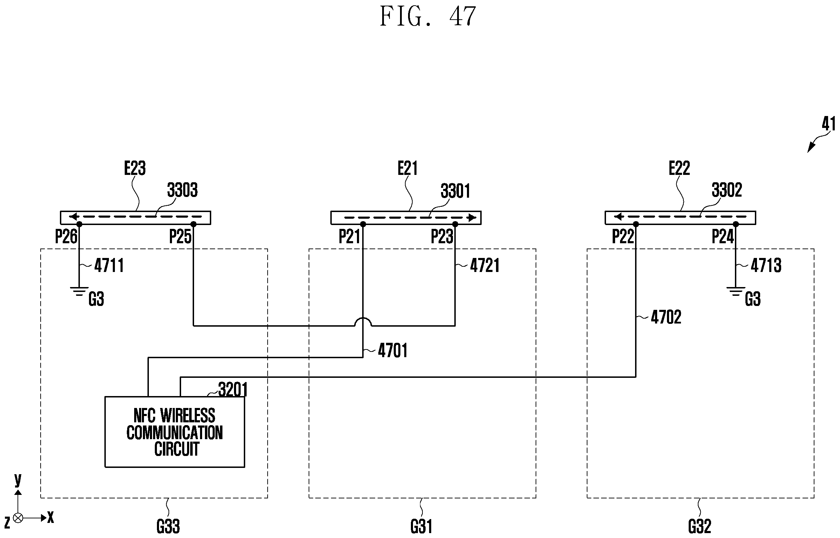

FIG. 47 is a view illustrating a multi-foldable electronic device 41 according to an embodiment of the disclosure in the unfolded state. It is to be understood that the disclosure conceives and includes all of the combinations of features and/or embodiments disclosed with reference to FIG. 47. That is, all of the combinations of features described below with reference to FIG. 47 are to be considered as being included in the disclosure as specific examples.

Referring to FIG. 47, the multi-foldable electronic device 41 may include a first metal E21, a second metal E22, a third metal E23, an antenna ground G3, and an NFC wireless communication circuit 3201.

According to an embodiment, the NFC wireless communication circuit 3201 may be accommodated in the third housing 3213 (see FIG. 41).

According to an embodiment, the NFC wireless communication circuit 3201 may be electrically connected to the first point P21 of the first metal E21 through a first feeding path 4701. For example, the first feeding path 4701 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a second feeding path 4702. For example, the second feeding path 4702 may include a combination of one or more conductive paths (or, conductors or conductive structures) (not separately illustrated) between the NFC wireless communication circuit 3201 and the second point P22 of the second metal E22.

According to an embodiment, the sixth point P26 of the third metal E23 may be electrically connected to the antenna ground G3 through the first ground path 4711. For example, the first ground path 4711 may include a combination (not separately illustrated) of one or more conductive paths (or, conductors or conductive structures) between the sixth point P26 of the third metal E23 and the third ground area G33 of the antenna ground G3.

According to an embodiment, the fourth point P24 of the second metal E22 may be electrically connected to the antenna ground G3 through the second ground path 4712. For example, the second ground path 4712 may include a combination (not separately illustrated) of one or more conductive paths (or, conductors or conductive structures) between the fourth point P24 of the second metal E22 and the second ground area G32 of the antenna ground G3.

According to an embodiment, the third point P23 of the first metal E21 and the fifth point P25 of the third metal E23 may be electrically connected to each other through a connection path 4721. For example, the connection path 4721 may include a combination (not separately illustrated) of one or more conductive paths (or, conductors or conductive structures) between the third point P23 of the first metal E21 and the fifth point P25 of the third metal E23.

According to an embodiment, the NFC wireless communication circuit 3201 may provide (or feed) a +voltage to the first metal E21 through the first feeding path 4701. At the time of positive feeding to the first feeding path 4701, the current (or radiation current) may flow on the first metal E21 from the first point P21 to the third point P23, and may flow on the third metal E23 from the fifth point P25 to the sixth point P26.

According to an embodiment, the NFC wireless communication circuit 3201 may provide (or feed) a -voltage to the second metal E22 through the second feeding path 4702. At the time of negative feeding to the second feeding path 4702, a current (or radiation current) may flow on the second metal E22 from the fourth point P24 to the second point P22.

According to an embodiment, when the multi-foldable electronic device 41 is in the folded state, at the time of feeding from the NFC wireless communication circuit 3201, a first current path (or first loop) including the first metal E21, a second current path (or second loop) including the second metal E22, and a third current path (or third loop) including the third metal E23 may be formed as a coil (or coil-shaped loop). The first current path may provide (or form) a first turn of the coil. The second current path may provide (or form) a second turn of the coil. The third current path may provide (or form) a third turn of the coil. When the multi-foldable electronic device 41 is in the folded state, the coil formed by the combination of the first turn of the first current path, the second turn of the second current path, and the third turn of the third current path may improve radiation performance by generating a electromagnetic field that is a composite of a first electromagnetic field generated through the first current path, a second electromagnetic field generated through the second current path, and a third electromagnetic field generated through the third current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301), the direction in which the current flows on the second metal E22 from the fourth point P24 to the second point P22 (3302), and the direction in which the current flows on the third metal E23 from the fifth point P25 to the sixth point P26 (3303) may be substantially the same. When the currents are caused to flow in substantially the same direction on the first metal E21, the second E22, and the third metal E23 which are aligned with and overlap each other when the multi-foldable electronic device 41 is in the folded state, it is possible to improve radiation performance by generating an electromagnetic field with a relatively high intensity of electromagnetic force, compared the case where the currents are caused to flow in opposite directions (e.g., reverse directions) on at least two of the first metal E21, the second metal E22, and the third metal E23 which are aligned with and overlap each other when the multi-foldable electronic device 41 is in the folded state.

According to an embodiment, when the multi-foldable electronic device 41 is in the folded state, at the time of feeding from the NFC wireless communication circuit 3201, the phase of the current (or radiation current) flowing on the first metal E21, the phase of the current flowing on the second metal E22, and the phase of the current flowing on the third metal E23 may be substantially the same. When the phases of the currents flowing on the first metal E21, the second metal E22, and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on two of the first metal E21, the second metal E22, and the third metal E3, which are aligned with and overlapped each other when the multi-foldable electronic device 41 is in the folded state, different from each other.

According to various embodiments, on the first metal E21, the second metal E22, and the third metal E23 which are aligned with and overlap each other when the multi-foldable electronic device 41 is in the folded state, the currents (or radiation currents) may flow in the same direction that is opposite to the direction illustrated in FIG. 41. For example, the NFC wireless communication circuit 3201 may be configured to provide (or feed) a -voltage to the first feeding path 4701 and a +voltage to the second feeding path 4702.

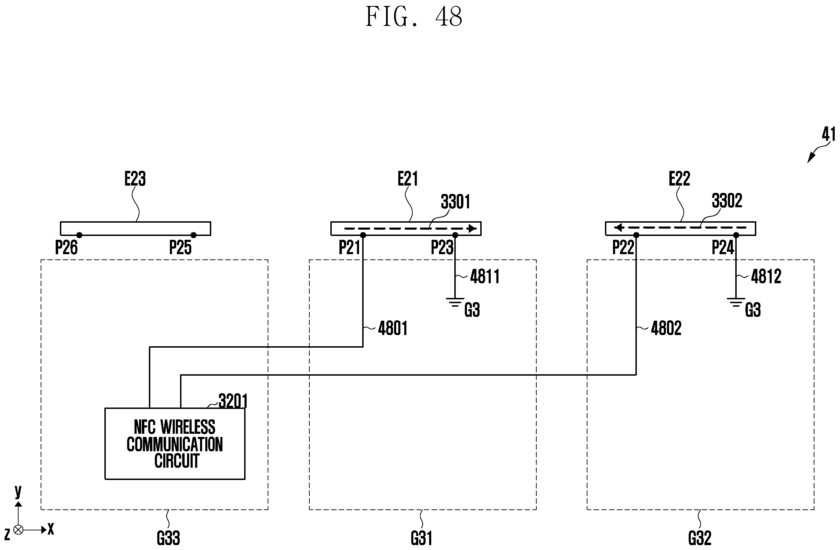

FIG. 48 is a view illustrating a multi-foldable electronic device 41 according to an embodiment of the disclosure in the unfolded state. It is to be understood that the disclosure conceives and includes all of the combinations of features and/or embodiments disclosed with reference to FIG. 48. That is, all of the combinations of features described below with reference to FIG. 48 are to be considered as being included in the disclosure as specific examples.

Referring to FIG. 48, the multi-foldable electronic device 41 may include a first metal E21, a second metal E22, a third metal E23, an antenna ground G3, and an NFC wireless communication circuit 3201.

According to an embodiment, the NFC wireless communication circuit 3201 may be accommodated in the third housing 3213 (see FIG. 41).

According to an embodiment, the NFC wireless communication circuit 3201 may be electrically connected to the first point P21 of the first metal E21 through a first feeding path 4801. For example, the first feeding path 4801 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the second point P22 of the second metal E22 through a second feeding path 4802. For example, the second feeding path 4802 may include a combination of one or more conductive paths (or, conductors or conductive structures) (not separately illustrated) between the NFC wireless communication circuit 3201 and the second point P22 of the second metal E22.

According to an embodiment, the third point P23 of the first metal E21 may be electrically connected to the antenna ground G3 through the first ground path 4811. For example, the first ground path 4811 may include a combination (not separately illustrated) of one or more conductive paths (or, conductors or conductive structures) between the third point P23 of the first metal E21 and the first ground area G31 of the antenna ground G3.

According to an embodiment, the fourth point P24 of the second metal E22 may be electrically connected to the antenna ground G3 through the second ground path 4812. For example, the second ground path 4812 may include a combination (not separately illustrated) of one or more conductive paths (or, conductors or conductive structures) between the fourth point P24 of the second metal E22 and the second ground area G32 of the antenna ground G3.

According to an embodiment, the NFC wireless communication circuit 3201 may provide (or feed) a +voltage to the first metal E21 through the first feeding path 48011. At the time of positive feeding to the first feeding path 4401, a current (or radiation current) may flow on the first metal E21 from the first point P21 to the third point P23.

According to an embodiment, the NFC wireless communication circuit 3201 may provide (or feed) a -voltage to the second metal E22 through the second feeding path 4802. At the time of negative feeding to the second feeding path 4802, a current (or radiation current) may flow on the second metal E22 from the fourth point P24 to the second point P22.

According to an embodiment, when the multi-foldable electronic device 41 is in the folded state, at the time of feeding from the NFC wireless communication circuit 3201, a first current path (or first loop) including the first metal E21 and a second current path (or second loop) including the second metal E22 may be formed as a coil (or coil-shaped loop). The first current path may provide (or form) a first turn of the coil. The second current path may provide (or form) a second turn of the coil. When the multi-foldable electronic device 41 is in the folded state, the coil formed by the combination of the first turn of the first current path and the second turn of the second current path may improve radiation performance by generating an electromagnetic field that is a composite of the first electromagnetic field generated through the first current path and the second electromagnetic field generated through the second current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301) and the direction in which the current flows on the fourth metal E24 from the second point P22 to the second point P22 (3302) may be substantially the same. When the currents are caused to flow in substantially the same direction on the first metal E21 and the second metal E22 which are aligned with and overlap each other when the multi-foldable electronic device 41 is in the folded state, it is possible to improve radiation performance by generating an electromagnetic field with a relatively high intensity of electromagnetic force, compared to the case where the currents are caused to flow in opposite directions (e.g., reverse directions) on the first metal E21 and the second metal E22 which are aligned with and overlap each other when the multi-foldable electronic device 41 is in the folded state.

According to an embodiment, when the multi-foldable electronic device 41 is in the folded state, at the time of feeding from the NFC wireless communication circuit 3201, the phase of the current (or radiation current) flowing on the first metal E21 and the phase of the current flowing on the second metal E22 may be substantially the same. When the phases of the currents flowing on the first metal E21 and the second metal E22, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on the first metal E21 and the second metal E22, which are aligned with and overlapped each other when the multi-foldable electronic device 41 is in the folded state, different from each other.

According to various embodiments, on the first metal E21 and the second metal E22 which are aligned with and overlap each other when the multi-foldable electronic device 41 is in the folded state, the currents (or radiation currents) may flow in the same direction that is opposite to the direction illustrated in FIG. 41. For example, the NFC wireless communication circuit 3201 may be configured to provide (or feed) a -voltage to the first feeding path 4801 and a +voltage to the second feeding path 4802.

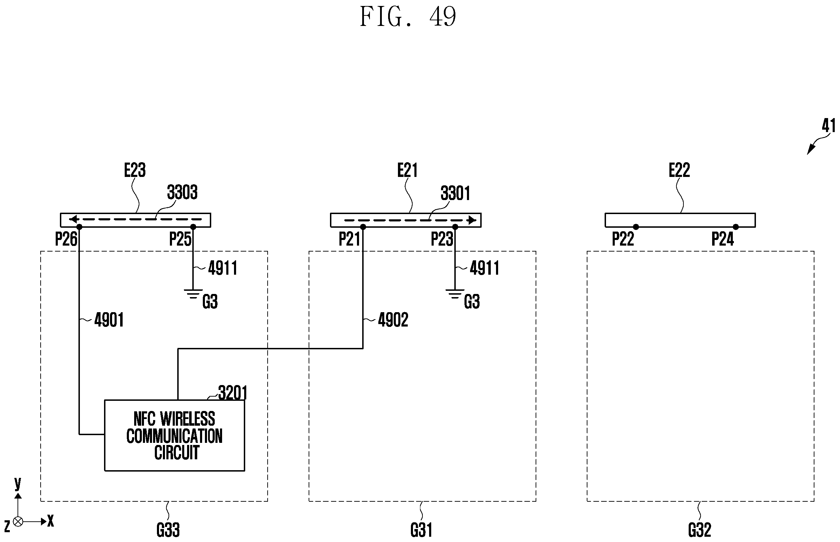

FIG. 49 is a view illustrating a multi-foldable electronic device 41 according to an embodiment of the disclosure in the unfolded state. It is to be understood that the disclosure conceives and includes all of the combinations of features and/or embodiments disclosed with reference to FIG. 49. That is, all of the combinations of features described below with reference to FIG. 49 are to be considered as being included in the disclosure as specific examples.

Referring to FIG. 49, the multi-foldable electronic device 41 may include a first metal E21, a second metal E22, a third metal E23, an antenna ground G3, and an NFC wireless communication circuit 3201.

According to an embodiment, the NFC wireless communication circuit 3201 may be accommodated in the third housing 3213 (see FIG. 41).

According to an embodiment, the NFC wireless communication circuit 3201 may be electrically connected to the first point P21 of the first metal E21 through a first feeding path 4901. For example, the first feeding path 4901 may include a combination of one or more conductive paths (or, conductors or conductive structures) (not separately illustrated) between the NFC wireless communication circuit 3201 and the first point P21 of the first metal E21.

According to an embodiment, the NFC wireless communication circuit 3201 may be electrically connected to the sixth point P26 of the third metal E23 through a second feeding path 4902. For example, the second feeding path 4902 may include a combination of one or more conductive paths (or, conductors or conductive structures) (not separately illustrated) between the NFC wireless communication circuit 3201 and the sixth point P26 of the third metal E23.

According to an embodiment, the third point P23 of the first metal E21 may be electrically connected to the antenna ground G3 through the first ground path 4911. For example, the first ground path 4911 may include a combination (not separately illustrated) of one or more conductive paths (or, conductors or conductive structures) between the third point P23 of the first metal E21 and the first ground area G31 of the antenna ground G3.

According to an embodiment, the fifth point P25 of the third metal E23 may be electrically connected to the antenna ground G3 through the second ground path 4912. For example, the second ground path 4912 may include a combination (not separately illustrated) of one or more conductive paths (or, conductors or conductive structures) between the fifth point P25 of the third metal E23 and the third ground area G33 of the antenna ground G3.

According to an embodiment, the NFC wireless communication circuit 2801 may provide (or feed) a +voltage to the first metal E21 through the first feeding path 4901. At the time of positive feeding to the first feeding path 4901, a current (or radiation current) may flow on the first metal E21 from the first point P21 to the third point P23.

According to an embodiment, the NFC wireless communication circuit 3201 may provide (or feed) a -voltage to the third metal E23 through the second feeding path 4902. At the time of negative feeding to the second feeding path 4902, a current (or radiation current) may flow on the third metal E23 from the fifth point P25 to the sixth point P26.

According to an embodiment, when the multi-foldable electronic device 41 is in the folded state, at the time of feeding from the NFC wireless communication circuit 3201, a first current path (or first loop) including the first metal E21 and a third current path (or second loop) including the third metal E23 may be formed as a coil (or coil-shaped loop). The first current path may provide (or form) a first turn of the coil. The third current path may provide (or form) a third turn of the coil. When the multi-foldable electronic device 47 is in the folded state, the coil formed by the combination of the first turn of the first current path and the third turn of the third current path may improve radiation performance by generating an electromagnetic field that is a composite of the electromagnetic field generated through the first current path and the third electromagnetic field generated through the third current path.

According to an embodiment, when the multi-foldable electronic device 41 is in the folded state, at the time of feeding from the NFC wireless communication circuit 3201, the direction in which the current (or radiation current) flows on the first metal E21 from the first point P21 to the third point P23 (3301) and the direction in which the current flows on the third metal E23 from the fifth point P25 to the sixth point P26 (3303) may be substantially the same. When the currents are caused to flow in substantially the same direction on the first metal E21 and the third metal E23 which are aligned with and overlap each other when the multi-foldable electronic device 41 is in the folded state, it is possible to improve radiation performance by generating an electromagnetic field with a relatively high intensity of electromagnetic force, compared to the case where the currents are caused to flow in opposite directions (e.g., reverse directions) on the first metal E21 and the third metal E23 which are aligned with and overlap each other when the multi-foldable electronic device 41 is in the folded state.

According to an embodiment, when the multi-foldable electronic device 41 is in the folded state, at the time of feeding power from the NFC wireless communication circuit 3201, the phase of the current (or radiation current) flowing on the first metal E21 and the phase of the current flowing on the third metal E23 may be substantially the same. When the phases of the currents flowing on the first metal E21 and the third metal E23, which are aligned with and overlapped each other when the multi-foldable electronic device 41 is in the folded state, are made to be the same, radiation performance can be improved by generating an electromagnetic field with relatively high electromagnetic force, compared to making the phases of currents flowing on the first metal E21 and the third metal E23, which are aligned with and overlapped each other when the multi-foldable electronic device 41 is in the folded state, different from each other.

According to various embodiments, on the first metal E21 and the third metal E23 which are aligned with and overlap each other when the multi-foldable electronic device 41 is in the folded state, the currents (or radiation currents) may flow in the same direction that is opposite to the direction illustrated in FIG. 41. For example, the NFC wireless communication circuit 3201 may be configured to provide (or feed) a -voltage to the first feeding path 4901 and a +voltage to the second feeding path 4902.

According to an exemplary embodiment of the disclosure, a foldable electronic device 2 includes a foldable housing 20, a first metal E1, a second metal (e.g., the seventh metal E7), a first ground area G1, a second ground area G2, a wireless communication circuit 610, a first electrical path EP1, a second electrical path EP2, a third electrical path EP3, a fourth electrical path EP4, and a fifth electrical path EP5. The foldable housing 20 includes a first housing 21, a second housing 22, and a hinge portion 24 interconnecting the first housing 21 and the second housing 22. The first metal E1 is included in a first side 2112 that provides at least a portion of the side surface of the first housing 21. The second metal (e.g., the seventh metal E7) is included in a second side 2212, which provides at least a portion of the side surface of the second housing 22. In the folded state of the foldable electronic device 2, the first metal E1 and the second metal (e.g., the seventh metal E7) are aligned with and overlap each other. The first ground area G1 is located in the first housing 21. The first ground area G1 is physically spaced apart from the first metal E1. The second ground area G2 is located in the second housing 22. The second ground area G2 is physically spaced apart from the second metal (e.g., the seventh metal E7). The wireless communication circuit 610 is accommodated in the first housing 21. The first electrical path EP1 electrically interconnects the first metal E1 and the wireless communication circuit 610. The second electrical path EP2 electrically interconnects the second metal (e.g., the seventh metal E7) and the wireless communication circuit 610. The second electrical path EP2 is disposed across the hinge portion 24. The third electrical path EP3 electrically interconnects the first metal E1 and the first ground area G1. The fourth electrical path EP4 electrically interconnects the second metal (e.g., the seventh metal E7) and the second ground area G2. The fifth electrical path EP5 electrically interconnects the first ground area G1 and the second ground area G2. The fifth electrical path EP5 is disposed across the hinge portion 24. Therefore, the radiation region of the electromagnetic field is designed to reduce the limitation of user's hand grip position and avoid being masked by the user's hand (e.g., dielectric) so as not to degrade the radiation performance.

According to an exemplary embodiment of the disclosure, the wireless communication circuit 610 may be configured to process an NFC signal.

According to an exemplary embodiment of the disclosure, the foldable electronic device 2 may include a first non-ground area NG1 between the first metal E1 and the first ground area G1. The foldable electronic device 2 may include a second non-ground area NG2 between a second metal (e.g., the seventh metal E7) and the second ground area G2. When the foldable electronic device 2 is in the folded state, the first non-ground area NG1 and the second non-ground area NG2 may overlap each other.

According to an exemplary embodiment of the disclosure, the wireless communication circuit 610 may provide a +voltage to the first electrical path EP1 and a -voltage to the second electrical path EP2.

According to an exemplary embodiment of the disclosure, the first electrical path EP1 may be electrically connected to the first point P1 of the first metal E1. The third electrical path EP3 may be electrically connected to the third point P3 of the first metal E1. The second electrical path EP2 may be electrically connected to the second point P2 of the second metal (e.g., the seventh metal E7). The fourth electrical path EP4 may be electrically connected to the fourth point P4 of the second metal (e.g., the seventh metal E7). The third point P3 may be located between the first point P1 and the hinge portion 24. The second point P2 may be located between the fourth point P4 and the hinge portion 24.

According to an exemplary embodiment of the disclosure, the foldable electronic device 2 may include a sixth electrical path EP6 and a seventh electrical path EP7. The sixth electrical path EP6 may electrically interconnect the first electrical path EP1 and the fourth electrical path EP4 and may be disposed across the hinge portion 24. The seventh electrical path EP7 may electrically interconnect the second electrical path EP2 and the third electrical path EP3.

According to an exemplary embodiment of the disclosure, the foldable electronic device 2 may include a flexible printed circuit board extending from the first housing 21 to the second housing 22 across the hinge portion 24. The flexible printed circuit board may include a first conductive line included in the second electrical path EP2 and a second conductive line included in the sixth electrical path EP6.

According to an exemplary embodiment of the disclosure, the foldable electronic device 2 may include a spiral conductive pattern 1100, a ninth electrical path EP9, and a tenth electrical path EP10. The spiral conductive pattern 1100 may be accommodated in the first housing 21. The ninth electrical path EP9 may electrically interconnect a first end 1101 of the spiral conductive pattern 1100 and the first electrical path EP1. The tenth electrical path EP10 may electrically interconnect a second end 1102 of the spiral conductive pattern 1100 and the second electrical path EP2.

According to an exemplary embodiment of the disclosure, a first rear surface area of the first housing 21 may include a first area 201, a second area 202, and a third area 203. The second area 202 may be located between the first area 201 and the third area 203. The second rear surface area of the second housing 22 may include a fourth area 204, a fifth area 205, and a sixth area 206. The fifth area 205 may be located between the fourth area 204 and the sixth area 206. When the foldable electronic device 2 is in the folded state, the first area 201 and the fourth area 204, the second area 202 and the fifth area 205, and the third area 203 and the six areas 206 may overlap each other. The first metal E1 may be located corresponding to the first area 201. The second metal (e.g., the seventh metal E7) may be located corresponding to the fourth area 204. The spiral conductive pattern 1100 may be located corresponding to the second area 202.

According to an exemplary embodiment of the disclosure, the foldable electronic device 2 may include a matching circuit 630 electrically connected to the first electrical path EP1 and the second electrical path EP2.

According to an exemplary embodiment of the disclosure, the foldable electronic device 2 may include a first filter 640 disposed in the first electrical path EP1.

According to an exemplary embodiment of the disclosure, the foldable electronic device 2 may include a second filter 650 disposed in the second electrical path EP2.

According to an exemplary embodiment of the disclosure, the foldable electronic device 2 includes a foldable housing 20, a first metal E1, a second metal (e.g., the seventh metal E7), and a first ground area G1, a second ground area G2, a first non-ground area NG1, a second non-ground area NG2, a wireless communication circuit 610, a first electrical path EP1, a second electrical path EP2, a third electrical path EP3, a fourth electrical path EP4, and/or a fifth electrical path EP5. The foldable housing 20 includes a first housing 21, a second housing 22, and a hinge portion 24 interconnecting the first housing 21 and the second housing 22. The first metal E1 is included in a first side 2112 that provides at least a portion of the side surface of the first housing 21. The second metal (e.g., the seventh metal E7) is included in a second side 2212 that provides at least a portion of the side surface of the second housing 22. When the foldable electronic device 2 is in the folded state, the first metal E1 and the second metal (e.g., the seventh metal E7) are aligned with and overlap each other. The first ground area G1 is located in the first housing 21. The first ground area G1 is physically spaced apart from the first metal E1. The second ground area G2 is located in the second housing 22. The second ground area G2 is physically spaced apart from the second metal (e.g., the seventh metal E7). The first non-ground area NG1 is located between the first metal E1 and the first ground area G1. The second non-ground area NG2 is located between the second metal (e.g., the seventh metal E7) and the second ground area G2. When the foldable electronic device 2 is in the folded state, the first non-ground area NG1 and the second non-ground area NG2 overlap each other. The wireless communication circuit 610 is accommodated in the first housing 21 and configured to process an NFC signal. The first electrical path EP1 electrically interconnects the first metal E1 and the wireless communication circuit 610. The second electrical path EP2 electrically interconnects the second metal (e.g., the seventh metal E7) and the wireless communication circuit 610. The second electrical path EP2 is disposed across the hinge portion 24. The third electrical path EP3 electrically interconnects the first metal E1 and the first ground area G1. The fourth electrical path EP4 electrically interconnects the second metal (e.g., the seventh metal E7) and the second ground area G2. The fifth electrical path EP5 electrically interconnects the first ground area G1 and the second ground area G2. The fifth electrical path EP5 is disposed across the hinge portion 24. The wireless communication circuit 610 provides a +voltage to the first electrical path EP1 and a -voltage to the second electrical path EP2. Therefore, the limitation of user's hand grip position can be reduced, and meanwhile, in-phase currents are formed on the first electrical path EP1 and the second electrical path EP2 to enhance the intensity of the electromagnetic field.

According to an exemplary embodiment of the disclosure, the first electrical path EP1 may be electrically connected to the first point P1 of the first metal E1. The third electrical path EP3 may be electrically connected to the third point P3 of the first metal E1. The second electrical path EP2 may be electrically connected to the second point P2 of the second metal (e.g., the seventh metal E7). The fourth electrical path EP4 may be electrically connected to the fourth point P4 of the second metal (e.g., the seventh metal E7). The third point P3 may be located between the first point P1 and the hinge portion 24. The second point P2 may be located between the fourth point P4 and the hinge portion 24.

According to an exemplary embodiment of the disclosure, the foldable electronic device 2 may include a spiral conductive pattern 1100, a ninth electrical path EP9, and a tenth electrical path EP10. The spiral conductive pattern 1100 may be accommodated in the first housing 21. The ninth electrical path EP9 may electrically interconnect a first end 1101 of the spiral conductive pattern 1100 and the first electrical path EP1. The tenth electrical path EP10 may electrically interconnect a second end 1102 of the spiral conductive pattern 1100 and the second electrical path EP2.

According to an exemplary embodiment of the disclosure, the foldable electronic device 2 includes a first metal E1, a second metal (e.g., the seventh metal (E7)), a hinge portion 24, and a wireless communication circuit 610. The first metal E1 is included in the first side surface member (e.g., the first side 2112) of the first housing 21. The second metal is included in the second side surface member (e.g., the second side 2212) of the second housing 22. The hinge portion 24 rotatably interconnects the first housing 21 and the second housing 22. The wireless communication circuit 610 is configured to transmit and/or receive a signal in the NFC band via the first metal E1 and the second metal E2. When the foldable electronic device 2 is in the folded state, the first metal E1 and the second metal are aligned with each other. When the foldable device 2 is in the folded state, at the time of feeding from the wireless communication circuit 61, the direction in which current flows on the first metal E1 and the direction in which current flows on the second metal are the same. Therefore, in-phase currents flow through the first metal E1 and the second metal (e.g., the seventh metal (E7)) and thus enhance the intensity of the electromagnetic field and the radiation performance.

According to an exemplary embodiment of the disclosure, the foldable electronic device 2 may include a first ground area G1, a second ground area G2, a first non-ground area NG1, and a second non-ground area NG2. The first ground area G1 may be located in the first housing 21 and physically spaced apart from the first metal E1. The second ground area G2 may be located in the second housing 22 and physically spaced apart from the second metal (e.g., the second metal E7). The first non-ground area NG1 may be disposed between the first metal E1 and the first ground area G1. The second non-ground area NG2 may be disposed between the second metal and the second ground area G2. When the foldable electronic device 2 is in the folded state, the first non-ground area NG1 and the second non-ground area NG2 may be aligned with each other.

According to an exemplary embodiment of the disclosure, the foldable electronic device 2 may include a first ground area G1, a second ground area G2, a first non-ground area NG1, and a second non-ground area NG2. The first ground area G1 may be located in the first housing 21 and physically spaced apart from the first metal E1. The second ground area G2 may be located in the second housing 22 and physically spaced apart from the second metal (e.g., the seventh metal E7). The first non-ground area NG1 may be disposed between the first metal E1 and the first ground area G1. The second non-ground area NG2 may be disposed between the second metal and the second ground area G2. When the foldable electronic device 2 is in the folded state, the first non-ground area NG1 and the second non-ground area NG2 may be aligned with each other.

According to an exemplary embodiment of the disclosure, the foldable electronic device 2 may include a first ground area G1, a second ground area G2, a wireless communication circuit 610, and a first electrical path EP1, a second electrical path EP2, a third electrical path EP3, and a fourth electrical path EP4. The first ground area G1 may be located in the first housing 21 and physically spaced apart from the first metal E1. The second ground area G2 may be located in the second housing 22 and physically spaced apart from the second metal (e.g., the seventh metal E7). The wireless communication circuit 610 may be accommodated in the first housing 21. The first electrical path EP 1 may electrically interconnect the first metal E1 and the wireless communication circuit 610. The second electrical path EP2 may electrically connect the second metal and wireless communication circuit 610 and be disposed across the hinge portion 24. The third electrical path EP3 may electrically interconnect the first metal E1 and the first ground area G1. The fourth electrical path EP4 may electrically interconnect the second metal and the second ground area G2. The wireless communication circuit 610 may provide a +voltage to the first electrical path EP1 and a -voltage to the second electrical path EP2.

According to an exemplary embodiment of the disclosure, the foldable electronic device 2 may include a balun 1901, a first electrical path EP1, a second electrical path (e.g., the fifteenth electrical path EP15), a third electrical path (e.g., the sixteenth electrical path EP16), a fourth electrical path (e.g., the seventeenth 17th electrical path EP17), and/or an eighth electrical path (e.g., the eighteenth electrical path EP18). The first electrical path EP1 may electrically interconnect the first metal E1 and the wireless communication circuit 610. The second electrical path may electrically interconnect the wireless communication circuit 610 and the balun 1901. The third electrical path may electrically interconnect the wireless communication circuit 610 and the balun 1901. The fourth electrical path may electrically interconnect the first metal E1 and the second metal (e.g., the seventh metal E7) and be disposed across the hinge portion 24. The fifth electrical path may electrically interconnect the second metal and the ground area (e.g., the second ground area G2) located in the second housing 22. The wireless communication circuit 610 may provide a +voltage to the second electrical path and a -voltage to the third electrical path EP16.

According to an exemplary embodiment of the disclosure, the foldable electronic device 2 may further include a phase shifter 2001 disposed in a fourth electrical path (e.g., the seventeenth electrical path EP17).

Embodiments disclosed in the disclosure and drawings are merely presented as specific examples to easily describe technical content and aid understanding of the disclosure, and are not intended to limit the scope of the disclosure. Accordingly, the scope of the various embodiments of the disclosure should be construed as including changes or modifications of the embodiments in addition to the embodiments disclosed herein. In addition, it will be appreciated that any embodiment(s) described herein may be used with any other embodiment(s) described herein. In particular, it is emphasized that although the disclosure is presented in a form that provides a number of embodiments, some of the embodiments are linked only by reference to the same drawing or drawings. The disclosure is to be understood to include all of the combinations of two (or more) embodiments unless there is an obvious contradiction therebetween. That is, when features are presented as optional in the disclosure, all of the combinations of those optional features are included in the disclosure.

## Claims

1. A foldable electronic device (2) comprising:
a foldable housing (20) comprising a first housing (21), a second housing (22), and a hinge portion (24) interconnecting the first housing and the second housing (22);
a first metal (E1) comprised in a first side (2112) that provides at least a portion of a side surface of the first housing (21);
a second metal (E7) comprised in a second side (2212) that provides at least a portion of a side surface of the second housing (22), wherein the first metal (E1) and the second metal (E7) are aligned with each other in a folded state of the foldable electronic device (2);
a first ground area (G1) located in the first housing (21) and physically spaced apart from the first metal (E1);
a second ground area (G2) located in the second housing (22) and physically spaced apart from the second metal (E7);
a wireless communication circuit (610) accommodated in the first housing (21);
a first electrical path (EP1) electrically interconnecting the first metal (E1) and the wireless communication circuit (610);
a second electrical path (EP2) electrically interconnecting the second metal (E7) and the wireless communication circuit (610) and disposed across the hinge portion (24);
a third electrical path (EP3) electrically interconnecting the first metal (E1) and the first ground area (G1);
a fourth electrical path (EP4) electrically interconnecting the second metal (E7) and the second ground area (G2); and
a fifth electrical path (EP5) electrically interconnecting the first ground area (G1) and the second ground area (G2) and disposed across the hinge portion (24).

2. The foldable electronic device of claim 1, wherein the wireless communication circuit (610) is configured to process a near field communication, NFC, signal.

3. The foldable electronic device of claim 1 or 2, wherein the foldable electronic device 2 comprises a first non-ground area (NG1) between the first metal (E1) and the first ground area (G1), and a second non-ground area (NG2) between the second metal (E7) and the second ground area (G2), and
wherein the first non-ground area (NG1) and the second non-ground area (NG2) are aligned with each other in case that the foldable electronic device (2) is in a folded state.

4. The foldable electronic device of one of claims 1 to 3, wherein the wireless communication circuit (610) is configured to provide a positive voltage to the first electrical path (EP1) and a negative voltage to the second electrical path (EP2).

5. The foldable electronic device of one of claims 1 to 4, wherein the first electrical path (EP1) is electrically connected to a first point (P1) of the first metal (E1),
wherein the third electrical path (EP3) is electrically connected to a third point (P3) of the first metal (E1),
wherein the second electrical path (EP2) is electrically connected to a second point (P2) of the second metal (E7),
wherein the fourth electrical path (EP4) is electrically connected to a fourth point (P4) of the second metal (E7),
wherein the third point (P3) is located between the first point (P1) and the hinge portion (24), and
wherein the second point (P2) is located between the fourth point (P4) and the hinge portion (24).

6. The foldable electronic device of one of claims 1 to 5, further comprising:
a sixth electrical path (EP6) electrically interconnecting the first electrical path (EP1) and the fourth electrical path (EP4) and disposed across the hinge portion (24); and
a seventh electrical path (EP7) electrically interconnecting the second electrical path (EP2) and the third electrical path (EP3).

7. The foldable electronic device of claim 6, further comprising a flexible printed circuit board extending from the first housing (21) to the second housing (22) across the hinge portion (24),
wherein the flexible printed circuit board comprises a first conductive line comprised in the second electrical path (EP2) and a second conductive line comprised in the sixth electrical path (EP6).

8. The foldable electronic device of one of claims 1 to 7, further comprising:
a spiral conductive pattern (1100) accommodated in the first housing (21);
a ninth electrical path (EP9) electrically interconnecting a first end (1101) of the spiral conductive pattern (1100) and the first electrical path (EP1); and
a tenth electrical path (EP10) electrically interconnecting a second end (1102) of the spiral conductive pattern (1100) and the second electrical path (EP2).

9. The foldable electronic device of claim 8, wherein the first housing (21) comprises, in a first rear surface area thereof, a first area (201), a second area (202), and a third area (203), and the second area (202) is located between the first area (201) and the third area (203),
wherein the second housing (22) comprises, in a second rear surface area thereof, a fourth area (204), a fifth area 205, and a sixth area (206), and the fifth area (205) is located between the fourth area (204) and the sixth area (206),
wherein in case that the foldable electronic device (2) is in the folded state, the first area (201) and the fourth area (204), the second area (202) and the fifth area (205), and the third area (203) and the sixth area (206) aligned with each other,
wherein the first metal (E1) is located corresponding to the first area (201),
wherein the second metal (E7) is located corresponding to the fourth area (204), and
wherein the spiral conductive pattern (1100) is located corresponding to the second area (202).

10. The foldable electronic device of one of claims 1 to 9, further comprising a matching circuit (630) electrically connected to the first electrical path (EP1) and the second electrical path (EP2).

11. The foldable electronic device of one of claims 1 to 10, further comprising a first filter (640) disposed in the first electrical path (EP1).

12. The foldable electronic device of one of claims 1 to 11, further comprising a second filter (650) disposed in the second electrical path (EP2).

13. A foldable electronic device (2) comprising:
a first metal (E1) included in a first side surface member (2112) of a first housing (21);
a second metal (E7) included in a second side surface member (2212) of a second housing (22);
a hinge portion (24) rotatably interconnecting the first housing (21) and the second housing (22); and
a wireless communication circuit (610) configured to transmit and/or receive a signal in a near field communication, NFC, band via the first metal (E1) and the second metal (E7),
wherein, when the foldable electronic device (2) is in a folded state, the first metal (E1) and the second metal (E7) are aligned with each other, and
wherein, when the foldable device (2) is in the folded state, at a time of feeding from the wireless communication circuit (610), a direction in which current flows on the first metal (E1) and a direction in which current flows on the second metal (E7) are same.

14. The foldable electronic device of claim 13, further comprising:
a balun (1901) between the first metal (E1) and the wireless communication circuit (610);
a first electrical path (EP1) electrically interconnecting the first metal (E1) and the wireless communication circuit (610);
a second electrical path (EP15) electrically interconnecting the wireless communication circuit (610) and the balun (1901);
a third electrical path (EP16) electrically interconnecting the wireless communication circuit (610) and the balun (1901);
a fourth electrical path (EP17) electrically interconnecting the first metal (E1) and the second metal (E7) and disposed across the hinge portion (24); and
a fifth electrical path (EP18) electrically interconnecting the second metal (E7) and a ground area (G2) located in the second housing 22,
wherein the wireless communication circuit (610) is configured to provide a positive voltage to the second electrical path (EP15) and a negative voltage to the third electrical path (EP16).

15. The foldable electronic device of claim 14, further comprising:
a phase shifter (2001) disposed in the fourth electrical path (EP17).
